(19) Europäisches Patentamt
European Patent Office
Office européen des brevets

(11) EP 4 074 739 A1

(12) # EUROPEAN PATENT APPLICATION
published in accordance with Art. 153(4) EPC

(43) Date of publication:
**19.10.2022 Bulletin 2022/42**

(21) Application number: **20900094.2**

(22) Date of filing: **19.11.2020**

(51) International Patent Classification (IPC):
***C08F 220/28*** *(2006.01)* ***G03F 7/038*** *(2006.01)*
***G03F 7/039*** *(2006.01)* ***G03F 7/20*** *(2006.01)*
***G03F 7/32*** *(2006.01)* ***H01L 21/027*** *(2006.01)*

(52) Cooperative Patent Classification (CPC):
**C08F 220/28; G03F 7/038; G03F 7/039; G03F 7/20; G03F 7/32; H01L 21/027**

(86) International application number:
**PCT/JP2020/043187**

(87) International publication number:
**WO 2021/117456 (17.06.2021 Gazette 2021/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.12.2019 JP 2019222306**

(71) Applicant: **FUJIFILM Corporation**
**Tokyo 106-8620 (JP)**

(72) Inventors:
- **TSUCHIHASHI, Toru**
**Haibara-gun, Shizuoka 421-0396 (JP)**
- **TAKAHASHI, Satomi**
**Haibara-gun, Shizuoka 421-0396 (JP)**
- **SHIMIZU, Tetsuya**
**Haibara-gun, Shizuoka 421-0396 (JP)**

(74) Representative: **HGF**
**HGF Limited**
**1 City Walk**
**Leeds LS11 9DX (GB)**

(54) **TREATMENT LIQUID AND PATTERN FORMING METHOD**

(57) The present invention provides a treatment liquid excellent in resolution, a property of suppressing reduction in film thickness, and a property of suppressing residues, in a case of being used for at least one of developing or washing a resist film. Further, the present invention provides a pattern forming method for the above-described treatment liquid. The treatment liquid of the present invention is a treatment liquid for patterning a resist film, which is used for performing at least one of development or washing after exposure on a resist film obtained from an actinic ray-sensitive or radiation-sensitive composition, the treatment liquid including a first organic solvent that satisfies a predetermined condition and a second organic solvent that satisfies a predetermined condition.

FIG. 1

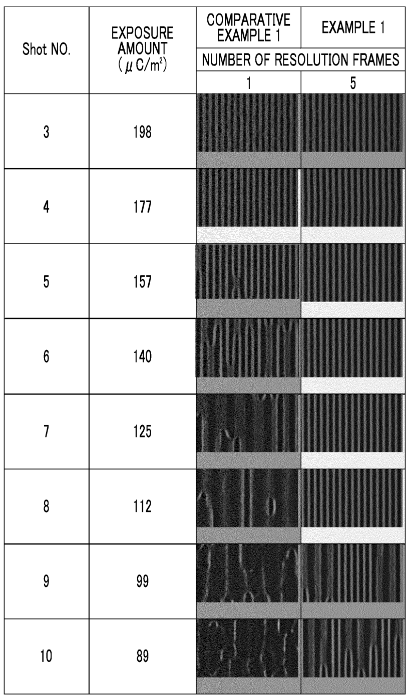


EP 4 074 739 A1

## Description

## BACKGROUND OF THE INVENTION

1. Field of the Invention

The present invention relates to a treatment liquid for patterning a resist film and a pattern forming method.

More specifically, the present invention relates to a treatment liquid and a pattern forming method which are used for a step of manufacturing a semiconductor such as an integrated circuit (IC), a step of manufacturing a circuit board for a liquid crystal or a thermal head, and a lithography step for photofabrication.

2. Description of the Related Art

In processes for manufacturing semiconductor devices such as integrated circuits (IC) and large scale integrated circuits (LSI) in the related art, microfabrication by lithography using a photoresist composition has been performed. In recent years, with the high integration of integrated circuits, the formation of ultrafine patterns in a submicron region or quarter micron region has been required. With such a demand, a tendency that an exposure wavelength has been shifted from g-rays to i-rays, and further, as with KrF excimer laser light, the exposure wavelength is shortened is observed. Moreover, development of lithography with electron beams, X-rays, or extreme ultraviolet rays (EUV), in addition to the excimer laser light, has also been currently in progress.

In such lithography, a film (resist film) is formed by an actinic ray-sensitive or radiation-sensitive composition (also referred to as a resist composition), and the obtained film is subjected to a treatment of being developed with a developer and the developed film is subjected to a treatment of being washed with a rinsing liquid.

For example, JP2013-045086A discloses that 1-hexanol is used as a rinsing liquid after development with butyl acetate.

## SUMMARY OF THE INVENTION

In recent years, with high integration of integrated circuits, formation of fine patterns (high-resolution patterns) using resist compositions has been required. In the formation of such fine patterns, there is a problem in that a large capillary force is generated due to a decrease in the distance between patterns as a result of the miniaturization, and thus high-quality patterns are unlikely to be formed.

Further, since the film thickness of a pattern tends to be decreased with the miniaturization, resolution of performance degradation of the pattern due to "reduction in film thickness of the pattern" during the development treatment and the rinsing treatment is significantly required more than before. That is, there is a demand for a treatment liquid (developer and/or rinsing liquid) that can simultaneously resolve the occurrence of pattern collapse and reduction in film thickness of a pattern.

It is also required to suppress residues on the obtained pattern in a case where the treatment liquid is applied.

The present invention has been made in view of the above-described circumstances, and an object thereof is to provide a treatment liquid excellent in resolution, a property of suppressing reduction in film thickness, and a property of suppressing residues, in a case of being used for at least one of developing or washing (rinsing) a resist film. Further, another object of the present invention is to provide a pattern forming method for the above-described treatment liquid.

As a result of intensive examination conducted by the present inventors in order to solve the above-described problems, it was found that the above-described objects can be achieved by the following configuration, thereby completing the present invention.

[1] A treatment liquid for patterning a resist film, which is used for performing at least one of development or washing after exposure on a resist film obtained from an actinic ray-sensitive or radiation-sensitive composition, the treatment liquid comprising: a first organic solvent that satisfies Condition A; and a second organic solvent that satisfies Condition B,

Condition A: the solvent has a SP value of 15.0 $MPa^{1/2}$ or greater and less than 16.5 $MPa^{1/2}$ which is acquired by Equation (1) and is a hydrocarbon-based solvent, an ester-based solvent, an ether-based solvent, or a carbonic acid ester-based solvent,

$$\text{Equation (1): SP value} = ((\delta d)^2 + (\delta p)^2 + (\delta h)^2)^{0.5}$$

SP value: Hansen solubility parameter of organic solvent
8d: dispersion element of organic solvent
δp: polarity element of organic solvent
δh: hydrogen bond element of organic solvent

Condition B: the solvent has a SP value of 16.5 $MPa^{1/2}$ or greater and less than 17.6 $MPa^{1/2}$ which is acquired by Equation (1) and has an X value of 7.0 or greater and less than 20.0 which is acquired by Equation (2), and is a hydrocarbon-based solvent, an ester-based solvent, an ether-based solvent, or a carbonic acid ester-based solvent,

$$\text{Equation (2): } X = (\delta p)^2/((\delta d)^2 + (\delta p)^2 + (\delta h)^2) \times 100.$$

[2] The treatment liquid according to [1], in which the first organic solvent is an ether-based solvent having 6 to 12 carbon atoms.
[3] The treatment liquid according to [1] or [2], in which the second organic solvent is an ester-based solvent having 5 to 8 carbon atoms or a carbonic acid ester-based solvent having 5 to 9 carbon atoms.
[4] The treatment liquid according to any one of [1] to [3], in which the first organic solvent is an ether-based solvent having 6 to 12 carbon atoms, which contains a branched chain alkyl group.
[5] The treatment liquid according to any one of [1] to [4], in which the second organic solvent is an ester-based solvent having 5 to 8 carbon atoms, which contains a branched chain alkyl group.
[6] The treatment liquid according to any one of [1] to [5], in which the first organic solvent is selected from the group consisting of diisopropyl ether, diisobutyl ether, diisoamyl ether, isopropyl propyl ether, isopropyl n-butyl ether, n-propyl isobutyl ether, isopropyl isobutyl ether, isopropyl isoamyl ether, isobutyl isoamyl ether, n-butyl isoamyl ether, and n-amyl isoamyl ether.
[7] The treatment liquid according to any one of [1] to [6], in which the second organic solvent is selected from the group consisting of t-butyl formate, isopentyl formate, 1,1-dimethylpropyl formate, 2,2-dimethylpropyl formate, 2-methylbutyl formate, isopropyl propanoate, isopentyl propanoate, diethyl carbonate, dipropyl carbonate, diisopropyl carbonate, dibutyl carbonate, diisobutyl carbonate, ditert-butyl carbonate, and ethyl isopentyl carbonate.
[8] The treatment liquid according to any one of [1] to [7], in which the first organic solvent and the second organic solvent satisfy a relationship of Expression (3),

$$\text{Expression (3): } 5.0°C < bp1 - bp2 < 100.0°C$$

bp1: boiling point of first organic solvent
bp2: boiling point of second organic solvent.

[9] The treatment liquid according to any one of [1] to [8], in which the actinic ray-sensitive or radiation-sensitive composition contains a resin having a hydroxystyrene-based repeating unit.
[10] A pattern forming method comprising: a resist film forming step of forming a resist film by using an actinic ray-sensitive or radiation-sensitive composition; an exposing step of exposing the resist film; and a treatment step of treating the exposed resist film with the treatment liquid according to any one of [1] to [8].
[11] A pattern forming method comprising: a resist film forming step of forming a resist film by using an actinic ray-sensitive or radiation-sensitive composition; an exposing step of exposing the resist film; and a treatment step of treating the exposed resist film, in which the treatment step includes a developing step of developing the film with a developer, and a rinsing step of washing the film with a rinsing liquid, and the rinsing liquid is the treatment liquid according to any one of [1] to [8].

According to the present invention, it is possible to provide a treatment liquid excellent in resolution, a property of suppressing reduction in film thickness, and a property of suppressing residues, in a case of being used for at least one of developing or washing (rinsing) a resist film. Further, it is possible to provide a pattern forming method for the above-described treatment liquid.

## BRIEF DESCRIPTION OF THE DRAWINGS

Fig. 1 is a micrograph showing an example of a pattern prepared in examples and comparative examples.

## DESCRIPTION OF THE PREFERRED EMBODIMENTS

Hereinafter, the present invention will be described in detail.

Description of configuration requirements described below may be made on the basis of representative embodiments of the present invention in some cases, but the present invention is not limited to such embodiments.

In notations for a group (atomic group) in the present specification, in a case where the group is cited without specifying whether it is substituted or unsubstituted, the group includes both a group having no substituent and a group having a substituent as long as this does not impair the spirit of the present invention. For example, "alkyl group" includes not only an alkyl group having no substituent (unsubstituted alkyl group), but also an alkyl group having a substituent (substituted alkyl group). In addition, "organic group" in the present specification denotes a group having at least one carbon atom.

"Actinic rays" or "radiation" in the present specification denotes, for example, a bright line spectrum of a mercury lamp, far ultraviolet rays typified by an excimer laser, extreme ultraviolet rays (EUV light), X-rays, or electron beams (EB). In the present specification, "light" denotes actinic rays or radiation.

In the present specification, the concept of "exposure" includes not only exposure to a bright line spectrum of a mercury lamp, far ultraviolet rays typified by an excimer laser, extreme ultraviolet rays, X-rays, EUV light, and the like, but also lithography by particle beams such as electron beams and ion beams, unless otherwise specified.

In the present specification, a numerical range shown using "to" indicates a range including numerical values described before and after "to" as a lower limit and an upper limit.

The bonding direction of divalent groups denoted in the present specification is not limited unless otherwise specified.

For example, in a case where Y in a compound represented by General Formula "X-Y-Z" represents -COO-, Y may represent -CO-O- or -O-CO-. In addition, the compound may be "X-CO-O-Z" or "X-O-CO-Z".

In the present specification, (meth)acrylate denotes acrylate and methacrylate, and (meth)acryl denotes acryl and methacryl.

In the present specification, examples of the halogen atom include a fluorine atom, a chlorine atom, a bromine atom, and an iodine atom.

In the present specification, the weight-average molecular weight (Mw), the number average molecular weight (Mn), and the dispersity (also referred to as molecular weight distribution) (Mw/Mn) of a resin are defined as values in terms of polystyrene by means of gel permeation chromatography (GPC) measurement (solvent: tetrahydrofuran, flow rate (amount of sample to be injected): 10 μL, columns: TSK gel Multipore HXL-M, manufactured by Tosoh Corporation, column temperature: 40°C, flow speed: 1.0 mL/min, detector: differential refractive index detector) using a GPC device (HLC-8120 GPC, manufactured by Tosoh Corporation).

The Hansen solubility parameter (also referred to as "SP value", unit: $MPa^{1/2}$) in the present specification is defined by three-dimensional parameters (δd, δp, and δh) and is acquired by Equation (1). The details of the SP value are described in "PROPERTIES OF POLYMERS" (writer: D. W. VAN KREVELEN, publisher: ELSEVIER SCIENTIFIC PUBLISHING COMPANY, published in 1989, 5th edition).

$$\text{Equation (1): SP value} = ((\delta d)^2 + (\delta p)^2 + (\delta h)^2)^{0.5}$$

8d represents a dispersion element (also referred to as a London dispersion force element) (unit: $MPa^{1/2}$).
δp represents a polarity element (also referred to as a molecular polarization element) (unit: $MPa^{1/2}$).
8h represents a hydrogen bond element (unit: $MPa^{1/2}$).
8d, δp, and δh can be calculated using Hansen Solubility Parameters in Practice (HSPiP), which is a program developed by Dr. Hansen's group who proposed the SP value. In addition, δd, δp, and δh in the present specification are values calculated using the program Ver. 5.1.04.

Further, the polarity of an organic solvent decreases as the SP value decreases. That is, in a case where the SP value of a solvent decreases, the affinity for a resist film is lowered, and excessive permeation into the resist film can be suppressed, that is, swelling can be suppressed.

In the present specification, the boiling point denotes a boiling point at 1 atm.

In the present specification, the organic solvent denotes an organic compound in a liquid state at 25°C.

The kind and the content of the organic compound contained in the treatment liquid are measured by, for example, direct injection mass chromatography (DI-MS).

[Treatment Liquid]

A treatment liquid according to the embodiment of the present invention is a treatment liquid for patterning a resist film, which is used for at least one of developing or washing a resist film obtained from an actinic ray-sensitive or radiation-sensitive composition (hereinafter, also referred to as "resist composition"). The treatment liquid according to the embodiment of the present invention contains a first organic solvent that satisfies Condition A and a second organic solvent that satisfies Condition B.

In a case where a pattern is formed by exposing and developing a resist film, residues may be generated on the pattern. In order to suppress generation of residues and/or reduce residues on such a pattern, an organic solvent with a high polarity can be effectively used as a treatment liquid (developer and/or rinsing liquid). However, the organic solvent with a high polarity may dissolve the pattern itself and cause reduction in film thickness of the pattern. In addition, such an organic solvent with a high polarity alone is likely to have low volatility and may be a factor of deteriorating the resolution of a dense pattern (for example, causing pattern collapse of a dense pattern).

As a result of further examination conducted by the present invention based on the above-described findings, it was clarified that, according to the treatment liquid containing the first organic solvent and the second organic solvent, generation of residues is suppressed and/or generation of residues and reduction in film thickness of residues on the pattern to be formed are simultaneously suppressed, and the resolution can also be improved.

The action of the first organic solvent for dissolving or swelling the pattern is suppressed, and thus the first organic solvent is considered to mainly contribute to improvement of the resolution and improvement of the property of suppressing reduction in film thickness by suppressing dissolution of the pattern. The second organic solvent is considered to mainly contribute to improvement of the property of suppressing residues.

Hereinafter, in a case where at least one of the resolution, the property of suppressing reduction in film thickness, or the property of suppressing residues is excellent, the expression of "the effect of the present invention is excellent" is used.

The present inventors consider that the use of the treatment liquid of the present invention is particularly significant in a case where the pattern is formed by exposure to EUV light.

That is, since EUV (wavelength of 13.5 nm) has a wavelength shorter than that of ArF excimer laser light (wavelength of 193 nm), the number of incident photons is small upon exposure of a resist film. Therefore, the density of acids to be generated during EUV exposure in the resist film tends to be lower than that of ArF exposure. In the resist film to which EUV exposure is applied as a method of compensation for this, the content of a photoacid generator tends to increase than that in the resist film to which ArF exposure is applied. As a result, in a case where the pattern is formed by EUV exposure, the solubility of the resist film derived from the photoacid generator is locally decreased, and thus residues are likely to be generated. Therefore, a pattern in which the abundance of residues is suppressed is likely to be obtained even in a case where the pattern is formed by EUV exposure, by applying the treatment liquid according to the embodiment of the present invention which contains the second organic solvent capable of improving the property of suppressing residues.

Further, in the treatment liquid, it is also preferable that an organic solvent having volatility higher than that of the first organic solvent is selected as the second organic solvent, and for example, it is preferable that the first organic solvent and the second organic solvent satisfy the relationship of Expression (3).

In a case where the second organic solvent has volatility higher than that of the first organic solvent, the second organic solvent is preferentially volatilized and thus the concentration of the first organic solvent on the formed pattern is increased during drying of the treatment liquid after a treatment with the treatment liquid (for example, a rinsing treatment). As a result, the effect of the first organic solvent is maximized, and particularly the effect of suppressing pattern collapse in a dense pattern is more significant.

Hereinafter, first, the first organic solvent and the second organic solvent will be described.

[First organic solvent]

The treatment liquid according to the embodiment of the present invention contains a first organic solvent that satisfies Condition A.

Condition A: The solution has a SP value of 15.0 $MPa^{1/2}$ or greater and less than 16.5 $MPa^{1/2}$ which is acquired by Equation (1) and is selected from a hydrocarbon-based solvent, an ester-based solvent, an ether-based solvent, or a carbonic acid ester-based solvent.

$$\text{Equation (1): SP value} = ((\delta d)^2 + (\delta p)^2 + (\delta h)^2)^{0.5}$$

SP value: Hansen solubility parameter of organic solvent

δd: dispersion element of organic solvent
δp: polarity element of organic solvent
8h: hydrogen bond element of organic solvent

The specific method of acquiring each variable in Equation (1) is as described above.
The SP value of the first organic solvent is 15.0 $MPa^{1/2}$ or greater and less than 16.5 $MPa^{1/2}$, preferably greater than 15.0 $MPa^{1/2}$ and less than 16.5 $MPa^{1/2}$, more preferably 15.2 $MPa^{1/2}$ or greater and less than 16.5 $MPa^{1/2}$, and still more preferably 15.4 $MPa^{1/2}$ or greater and less than 16.5 $MPa^{1/2}$.
The first organic solvent may be any of a hydrocarbon-based solvent, an ester-based solvent, an ether-based solvent, or a carbonic acid ester-based solvent.
Among these, a hydrocarbon-based solvent or an ether-based solvent is preferable, and an ether-based solvent is more preferable as the first organic solvent.
In a case where the first organic solvent is a hydrocarbon-based solvent, examples of the hydrocarbon-based solvent include a terpene-based hydrocarbon-based solvent, an alkane-based hydrocarbon-based solvent (which may be linear or branched chain and may have a cyclic structure), and an aromatic hydrocarbon-based solvent.
Examples of the hydrocarbon-based solvent that can be used as the first organic solvent include decane.
The hydrocarbon-based solvent may be used alone or in combination of two or more kinds thereof.
In a case where the first organic solvent is an ether-based solvent, the number of carbon atoms of the ether-based solvent is preferably in a range of 6 to 12 and more preferably in a range of 8 to 10.
The ether-based solvent contains preferably a linear or branched chain alkyl group and more preferably a branched alkyl group.
Meanwhile, from the viewpoints of the volatility and/or the solubility, the number of oxygen atoms of the ether-based solvent in a molecule is preferably 1. Further, it is also preferable that the ether-based solvent consists of only an alkyl group and an ether bond. For example, it is also preferable that the ether-based solvent contains none of an aromatic ring group, an alkoxycarbonyl group, an oxo group, an amino group, and/or a carbamoyl group. Further, it is also preferable that the ether-based solvent has only an oxygen atom as a heteroatom (such as an oxygen atom, a nitrogen atom, a sulfur atom, or a halogen atom).
As the ether-based solvent that can be used as the first organic solvent, one or more organic solvents selected from the group consisting of diisopropyl ether, diisobutyl ether, diisoamyl ether, isopropyl propyl ether, isopropyl n-butyl ether, n-propyl isobutyl ether, isopropyl isobutyl ether, isopropyl isoamyl ether, isobutyl isoamyl ether, n-butyl isoamyl ether, n-amyl isoamyl ether, and dibutyl ether are preferable, and one or more organic solvents selected from the group consisting of diisopropyl ether, diisobutyl ether, diisoamyl ether, isopropyl propyl ether, isopropyl n-butyl ether, n-propyl isobutyl ether, isopropyl isobutyl ether, isopropyl isoamyl ether, isobutyl isoamyl ether, n-butyl isoamyl ether, and n-amyl isoamyl ether are more preferable.
The ether-based solvent may be used alone or in combination of two or more kinds thereof.
It is also preferable that an ester-based solvent is used as the first organic solvent.
In a case where the first organic solvent is an ester-based solvent, the number of carbon atoms of the ester-based solvent is more preferably in a range of 5 to 8.
The ester-based solvent may be linear or branched chain and may have a cyclic structure.
The ester-based solvent contains preferably a linear or branched chain alkyl group and more preferably a branched chain alkyl group.
Meanwhile, from the viewpoints of the volatility and/or the solubility, the number of oxygen atoms of the ester-based solvent in a molecule is preferably 2. Further, it is also preferable that the ester-based solvent consists of only an alkyl group, an ester bond, and a hydrogen atom that can be bonded to the carbonyl carbon in the ester bond. For example, it is also preferable that the ester-based solvent contains none of an aromatic ring group, an oxo group, an amino group, and/or a carbamoyl group. Further, it is also preferable that the ester-based solvent has only an oxygen atom as a heteroatom (such as an oxygen atom, a nitrogen atom, a sulfur atom, or a halogen atom).
As the ester-based solvent that can be used as the first organic solvent, isobutyl isobutanoate is preferable.
The ester-based solvent may be used alone or in combination of two or more kinds thereof.
The first organic solvent may be used alone or in combination of two or more kinds thereof.
The content of the first organic solvent is preferably in a range of 1% to 90% by mass, more preferably in a range of 3% to 75% by mass, and still more preferably in a range of 5% to 60% by mass with respect to the total mass of the treatment liquid.

[Second organic solvent]

The treatment liquid according to the embodiment of the present invention contains a second organic solvent that satisfies Condition B.

Condition B: The solution has a SP value of 16.5 $MPa^{1/2}$ or greater and less than 17.6 $MPa^{1/2}$ which is acquired by Equation (1) and has an X value of 7.0 or greater and less than 20.0 which is acquired by Equation (2), and is selected from a hydrocarbon-based solvent, an ester-based solvent, an ether-based solvent, or a carbonic acid ester-based solvent.

The SP value of the second organic solvent is 16.5 $MPa^{1/2}$ or greater and less than 17.6 $MPa^{1/2}$, preferably greater than 16.5 $MPa^{1/2}$ and less than 17.6 $MPa^{1/2}$, more preferably 16.7 $MPa^{1/2}$ or greater and less than 17.6 $MPa^{1/2}$, and still more preferably 16.8 $MPa^{1/2}$ or greater and less than 17.6 $MPa^{1/2}$.

In the second organic solvent, the X value acquired by Equation (2) is 7.0 or greater and less than 20.0, preferably in a range of 7.0 to 19.0, more preferably in a range of 7.0 to 16.0, and still more preferably greater than 7.0 and 14.0 or less.

$$\text{Equation (2): } X = (\delta p)^2/((\delta d)^2 + (\delta p)^2 + (\delta h)^2) \times 100.$$

Each variable in Equation (2) has the same definition as that for each variable shown in Equation (1).

The second organic solvent contains preferably a linear or branched chain alkyl group and more preferably a branched chain alkyl group.

In a case where the second organic solvent contains a plurality of the alkyl groups, the plurality of the alkyl groups may be the same as or different from each other.

The second organic solvent may be any of a hydrocarbon-based solvent, an ester-based solvent, an ether-based solvent, or a carbonic acid ester-based solvent.

Among these, an ester-based solvent or a carbonic acid ester-based solvent is preferable as the second organic solvent.

In a case where the second organic solvent is an ester-based solvent, the number of carbon atoms of the ester-based solvent is more preferably in a range of 5 to 8.

The ester-based solvent may be linear or branched chain and may have a cyclic structure.

The ester-based solvent contains preferably a linear or branched chain alkyl group and more preferably a branched chain alkyl group.

Meanwhile, from the viewpoints of the volatility and/or the solubility, the number of oxygen atoms of the ester-based solvent in a molecule is preferably 2. Further, it is also preferable that the ester-based solvent consists of only an alkyl group, an ester bond, and a hydrogen atom that can be bonded to the carbonyl carbon in the ester bond. For example, it is also preferable that the ester-based solvent contains none of an aromatic ring group, an oxo group, an amino group, and/or a carbamoyl group. Further, it is also preferable that the ester-based solvent has only an oxygen atom as a heteroatom (such as an oxygen atom, a nitrogen atom, a sulfur atom, or a halogen atom).

As the ester-based solvent that can be used as the second organic solvent, one or more organic solvents selected from the group consisting of t-butyl formate, isopentyl formate, 1,1-dimethylpropyl formate, 2,2-dimethylpropyl formate, 2-methylbutyl formate, isopropyl propanoate, isopentyl propanoate, and propyl propionate are preferable, and one or more organic solvents selected from the group consisting of t-butyl formate, isopentyl formate, 1,1-dimethylpropyl formate, 2,2-dimethylpropyl formate, 2-methylbutyl formate, isopropyl propanoate, and isopentyl propanoate are more preferable.

The ester-based solvent may be used alone or in combination of two or more kinds thereof.

In a case where the second organic solvent is a carbonic acid ester-based solvent, the number of carbon atoms of the carbonic acid ester-based solvent is preferably in a range of 5 to 9.

The carbonic acid ester-based solvent may be linear or branched chain and may have a cyclic structure.

The carbonic acid ester-based solvent contains preferably a linear or branched chain alkyl group and more preferably a branched chain alkyl group.

Meanwhile, from the viewpoints of the volatility and/or the solubility, the number of oxygen atoms of the carbonic acid ester-based solvent in a molecule is preferably 3. Further, it is also preferable that the carbonic acid ester-based solvent consists of only an alkyl group and a carbonic acid ester bond (-O-CO-O-). For example, it is also preferable that the carbonic acid ester-based solvent contains none of an aromatic ring group, an oxo group, an amino group, and/or a carbamoyl group. Further, it is also preferable that the carbonic acid ester-based solvent has only an oxygen atom as a heteroatom (such as an oxygen atom, a nitrogen atom, a sulfur atom, or a halogen atom).

As the carbonic acid ester-based solvent that can be used as the second organic solvent, one or more organic solvents selected from the group consisting of diethyl carbonate, dipropyl carbonate, diisopropyl carbonate, dibutyl carbonate, diisobutyl carbonate, ditert-butyl carbonate, and ethyl isopentyl carbonate are preferable.

The second organic solvent may be used alone or in combination of two or more kinds thereof.

Further, the treatment liquid may intentionally or inevitably contain a regioisomer (for example, a regioisomer of the first or second organic solvent containing a linear or branched chain alkyl group) of the organic solvent in addition

to the first or second organic solvent to be contained in the treatment liquid. The regioisomer may correspond to the first or second organic solvent or may correspond to another component.

In a case where the treatment liquid contains two or more compounds each having a regioisomer (assuming that at least one of the two or more compounds corresponds to the first or second organic solvent), the total content of the compounds each having a regioisomer with respect to 100% by mass of the compound having the highest content of the regioisomer (preferably a compound corresponding to the first or second organic solvent) is preferably greater than 0% by mass and 1% by mass or less.

The content of the second organic solvent is preferably in a range of 10% to 99% by mass, more preferably in a range of 25% to 97% by mass, and still more preferably in a range of 40% to 95% by mass with respect to the total mass of the treatment liquid.

[Relationship between first organic solvent and second organic solvent]

The boiling points of the first organic solvent and the second organic solvent in the treatment liquid according to the embodiment of the present invention are each independently preferably in a range of 80°C to 200°C, more preferably in a range of 90°C to 200°C, still more preferably in a range of 100°C to 190°C, and particularly preferably in a range of 105°C to 185°C.

Further, the first organic solvent and the second organic solvent in the treatment liquid according to the embodiment of the present invention satisfy preferably the relationship of Expression (5), more preferably the relationship of Expression (4), and still more preferably the relationship of Expression (3).

$$\text{Expression (3): } 5.0°C < bp1 - bp2 < 100.0°C$$

$$\text{Expression (4): } 0.0°C < bp1 - bp2 < 120.0°C$$

$$\text{Expression (5): } -50.0°C < bp1 - bp2 < 150.0°C$$

In the relational expressions (Expressions (3) to (5)), bp1 represents the boiling point (°C) of the first organic solvent, and bp2 represents the boiling point (°C) of the second organic solvent.

In a case where the treatment liquid contains two or more kinds of the first organic solvents and/or the second organic solvents, at least one combination (preferably all combinations) of a plurality of the first organic solvents and a plurality of the second organic solvents may satisfy the above-described relational expressions.

Among these, it is preferable that a combination of the highest content of first organic solvent and the highest content of the second organic solvent in the treatment liquid satisfies the above-described relational expressions. The content here is a content in terms of mass.

After the treatment with the treatment liquid used in the present invention, a wafer is typically dried by rotating the wafer at a high speed. During the drying, since the second organic solvent volatilizes first, the concentration of the first organic solvent in the treatment liquid remaining on the wafer increases. As a result, the effect of suppressing swelling of the pattern by the first organic solvent is increased, and the pattern collapse is further suppressed. In this manner, since the effect of suppressing pattern collapse is exhibited even with a small amount of the first organic solvent, both the resolution performance and the property of suppressing residues can be achieved.

It is preferable that at least one of the first organic solvent or the second organic solvent of the treatment liquid according to the embodiment of the present invention contains a branched chain alkyl group.

Further, it is more preferable that the first organic solvent contains a branched chain alkyl group and the second organic solvent contains a branched chain alkyl group.

In the case where the treatment liquid contains two or more kinds of the first organic solvents and/or the second organic solvents, it is preferable that one or more (preferably all kinds) of a plurality of the first organic solvents contain a branched chain alkyl group and that one or more (preferably all kinds) of a plurality of the second organic solvents contain a branched chain alkyl group.

Among these, it is preferable that the highest content of the first organic solvent contains a branched chain alkyl group. Further, it is preferable that the highest content of the second organic solvent contains a branched chain alkyl group. The content here is a content in terms of mass.

The treatment liquid according to the embodiment of the present invention may contain at least one first organic solvent and at least one second organic solvent.

The treatment liquid according to the embodiment of the present invention can be appropriately adjusted according to the purpose.

In a case where the treatment liquid is used as a developer, since the treatment liquid is required to have a certain degree of solubility, it is also preferable that the content of the second organic solvent is high.

Meanwhile, in a case where the treatment liquid is used as a washing liquid (also referred to as a rinsing liquid) after development, it is preferable that the content of the first organic solvent is high from the viewpoint of suppressing reduction in film thickness of the pattern.

For example, the mass ratio of the content of the second organic solvent to the content of the first organic solvent (mass content of second organic solvent/mass content of first organic solvent) is preferably in a range of 10/90 to 99/1, more preferably in a range of 25/75 to 97/3, and still more preferably in a range of 40/60 to 95/5.

The total content of the first organic solvent and the second organic solvent in the treatment liquid according to the embodiment of the present invention is preferably 95.0% by mass or greater, more preferably 98.0% by mass or greater, still more preferably 99.0% by mass or greater, particularly preferably 99.5% by mass or greater, and most preferably 99.9% by mass or greater with respect to the total mass of the treatment liquid. The upper limit of the total content is, for example, 100% by mass.

[Other components]

The treatment liquid according to the embodiment of the present invention may contain other components in addition to the components described above.

<Metal component>

The treatment liquid may contain a metal component.

Examples of the metal component include metal particles and metal ions. For example, the content of the metal component denotes the total content of metal particles and metal ions.

The treatment liquid may contain any or both of metal particles and metal ions.

Examples of the metal atom contained in the metal component include metal atoms selected from the group consisting of Ag, Al, As, Au, Ba, Ca, Cd, Co, Cr, Cu, Fe, Ga, Ge, K, Li, Mg, Mn, Mo, Na, Ni, Pb, Sn, Sr, Ti, and Zn.

The metal component may contain one or two or more kinds of metal atoms.

The metal particles may be a simple metal or an alloy, and may be in the form of particles in which a metal and an organic substance are aggregated.

The metal component may be a metal component which is inevitably or intentionally contained in each component (raw material) of the treatment liquid or a metal component inevitably or intentionally contained in the treatment liquid during the production, storage, and/or transfer of the treatment liquid.

In a case where the treatment liquid contains a metal component, the content of the metal component is preferably greater than 0 mass ppt and 1 mass ppm or less, more preferably greater than 0 mass ppt and 10 mass ppb or less, and still more preferably greater than 0 mass ppt and 10 mass ppt or less with respect to the total mass of the treatment liquid.

Further, the kind and the content of the metal component in the treatment liquid can be measured by an inductively coupled plasma mass spectrometry (ICP-MS) method.

<Ionic liquid>

The treatment liquid according to the embodiment of the present invention may contain an ionic liquid described below. Further, in a case where the treatment liquid contains an ionic liquid, the ionic liquid is not included in the first organic solvent or the second organic solvent.

Preferred examples of the ionic liquid include ionic liquids having aromatic ions such as pyridinium ions or imidazolium ions, and aliphatic amine-based ions such as trimethylhexyl ammonium ions as cations, and inorganic ions such as $NO_3^-$, $CH_3CO_2^-$, $BF_6^-$, or $PF_6^-$ and fluorine-containing organic anions such as $(CF_3SO_2)_2N^-$, $CF_3CO_2^-$ and $CF_3SO_2^-$ as anions; and quaternary ammonium salt-based ionic liquids.

Examples of commercially available products of the ionic liquid include IL-P14 and IL-A2 (both manufactured by Koei Chemical Industry Co., Ltd.) and ELEGAN SS-100 (manufactured by NOF Corporation) which is a quaternary ammonium salt-based ionic liquid. The ionic liquid may be used alone or in combination of two or more kinds thereof.

In a case where the treatment liquid according to the embodiment of the present invention contains an ionic liquid, the content of the ionic liquid is preferably in a range of 0.5% to 15% by mass, more preferably in a range of 1% to 10% by mass, and still more preferably in a range of 1% to 5% by mass with respect to the total mass of the treatment liquid.

<Surfactant>

The treatment liquid according to the embodiment of the present invention may contain a surfactant.
In a case where the treatment liquid contains a surfactant, the wettability of the treatment liquid with respect to the resist film is improved, and development and/or rinsing proceeds more effectively.
A surfactant which can be contained in the resist composition described below can be used as the surfactant.
The surfactant may be used alone or in combination of two or more kinds thereof.
In a case where the treatment liquid according to the embodiment of the present invention contains a surfactant, the content of the surfactant is preferably in a range of 0.001% to 5% by mass, more preferably in a range of 0.005% to 2% by mass, and still more preferably in a range of 0.01% to 0.5% by mass with respect to the total mass of the treatment liquid.

<Antioxidant>

The treatment liquid according to the embodiment of the present invention may contain an antioxidant.
As the antioxidant, an amine-based antioxidant or a phenol-based antioxidant is preferable.
The antioxidant may be used alone or in combination of two or more kinds thereof.
In a case where the treatment liquid according to the embodiment of the present invention contains an antioxidant, the content of the antioxidant is preferably in a range of 0.0001% to 1% by mass, more preferably in a range of 0.0001% to 0.1% by mass, and still more preferably in a range of 0.0001% to 0.01% by mass with respect to the total mass of the treatment liquid.

<Basic compound>

The treatment liquid according to the embodiment of the present invention may contain a basic compound.
Specific examples of the basic compound include compounds exemplified as an acid diffusion control agent that can be contained in the resist composition described below.
The basic compound may be used alone or in combination of two or more kinds thereof.
In a case where the treatment liquid according to the embodiment of the present invention contains a basic compound, the content of the basic compound is preferably 10% by mass or less and more preferably in a range of 0.5% to 5% by mass with respect to the total amount of the treatment liquid.
In the present invention, the basic compound may be used alone or in combination of two or more kinds thereof with different chemical structures.

<Other Solvents>

The treatment liquid according to the embodiment of the present invention may contain other solvents.
In a case where the treatment liquid according to the embodiment of the present invention is used as a developer, the treatment liquid according to the embodiment of the present invention may contain other organic solvents in addition to the first organic solvent and the second organic solvent.
In a case where the treatment liquid according to the embodiment of the present invention is used as a rinsing liquid, the treatment liquid according to the embodiment of the present invention may contain other organic solvents in addition to the first organic solvent and the second organic solvent.
The other organic solvents are not particularly limited, and examples thereof include organic solvents that do not correspond to the first organic solvent and the second organic solvent, such as a hydrocarbon-based solvent, a ketone-based solvent, an ester-based solvent, an alcohol-based solvent, an amide-based solvent, and/or an ether-based solvent.

<Organic substance having boiling point of 300°C or higher>

In a case where a treatment liquid that contains an organic substance having a boiling point of 300°C or higher is applied to a semiconductor device manufacturing process, the organic substance having a high boiling point remains without being volatilized and causes defect failure of a substrate in some cases.
The organic substance having a boiling point of 300°C or higher may be, for example, a resin component or a plasticizer contained in a plastic material (for example, an O-ring) used for a member of a manufacturing device, and is assumed to be eluted in the liquid at any time point during the manufacturing process.
In a case where the content of the organic substance having a boiling point of 300°C or higher is in a range of 0.001 to 50 mass ppm with respect to the total mass of the treatment liquid, it was confirmed that the defect failure is

set to be in a range where the number of defects can be reduced by improving the treatment conditions for the development treatment or the rinsing treatment in the case where the treatment liquid is used for the semiconductor device manufacturing process. From the viewpoint of suppressing the defect failure of the substrate in a case where the treatment liquid is used for the semiconductor device manufacturing process, the content of organic substance having a boiling point of 300°C or higher is more preferably in a range of 0.001 to 30 mass ppm, still more preferably in a range of 0.001 to 15 mass ppm, particularly preferably in a range of 0.001 to 10 mass ppm, and most preferably in a range of 0.001 to 1 mass ppm with respect to the total mass of the treatment liquid.

From the viewpoint of suppressing the organic substance from remaining on the surface of the substrate without being volatilized and from causing defect failure in a case where the treatment liquid is used as a developer and brought into contact with the substrate, it is preferable that the content of the organic substance having a boiling point of 300°C or higher is 30 mass ppm or less with respect to the total mass of the treatment liquid.

From the viewpoint of suppressing the organic substance having a boiling point of 300°C or higher from remaining on the substrate even after a bake step and from causing defects (development failure) in a case where the treatment liquid is used as a developer and brought into contact with the substrate, it is more preferable that the content of the organic substance having a boiling point of 300°C or higher is 15 mass ppm or less with respect to the total mass of the treatment liquid.

As the organic substance having a boiling point of 300°C or higher which can be contained in the treatment liquid, components such as dioctyl phthalate (DOP, boiling point of 385°C) eluted from an O-ring, diisononyl phthalate (DINP, boiling point of 403°C), dioctyl adipate (DOA, boiling point 335°C), dibutyl phthalate (DBP, boiling point of 340°C), ethylene propylene rubber (EPDM, boiling point of 300°C to 450°C), and the like have been confirmed.

Examples of a method of setting the content of organic substance having a boiling point of 300°C or higher in the treatment liquid to be in the above-described range include the methods described in the section of the purifying step below.

[Pattern forming method]

The present invention also relates to a pattern forming method using the above-described treatment liquid.

The pattern forming method includes, for example, (i) a resist film forming step of forming a resist film using a resist composition, (ii) an exposing step of exposing the resist film, and (iii) a treatment step of treating the exposed resist film with the above-described treatment liquid.

Hereinafter, each step of the pattern forming method will be described. Further, a developing step and a rinsing step will be respectively described as an example of the treatment step.

<Resist film forming step (i)>

The resist film forming step is a step of forming a resist film using a resist composition.

In the formation of a resist film using a resist composition, for example, a resist composition is prepared by dissolving each component described below in a solvent, and filtered through a filter as necessary, and a support (substrate is coated with the resist composition to form a resist film. The pore diameter of the filter is preferably 0.1 micron or less, more preferably 0.05 micron or less, and still more preferably 0.03 micron or less. As a material of the filter, polytetrafluoroethylene, polyethylene, or nylon is preferable.

For example, a support (substrate) is coated with the resist composition by an appropriate coating method such as a spinner. Thereafter, the coating film (the coating film of the applied resist composition) is dried to form a resist film. Various undercoat films (an inorganic film, an organic film, an antireflection film, and the like) may be formed on the underlayer of the resist film as necessary.

The support forming the resist film is not particularly limited, and a substrate which is typically used in a step of manufacturing a semiconductor such as an IC, a step of manufacturing a circuit board for a liquid crystal, a thermal head, or the like, and other lithographic steps of photofabrication can be used.

Specific examples of the support include an inorganic substrate such as silicon, $SiO_2$, or SiN.

Examples of the substrate include a semiconductor substrate consisting of a single layer and a semiconductor substrate consisting of multiple layers.

A material constituting the semiconductor substrate consisting of a single layer is not particularly limited, and in general, it is preferable that the semiconductor substrate is formed of silicon, silicon germanium, Group III to V compounds such as GaAs, and any combinations thereof.

In a case of the semiconductor substrate consisting of multiple layers, the configuration is not particularly limited, and the substrate may have, for example, exposed integrated circuit structures such as interconnect structures (interconnect features) such as a metal wire and a dielectric material on the semiconductor substrate such as silicon as described above. Examples of the metals and the alloys used in the interconnect structures include aluminum, aluminum

alloyed with copper, copper, titanium, tantalum, cobalt, silicon, titanium nitride, tantalum nitride, and tungsten, but the present invention is not limited thereto. Further, an interlayer dielectric layer, a silicon oxide layer, a silicon nitride layer, a silicon carbide layer, a carbon-doped silicon oxide layer, or the like may be provided on the semiconductor substrate.

As the drying method, a method of drying the composition by heating the composition is typically used.

The heating temperature is preferably in a range of 80°C to 180°C, more preferably in a range of 80°C to 150°C, still more preferably in a range of 80°C to 140°C, and particularly preferably in a range of 80°C to 130°C.

The heating time is preferably in a range of 30 to 1,000 seconds, more preferably in a range of 60 to 800 seconds, and still more preferably in a range of 60 to 600 seconds.

The film thickness of the resist film is typically 200 nm or less and preferably 100 nm or less.

For example, it is preferable that the film thickness of the resist film is 50 nm or less from the viewpoint of resolving a 1:1 line-and-space pattern with a size of 30 nm or less. In a case where the film thickness thereof is 50 nm or less, pattern collapse is unlikely to occur and excellent resolution performance is obtained in a case where a developing step described below is applied.

From the viewpoint that the etching resistance and the resolution are more excellent, the film thickness is preferably in a range of 15 to 70 nm and more preferably in a range of 15 to 65 nm.

<Exposing step (ii)>

In the pattern forming method, the exposing method in the exposing step (ii) may be liquid immersion exposure.

It is preferable that the pattern forming method includes a prebake (PB, also referred to as bake after application) step (iv) before the exposing step (ii).

It is preferable that the pattern forming method includes a post-exposure bake (PEB, also referred to as bake after exposure) step (v) after the exposing step (ii) and before the developing step (iii).

The pattern forming method may include the exposing step (ii) a plurality of times.

The pattern forming method may include the prebake step (iv) a plurality of times.

The pattern forming method may include the post-exposure bake step (v) a plurality of times.

In the pattern forming method, the film forming step (i), the exposing step (ii), and the treatment step (iii) described above can be performed by a generally known method.

In addition, a resist underlayer film (for example, spin on glass (SOG), spin on carbon (SOC), and an antireflection film) may be formed between the resist film and the support, as necessary.

As a material constituting the resist underlayer film, known organic or inorganic materials can be appropriately used.

A protective film (topcoat) may be formed on the upper layer of the resist film. As the protective film, a known material can be appropriately used. For example, the compositions for forming a protective film disclosed in the specification of US2007/0178407A, the specification of US2008/0085466A, the specification of US2007/0275326A, the specification of US2016/0299432A, the specification of US2013/0244438A, or the specification of WO2016/157988A can be suitably used. It is preferable that the composition for forming a protective film contains the above-described acid diffusion control agent. Further, for example, an upper layer film may be formed based on the description of <0072> to <0082> in JP2014-059543A.

The film thickness of the protective film is preferably in a range of 10 to 200 nm, more preferably in a range of 20 to 100 nm, and still more preferably in a range of 40 to 80 nm.

For any of the prebake step (iv) or the post-exposure bake step (v), the heating temperature is preferably in a range of 80°C to 150°C, more preferably in a range of 80°C to 140°C, and still more preferably in a range of 80°C to 130°C.

For any of the prebake step (iv) or the post-exposure bake step (v), the heating time is preferably in a range of 30 to 1,000 seconds, more preferably in a range of 60 to 800 seconds, and still more preferably in a range of 60 to 600 seconds.

The heating can be performed by units of an exposure device and a development device or may also be performed using a hot plate or the like.

A light source wavelength used in the exposing step is not limited, and examples thereof include infrared light, visible light, ultraviolet light, far ultraviolet light, extreme ultraviolet light (EUV), an X-ray, and an electron beam. Among these, far ultraviolet light is preferable, and the wavelength thereof is preferably 250 nm or less, more preferably 220 nm or less, and still more preferably in a range of 1 to 200 nm. Specific examples thereof include a KrF excimer laser (248 nm), an ArF excimer laser (193 nm), an $F_2$ excimer laser (157 nm), an X-ray, EUV (13 nm), and an electron beam. Among these, a KrF excimer laser, an ArF excimer laser, EUV, or an electron beam is preferable, and EUV or an electron beam is more preferable.

<Step (iii) of treating exposed film>

The step (iii) of treating the exposed film typically includes a developing step (vi) of developing the film with a

developer (developing step) and a rinsing step (vii) of washing the film with a rinsing liquid (rinsing step).

The treatment liquid according to the embodiment of the present invention may be used as a developer in the developing step or may be used as a rinsing liquid in the rinsing step. Among these, it is preferable that the treatment liquid is used as a rinsing liquid in the rinsing step.

In a case where the treatment liquid according to the embodiment of the present invention is used as a rinsing liquid in the rinsing step, it is preferable that a treatment liquid other than the treatment liquid according to the embodiment of the present invention is used as the developer in the developing step.

(Developing step)

The developing step is a step of developing the exposed resist film with the developer.

Examples of the developing method include a method in which a substrate is immersed in a tank filled with a developer for a certain period of time (dip method), a method in which development is performed by heaping a developer up onto a surface of a substrate by surface tension and allowing the developer to stand for a certain period of time (puddle method), a method in which a developer is sprayed onto a surface of a substrate (spray method), and a method in which a developer is continuously jetted onto a substrate rotating at a constant rate while a developer jetting nozzle is scanned at a constant rate (dynamic dispense method).

Further, a step of stopping the development while substituting the solvent with another solvent may be performed after the developing step.

The development time is preferably in a range of 10 to 300 seconds and more preferably in a range of 20 to 120 seconds.

The temperature of the developer is preferably in a range of 0°C to 50°C and more preferably in a range of 15°C to 35°C.

As the developer, the above-described treatment liquid may be used or another developer may be used.

In addition to the development using the treatment liquid, development using an alkali developer may be further performed (so-called double development).

• Other developers

Hereinafter, other developers (developers other than the treatment liquid according to the embodiment of the present invention) will be described.

The vapor pressure of the organic solvent used in the developer (the total vapor pressure in a case of a mixed solvent) is preferably 5 kPa or less, more preferably 3 kPa or less, and still more preferably 2 kPa or less at 20°C. By setting the vapor pressure of the organic solvent to 5 kPa or less, evaporation of the developer on a substrate or in a development cup is suppressed, the temperature uniformity in a substrate surface is improved, and as a result, the dimensional uniformity in the substrate surface is enhanced.

The organic solvent used in the developer is not particularly limited, and examples thereof include solvents such as an ester-based solvent, a ketone-based solvent, an alcohol-based solvent, an amide-based solvent, an ether-based solvent, and a hydrocarbon-based solvent.

It is preferable that the developer contains one or more solvents selected from the group consisting of a ketone-based solvent, an ester-based solvent, an alcohol-based solvent, and an ether-based solvent.

Examples of the ester-based solvent include methyl acetate, ethyl acetate, butyl acetate, isobutyl acetate, pentyl acetate, propyl acetate, isopropyl acetate, amyl acetate (pentyl acetate), isoamyl acetate (isopentyl acetate), 3-methylbutyl acetate, 2-methylbutyl acetate, 1-methylbutyl acetate, hexyl acetate, isohexyl acetate, heptyl acetate, octyl acetate, ethyl methoxyacetate, ethyl ethoxyacetate, propylene glycol monomethyl ether acetate (PGMEA; also known as 1-methoxy-2-acetoxypropane), ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, butyl propionate, pentyl propionate, hexyl propionate, heptyl propionate, butyl butanoate, isobutyl butanoate, pentyl butanoate, hexyl butanoate, isobutyl isobutanoate, propyl

pentanoate, isopropyl pentanoate, butyl pentanoate, pentyl pentanoate, ethyl hexanoate, propyl hexanoate, butyl hexanoate, isobutyl hexanoate, methyl heptanoate, ethyl heptanoate, propyl heptanoate, cyclohexyl acetate, cycloheptyl acetate, 2-ethylhexyl acetate, cyclopentyl propionate, methyl 2-hydroxypropionate, ethyl 2-hydroxypropionate, methyl-3-methoxypropionate, ethyl-3-methoxypropionate, ethyl-3-ethoxypropionate, and propyl-3 -methoxypropionate.

Among these, butyl acetate, amyl acetate, isoamyl acetate, 2-methylbutyl acetate, 1-methylbutyl acetate, hexyl acetate, pentyl propionate, hexyl propionate, heptyl propionate, or butyl butanoate is preferable, and isoamyl acetate is more preferable.

Examples of the ketone-based solvent include 1-octanone, 2-octanone, 1-nonanone, 2-nonanone, acetone, 2-heptanone, 4-heptanone, 1-hexanone, 2-hexanone, diisobutyl ketone, cyclohexanone, methylcyclohexanone, phenyl acetone, methyl ethyl ketone, methyl isobutyl ketone, acetyl acetone, acetonyl acetone, ionone, diacetonyl alcohol, acetyl carbinol, acetophenone, methyl naphthyl ketone, isophorone, propylene carbonate, and γ-butyrolactone. Among these, 2-heptanone is preferable.

Examples of the alcohol-based solvent include alcohol (monohydric alcohol) such as methanol, ethanol, 1-propanol, isopropanol, 1-butanol, 2-butanol, 3-methyl-1-butanol, tert-butyl alcohol, 1-pentanol, 2-pentanol, 1-hexanol, 1-heptanol, 1-octanol, 1-decanol, 2-hexanol, 2-heptanol, 2-octanol, 3-hexanol, 3-heptanol, 3-octanol, 4-octanol, 3-methyl-3-pentanol, cyclopentanol, 2,3-dimethyl-2-butanol, 3,3-dimethyl-2-butanol, 2-methyl-2-pentanol, 2-methyl-3-pentanol, 3-methyl-2-pentanol, 3-methyl-3-pentanol, 4-methyl-2-pentanol, 4-methyl-3-pentanol, cyclohexanol, 5-methyl-2-hexanol, 4-methyl-2-hexanol, 4,5-dimethyl-2-hexanol, 6-methyl-2-heptanol, 7-methyl-2-octanol, 8-methyl-2-nonanol, 9-methyl-2-decanol, or 3-methoxy-1-butanol; a glycol-based solvent such as ethylene glycol, diethylene glycol, or triethylene glycol; and a glycol ether-based solvent containing a hydroxyl group, such as ethylene glycol monomethyl ether, propylene glycol monomethyl ether (PGME; also known as 1-methoxy-2-propanol), diethylene glycol monomethyl ether, triethylene glycol monoethyl ether, methoxymethylbutanol, ethylene glycol monoethyl ether, ethylene glycol monopropyl ether, ethylene glycol monobutyl ether, propylene glycol monoethyl ether, propylene glycol monopropyl ether, propylene glycol monobutyl ether, or propylene glycol monophenyl ether. Among these, a glycol ether-based solvent is preferable.

Examples of the ether-based solvent include a glycol ether-based solvent containing no hydroxyl group, such as propylene glycol dimethyl ether, propylene glycol diethyl ether, diethylene glycol dimethyl ether, or diethylene glycol diethyl ether; an aromatic ether solvent such as anisole or phenetol; dioxane, tetrahydrofuran, tetrahydropyran, perfluoro-2-butyl tetrahydrofuran, perfluorotetrahydrofuran, 1,4-dioxane, and isopropyl ether, in addition to the above-described glycol ether-based solvent containing a hydroxyl group. Among these, a glycol ether-based solvent or an aromatic ether-based solvent such as anisole is preferable.

Examples of the amide-based solvent include N-methyl-2-pyrrolidone, N,N-dimethylacetamide, N,N-dimethylformamide, hexamethylphosphoric triamide, and 1,3-dimethyl-2-imidazolidinone.

Examples of the hydrocarbon-based solvent include an aliphatic hydrocarbon-based solvent such as pentane, hexane, octane, nonane, decane, dodecane, undecane, hexadecane, 2,2,4-trimethylpentane, 2,2,3-trimethylhexane, perfluorohexane, or perfluoroheptane; and an aromatic hydrocarbon-based solvent such as toluene, xylene, ethylbenzene, propylbenzene, 1-methylpropylbenzene, 2-methylpropylbenzene, dimethylbenzene, diethylbenzene, ethylmethylbenzene, trimethylbenzene, ethyldimethylbenzene, or dipropylbenzene.

Further, as the hydrocarbon-based solvent, an unsaturated hydrocarbon-based solvent can also be used, and examples thereof include an unsaturated hydrocarbon-based solvent such as octene, nonene, decene, undecene, dodecene, or hexadecene. The number of double bonds or triple bonds of the unsaturated hydrocarbon solvent is not particularly limited, and the unsaturated hydrocarbon solvent may have double bonds or triple bonds at any position of the hydrocarbon chain. Further, in a case where the unsaturated hydrocarbon solvent has a double bond, a cis form and a trans form may be present in a mixture.

In addition, the aliphatic hydrocarbon-based solvent which is a hydrocarbon-based solvent may be a mixture of compounds having the same number of carbon atoms but different structures. For example, in a case where decane is used as the aliphatic hydrocarbon-based solvent, 2-methylnonane, 2,2-dimethyloctane, 4-ethyloctane, isooctane, and the like which are compounds having the same number of carbon atoms and different structures may be contained in the aliphatic hydrocarbon-based solvent.

In addition, the solvent may contain only one or a plurality of kinds of the compounds having the same number of carbon atoms and different structures.

From the viewpoint of suppressing swelling of the resist film in a case where EUV light and electron beams are used in the exposing step, an ester-based solvent having 6 or more carbon atoms (preferably 6 to 14 carbon atoms, more preferably 6 to 12 carbon atoms, and still more preferably 6 to 10 carbon atoms), and 2 or less heteroatoms is preferable as the developer.

An atom other than a carbon atom and a hydrogen atom may be used as the heteroatom, and examples thereof include an oxygen atom, a nitrogen atom, and a sulfur atom. The number of the heteroatoms is preferably 2 or less.

As the specific examples of the ester-based solvent having 6 or more carbon atoms and 2 or less heteroatoms, solvents selected from the group consisting of butyl acetate, amyl acetate, isoamyl acetate, 2-methylbutyl acetate, 1-methylbutyl acetate, hexyl acetate, pentyl propionate, hexyl propionate, heptyl propionate, butyl butanoate, butyl isobutanoate, and isobutyl isobutanoate are preferable, and isoamyl acetate or butyl isobutanoate is more preferable.

From the viewpoint of further suppressing swelling of the resist film in a case where EUV light and electron beams are used in the exposing step, a mixed solvent of an ester-based solvent and a hydrocarbon-based solvent or a mixed solvent of a ketone-based solvent and a hydrocarbon solvent may be used as the developer, in place of the ester-based solvent having 6 or more carbon atoms and 2 or less heteroatoms.

The content of the hydrocarbon-based solvent in the mixed solvent is not particularly limited because the content thereof depends on the solvent solubility of the resist film, the required amount may be determined by appropriately adjusting the content.

In the mixed solvent of an ester-based solvent and a hydrocarbon-based solvent, isoamyl acetate is preferable as the ester-based solvent. From the viewpoint of easily adjusting the solubility of the resist film, a saturated hydrocarbon solvent (for example, octane, nonane, decane, dodecane, undecane, or hexadecane) is preferable as the hydrocarbon-based solvent.

Examples of the ketone-based solvent in the mixed solvent of a ketone-based solvent and a hydrocarbon-based solvent include 1-octanone, 2-octanone, 1-nonanone, 2-nonanone, acetone, 2-heptanone (methyl amyl ketone), 4-heptanone, 1-hexanone, 2-hexanone, diisobutyl ketone, 2,5-dimethyl-4-hexanone, cyclohexanone, methylcyclohexanone, phenyl acetone, methyl ethyl ketone, methyl isobutyl ketone, acetyl acetone, acetonyl acetone, ionone, diacetonyl alcohol, acetyl carbinol, acetophenone, methyl naphthyl ketone, isophorone, and propylene carbonate. Among these, diisobutyl ketone or 2,5-dimethyl-4-hexanone is preferable. From the viewpoint of easily adjusting the solubility of the resist film, a saturated hydrocarbon solvent (for example, octane, nonane, decane, dodecane, undecane, or hexadecane) is preferable as the hydrocarbon-based solvent.

The solvent may be used in a mixture of a plurality of the above-described solvents or in a mixture with water or a solvent other than those described above. The moisture content in the entire developer is preferably less than 50% by mass, more preferably less than 20% by mass, still more preferably less than 10% by mass, and particularly preferably substantially zero.

The content of the organic solvent with respect to the organic developer is preferably in a range of 50% to 100% by mass, more preferably in a range of 80% to 100% by mass, still more preferably in a range of 90% to 100% by mass, and particularly preferably in a range of 95% to 100% by mass with respect to the total amount of the developer.

The developer may include an appropriate amount of a known surfactant as necessary.

The content of the surfactant is typically in a range of 0.001% to 5% by mass, preferably in a range of 0.005% to 2% by mass, and more preferably in a range of 0.01% to 0.5% by mass with respect to the total amount of the developer.

The developer may include a basic compound. Specific examples of the basic compound include compounds exemplified as an acid diffusion control agent that can be contained in the resist composition described below.

As the organic solvent used as a developer, an ester-based solvent represented by General Formula (S1) or General Formula (S2) is also preferable in addition to the above-described ester-based solvents.

As the ester-based solvent, an ester-based solvent represented by General Formula (S1) is more preferable, alkyl acetate is still more preferable, and butyl acetate, amyl acetate (pentyl acetate), or isoamyl acetate (isopentyl acetate) is particularly preferable.

R-C(=O)-O-R'    General Formula (S1)

In General Formula (S1), R and R' each independently represent a hydrogen atom, an alkyl group, a cycloalkyl group, an alkoxyl group, an alkoxycarbonyl group, a carboxyl group, a hydroxyl group, a cyano group, or a halogen atom. R and R' may be bonded to each other to form a ring.

The number of carbon atoms of the alkyl group, the alkoxyl group, or the alkoxycarbonyl group represented by R and R' is preferably in a range of 1 to 15, and the number of carbon atoms of the cycloalkyl group is preferably in a range of 3 to 15.

The alkyl group, the cycloalkyl group, the alkoxyl group, and the alkoxycarbonyl group represented by R and R' and the ring formed by R and R' being bonded to each other may have a substituent. The substituent is not particularly limited, and examples thereof include a hydroxyl group, a group containing a carbonyl group (such as an acyl group, an aldehyde group, or an alkoxycarbonyl group), and a cyano group.

Among these, it is preferable that R and R' represents a hydrogen atom or an alkyl group.

Examples of the solvent represented by General Formula (S1) include methyl acetate, butyl acetate, ethyl acetate, isopropyl acetate, amyl acetate, isoamyl acetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, and ethyl 2-hydroxypropionate.

Among these, it is preferable that R and R' represent an unsubstituted alkyl group.

As the solvent represented by General Formula (S1), alkyl acetate is preferable, butyl acetate, amyl acetate (pentyl acetate), or isoamyl acetate (isopentyl acetate) is more preferable, and isoamyl acetate is still more preferable.

In a case where the developer contains a solvent represented by General Formula (S1), the developer may further contain one or more other organic solvents (hereinafter, also referred to as "combined solvent"). The combined solvent is not particularly limited as long as the combined solvent can be mixed with a solvent represented by General Formula (S1) without being separated, and examples thereof include a solvent selected from the group consisting of an ester-based solvent, a ketone-based solvent, an alcohol-based solvent, an amide-based solvent, an ether-based solvent, and a hydrocarbon-based solvent other than the solvent represented by General Formula (S1).

The combined solvent may be used alone or two or more kinds thereof, but it is preferable that the combined solvent is used alone from the viewpoint of obtaining stable performance.

In a case where the developer is a mixed solvent of the solvent represented by General Formula (S1) and one kind of combined solvent, the mixing ratio of the solvent represented by General Formula (S1) to the combined solvent is typically in a range of 20:80 to 99:1, preferably in a range of 50:50 to 97:3, more preferably in a range of 60:40 to 95:5, and still more preferably in a range of 60:40 to 90:10 in terms of the mass ratio.

As the organic solvent used as a developer, a solvent represented by General Formula (S2) is also preferable.

R"-C(=O)-O-R‴-O-R″″ General Formula (S2)

In General Formula (S2), R" and R″″ each independently represent a hydrogen atom, an alkyl group, a cycloalkyl group, an alkoxyl group, an alkoxycarbonyl group, a carboxyl group, a hydroxyl group, a cyano group, or a halogen atom. R" and R″″ may be bonded to each other to form a ring.

It is preferable that R" and R″″ represent a hydrogen atom or an alkyl group.

The number of carbon atoms of the alkyl group, the alkoxyl group, or the alkoxycarbonyl group represented by R" and R″″ is preferably in a range of 1 to 15, and the number of carbon atoms of the cycloalkyl group is preferably in a range of 3 to 15.

R'" represents an alkylene group or a cycloalkylene group and preferably an alkylene group.

The number of carbon atoms of the alkylene group represented by R‴ is preferably in a range of 1 to 10, and the number of carbon atoms of the cycloalkylene group represented by R‴ is preferably in a range of 3 to 10.

Further, the alkylene group represented by R'" may have an ether bond in the alkylene chain.

The alkyl group, the cycloalkyl group, the alkoxyl group, and the alkoxycarbonyl group represented by R" and R"", the alkylene group and the cycloalkylene group represented by R"", and the ring formed by R" and R″″ being bonded to each other may have a substituent. The substituent is not particularly limited, and examples thereof include a hydroxyl group, a group containing a carbonyl group (such as an acyl group, an aldehyde group, or an alkoxycarbonyl group), and a cyano group.

Examples of the solvent represented by General Formula (S2) include propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monophenyl ether acetate, diethylene glycol monobutyl ether acetate, diethylene glycol monoethyl ether acetate, propylene glycol monoethyl ether acetate, propylene glycol monopropyl ether acetate, methyl-3-methoxypropionate, ethyl-3-methoxypropionate, ethyl-3-ethoxypropionate, propyl-3-methoxypropionate, ethyl methoxyacetate, ethyl ethoxyacetate, 2-methoxybutyl acetate, 3-methoxybutyl acetate, 4-methoxybutyl acetate, 3-methyl-3-methoxybutyl acetate, 3-ethyl-3-methoxybutyl acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, and 4-methyl-4-methoxypentyl acetate. Among these, propylene glycol monomethyl ether acetate is preferable.

Among these, it is preferable that R" and R"" represent an unsubstituted alkyl group and R'" represents an unsubstituted alkylene group, more preferable that R" and R"" represent any of a methyl group or an ethyl group, and still more preferable that R" and R"" represent a methyl group.

In a case where the developer contains a solvent represented by General Formula (S2), the developer may further contain one or more other organic solvents (hereinafter, also referred to as "combined solvent"). The combined solvent is not particularly limited as long as the combined solvent can be mixed with a solvent represented by General Formula (S2) without being separated, and examples thereof include a solvent selected from the group consisting of an ester-based solvent, a ketone-based solvent, an alcohol-based solvent, an amide-based solvent, an ether-based solvent, and a hydrocarbon-based solvent other than the solvent represented by General Formula (S2).

The combined solvent may be used alone or two or more kinds thereof, but it is preferable that the combined solvent is used alone from the viewpoint of obtaining stable performance.

In a case where the developer is a mixed solvent of the solvent represented by General Formula (S2) and one kind of combined solvent, the mixing ratio of the solvent represented by General Formula (S2) to the combined solvent

is typically in a range of 20:80 to 99:1, preferably in a range of 50:50 to 97:3, more preferably in a range of 60:40 to 95:5, and still more preferably in a range of 60:40 to 90:10 in terms of the mass ratio.

Further, as the organic solvent used as a developer, an ether-based solvent containing one or more aromatic rings is also preferable, a solvent represented by General Formula (S3) is more preferable, and anisole is still more preferable.

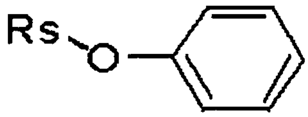

(S3)

In General Formula (S3), $R_S$ represents an alkyl group. As the alkyl group, an alkyl group having 1 to 4 carbon atoms is preferable, a methyl group or an ethyl group is more preferable, and a methyl group is still more preferable.

An aqueous alkali developer may be used as the developer (other developers).

(Rinsing step)

The rinsing step is a step of performing washing (rinsing) by a rinsing liquid after the developing step.

In the rinsing step, the substrate which has been subjected to development is subjected to a washing treatment using the above-described rinsing liquid.

The method of the washing treatment is not particularly limited, and for example, a method of continuously jetting a rinsing liquid onto a substrate rotating at a constant rate (rotation jetting method), a method of immersing a substrate in a tank filled with a rinsing liquid for a constant time (dip method), or a method of spraying a rinsing liquid onto the surface of a substrate (spray method) can be applied. Among these, it is preferable that the washing treatment is performed by the rotation jetting method, the substrate is allowed to rotate at a rotation speed of 2000 rpm to 4000 rpm after being washed to remove the rinsing liquid from the substrate.

The rinsing time is preferably in a range of 10 to 300 seconds, more preferably in a range of 10 to 180 seconds, and still more preferably in a range of 20 to 120 seconds.

The temperature of the rinsing liquid is preferably in a range of 0°C to 50°C and more preferably in a range of 15°C to 35°C.

As the rinsing liquid, the above-described treatment liquid may be used or other rinsing liquids may be used.

Examples of the other rinsing liquids include the above-described other developers and water.

In addition, a treatment of removing the developer or the rinsing liquid adhering onto a pattern with a supercritical fluid can be performed after the development treatment or the rinsing treatment.

In addition, a drying treatment for removing the solvent remaining in the pattern may be performed after the development treatment, the rinsing treatment, or the treatment with a supercritical fluid.

The drying temperature is preferably in a range of 40°C to 160°C, more preferably in a range of 50°C to 150°C, and still more preferably in a range of 50°C to 110°C.

The drying time is preferably in a range of 15 to 300 seconds and more preferably in a range of 15 to 180 seconds.

In the pattern forming method according to the embodiment of the present invention, the treatment liquid according to the embodiment of the present invention is used as at least one of the developer or the rinsing liquid. Among these, it is preferable that the treatment liquid according to the embodiment of the present invention is used as the rinsing liquid.

For example, in a case where pattern formation is performed using an ester-based solvent as the developer in the developing step and using the treatment liquid according to the embodiment of the present invention as the rinsing liquid in the rinsing step, it is preferable that the supply interval of the developer and the rinsing liquid to the resist film after exposure is set to 1 second or longer. By setting the supply interval of the developer and the rinsing liquid to a predetermined time or longer, deterioration of the solubility of the unexposed region of the resist film after exposure can be suppressed, and an increase of defects due to the solvent shock can be suppressed.

Further, the developer and the rinsing liquid are typically accommodated in a common waste liquid tank through a pipe after use. Here, in a case where an ester-based solvent is used as the developer in the developing step and the treatment liquid according to the embodiment of the present invention is used as the rinsing liquid in the rinsing step, there is a concern that the resist dissolved in the developer is deposited and adhered to the rear surface of the substrate and the side surface of the pipe so that the device is contaminated.

A method of passing the solvent in which the resist is dissolved through the pipe again is used in order to solve the above-described problem. Examples of the method of passing the solvent through the pipe include a method in which the rear surface, the side surface, and the like of a substrate are washed with a solvent in which a resist is dissolved and then the solvent is allowed to flow after performing washing with a rinsing liquid, and a method of circulating a solvent

in which a resist is dissolved to pass through a pipe such that the resist and the pipe do not come into contact with each other.

The solvent to pass through the pipe is not particularly limited as long as the solvent can dissolve the resist, and examples thereof include the above-described organic solvents used as the developer. Specific examples of the solvent include propylene glycol monomethyl ether acetate (PGMEA), propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate, ethylene glycol monoethyl ether acetate, propylene glycol monomethyl ether (PGME), propylene glycol monoethyl ether, propylene glycol monopropyl ether, propylene glycol monobutyl ether, ethylene glycol monomethyl ether, ethylene glycol monoethyl ether, 2-heptanone, ethyl lactate, 1-propanol, and acetone. Among these, PGMEA, PGME, or cyclohexanone is preferable.

Examples of other methods for solving the above-described problem include a method of adjusting the amount ratio between the developer and the rinsing liquid flowing into the pipe after use to an amount ratio set such that deposition of the resist does not occur and a method of further mixing a solvent having a high solubility for the resist with the developer and the rinsing liquid flowing through the pipe after use, in order to prevent deposition of the resist in the waste liquid flowing into the waste liquid tank through the pipe after use. Specific examples of the method include a method of suppressing deposition and precipitation of the resist in the waste liquid flowing into the waste liquid tank through the pipe after use by continuously supplying an organic solvent having a SP value higher than that of the first organic solvent and/or the second organic solvent contained in the treatment liquid according to the embodiment of the present invention to the rear surface of the wafer, between the developing step and the rinsing step.

Further, it is also preferable that the developer and the rinsing liquid are accommodated in separate waste liquid tanks after use.

For example, in a case where pattern formation is performed using an ester-based solvent as the developer in the developing step and using the treatment liquid according to the embodiment of the present invention as the rinsing liquid in the rinsing step, the ester-based solvent and the treatment liquid are accommodated in a common waste liquid tank through a pipe after use, the components contained in the resist composition such as the resin dissolved in the developer may be deposited (precipitated and solidified), which may cause contamination of the device. Specifically, clogging of the waste liquid pipe and contamination inside the treatment chamber are caused by the deposited components. In order to solve the above-described problems, it is preferable that the developer and the rinsing liquid are accommodated in separate waste liquid tanks by switching the pipe or the treatment chamber after use. Further, it is preferable that the inside of the treatment chamber may be washed with a solvent having a SP value higher than that of the first organic solvent contained in the treatment liquid according to the embodiment of the present invention after the treatment in order to remove the resist component that may adhere to the inside of the treatment chamber.

[Resist composition]

Next, the resist composition used in combination with the treatment liquid according to the embodiment of the present invention may be a so-called chemically amplified resist composition containing, for example, a resin, a photoacid generator, and/or an acid diffusion control agent, a molecular resist composition containing a low-molecular-weight phenol compound in place of a resin, a metal resist composition containing a metal oxide-based compound, or a main chain cutting type resist composition in which the main chain of the polymer is cut by exposure and the molecular weight is decreased.

The resist composition may be any of a negative tone resist composition or a positive tone resist composition.

Hereinafter, the chemically amplified resist composition, which is an aspect of the resist composition that can be used in combination with the treatment liquid according to the embodiment of the present invention, will be described in detail.

Hereinafter, the chemically amplified resist composition is also simply referred to as a resist composition.

<Resin (A)>

The resist composition contains a resin (hereinafter also referred to as "acid-decomposable resin" or "resin (A)") having a polarity that increases through decomposition due to the action of an acid.

That is, in the pattern forming method, typically, a positive tone pattern is suitably formed in a case where an alkali developer is employed as a developer, and a negative tone pattern is suitably formed in a case where an organic developer is employed as the developer.

The resin (A) typically contains a group having a polarity that increases through decomposition due to the action of an acid (hereinafter, also referred to as "acid-decomposable group") and preferably has a repeating unit containing an acid-decomposable group.

«Repeating unit containing acid-decomposable group»

The acid-decomposable group is a group that is decomposed due to the action of an acid to produce a polar group. It is preferable that the acid-decomposable group has a structure in which the polar group is protected by a leaving group that leaves due to the action of an acid. That is, the resin (A) has a repeating unit containing a group that is decomposed due to the action of an acid to produce a polar group. The resin having such a repeating unit has a polarity increased due to the action of an acid, and thus has an increased solubility in an alkali developer and a decreased solubility in an organic solvent.

As the polar group, an alkali-soluble group is preferable, and examples thereof include an acidic group such as a carboxyl group, a phenolic hydroxyl group, a fluorinated alcohol group, a sulfonic acid group, a phosphoric acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group, and an alcoholic hydroxyl group.

Among these, a carboxyl group, a phenolic hydroxyl group, a fluorinated alcohol group (preferably a hexafluoroisopropanol group), or a sulfonic acid group is preferable as the polar group.

Examples of the leaving group that leaves due to the action of an acid include groups represented by Formulae (Y1) to (Y4).

Formula (Y1): $-C(Rx_1)(Rx_2)(Rx_3)$

Formula (Y2): $-C(=O)OC(Rx_1)(Rx_2)(Rx_3)$

Formula (Y3): $-C(R_{36})(R_{37})(OR_{38})$

Formula (Y4): $-C(Rn)(H)(Ar)$

In Formula (Y1) and Formula (Y2), $Rx_1$ to $Rx_3$ each independently represent a (linear or branched chain) alkyl group or (monocyclic or polycyclic) cycloalkyl group, a (linear or branched chain) alkenyl group, or a (monocyclic or polycyclic) aryl group. In addition, in a case where all of $Rx_1$ to $Rx_3$ represent a (linear or branched chain) alkyl group, it is preferable that at least two of $Rx_1$, $Rx_2$, or $Rx_3$ represent a methyl group.

Here, it is preferable that $Rx_1$ to $Rx_3$ each independently represent a linear or branched chain alkyl group and more preferable that $Rx_1$ to $Rx_3$ each independently represent a linear alkyl group.

Two of $Rx_1$ to $Rx_3$ may be bonded to each other to form a monocycle or a polycycle.

As the alkyl group represented by $Rx_1$ to $Rx_3$, an alkyl group having 1 to 5 carbon atoms, such as a methyl group, an ethyl group, an n-propyl group, an isopropyl group, an n-butyl group, an isobutyl group, or a t-butyl group, is preferable.

As the cycloalkyl group represented by $Rx_1$ to $Rx_3$, a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group is preferable.

As the aryl group represented by $Rx_1$ to $Rx_3$, an aryl group having 6 to 10 carbon atoms is preferable, and examples thereof include a phenyl group, a naphthyl group, and an anthryl group.

As the alkenyl group represented by $Rx_1$ to $Rx_3$, a vinyl group is preferable.

A cycloalkyl group is preferable as the ring formed by two of $Rx_1$ to $Rx_3$ being bonded to each other. As the cycloalkyl group formed by two of $Rx_1$ to $Rx_3$ being bonded to each other, a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group is preferable, and a monocyclic cycloalkyl group having 5 or 6 carbon atoms is more preferable.

In the cycloalkyl group formed by two of $Rx_1$ to $Rx_3$ being bonded to each other, for example, one of the methylene groups constituting the ring may be substituted with a heteroatom such as an oxygen atom, a group having a heteroatom, such as a carbonyl group, or a vinylidene group. In addition, in the cycloalkyl group, one or more of the ethylene groups constituting the cycloalkane ring may be substituted with a vinylene group.

With regard to the group represented by Formula (Y1) or Formula (Y2), for example, an aspect in which $Rx_1$ represents a methyl group or an ethyl group, and $Rx_2$ and $Rx_3$ are bonded to each other to form a cycloalkyl group is preferable.

In Formula (Y3), $R_{36}$ to $R_{38}$ each independently represent a hydrogen atom or a monovalent organic group. $R_{37}$ and $R_{38}$ may be bonded to each other to form a ring. Examples of the monovalent organic group include an alkyl group, a cycloalkyl group, an aryl group, an aralkyl group, and an alkenyl group. It is also preferable that $R_{36}$ represents

the hydrogen atom.

Further, the alkyl group, the cycloalkyl group, the aryl group, and the aralkyl group may include a heteroatom such as an oxygen atom, and/or a group having a heteroatom, such as a carbonyl group. For example, one or more of the methylene groups of the alkyl group, the cycloalkyl group, the aryl group, and the aralkyl group may be substituted with a heteroatom such as an oxygen atom and/or a group having a heteroatom, such as a carbonyl group.

In addition, $R_{38}$ and another substituent contained in the main chain of the repeating unit may be bonded to each other to form a ring. As a group formed by the mutual bonding of $R_{38}$ and another substituent on the main chain of the repeating unit, an alkylene group such as a methylene group is preferable.

As Formula (Y3), a group represented by Formula (Y3-1) is preferable.

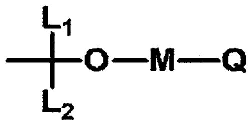

(Y3-1)

Here, $L_1$ and $L_2$ each independently represent a hydrogen atom, an alkyl group, a cycloalkyl group, an aryl group, or a group formed by combination thereof (for example, a group formed by combination of an alkyl group and an aryl group).

M represents a single bond or a divalent linking group.

Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by combination thereof (for example, a group formed by combination of an alkyl group and a cycloalkyl group).

In the alkyl group and the cycloalkyl group, for example, one methylene group may be substituted with a heteroatom such as an oxygen atom, or a group having a heteroatom, such as a carbonyl group.

In addition, it is preferable that one of $L_1$ or $L_2$ is a hydrogen atom, and the other is an alkyl group, a cycloalkyl group, an aryl group, or a group formed by combination of an alkylene group and an aryl group.

At least two of Q, M, or $L_1$ may be bonded to each other to form a ring (preferably a 5- or 6-membered ring).

From the viewpoint of pattern miniaturization, $L_2$ is preferably a secondary or tertiary alkyl group, and more preferably the tertiary alkyl group. Examples of the secondary alkyl group include an isopropyl group, a cyclohexyl group, and a norbornyl group, and examples of the tertiary alkyl group include a tert-butyl group and an adamantane group. In these aspects, since the glass transition temperature (Tg) and the activation energy are increased, it is possible to suppress fogging in addition to ensuring film hardness.

In Formula (Y4), Ar represents an aromatic ring group. Rn represents an alkyl group, a cycloalkyl group, or an aryl group. Rn and Ar may be bonded to each other to form a non-aromatic ring. Ar is more preferably an aryl group.

From the viewpoint that the acid decomposability of the repeating unit is excellent, in a case where a non-aromatic ring is directly bonded to a polar group (or a residue thereof) in an leaving group that protects the polar group, it is also preferable that a ring member atom adjacent to the ring member atom directly bonded to the polar group (or a residue thereof) in the non-aromatic ring has no halogen atom such as a fluorine atom as a substituent.

In addition, the leaving group that leaves due to the action of an acid may be a 2-cyclopentenyl group having a substituent (an alkyl group and the like), such as a 3-methyl-2-cyclopentenyl group, and a cyclohexyl group having a substituent (an alkyl group and the like), such as 1,1,4,4-tetramethylcyclohexyl group.

As the repeating unit having an acid-decomposable group, a repeating unit represented by Formula (A) is also preferable.

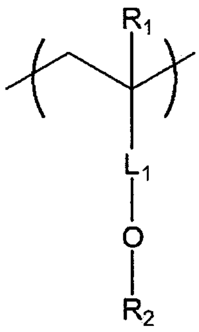

(A)

$L_1$ represents a divalent linking group which may have a fluorine atom or an iodine atom, $R_1$ represents a hydrogen atom, a fluorine atom, an iodine atom, a fluorine atom, an alkyl group which may have an iodine atom, or an aryl group which may have a fluorine atom or an iodine atom, and $R_2$ represents an leaving group that leaves due to the action of an acid and may have a fluorine atom or an iodine atom. Here, at least one of Li, $R_1$, or $R_2$ has a fluorine atom or an iodine atom.

$L_1$ represents a divalent linking group which may have a fluorine atom or an iodine atom. Examples of the divalent linking group which may have a fluorine atom or an iodine atom include -CO-, -O-, -S-, -SO-, $-SO_2-$, a hydrocarbon group which may have a fluorine atom or an iodine atom (for example, an alkylene group, a cycloalkylene group, an alkenylene group, and an arylene group), and a linking group formed by the linking of a plurality of these groups. Among these, as $L_1$, -CO- or -arylene group-alkylene group having a fluorine atom or an iodine atom- is preferable.

As the arylene group, a phenylene group is preferable.

The alkylene group may be linear or branched chain. The number of carbon atoms of the alkylene group is not particularly limited, but is preferably 1 to 10, and more preferably 1 to 3.

The total number of fluorine atoms and iodine atoms included in the alkylene group having a fluorine atom or an iodine atom is not particularly limited, but is preferably 2 or more, more preferably in a range of 2 to 10, and still more preferably in a range of 3 to 6.

$R_1$ represents a hydrogen atom, a fluorine atom, an iodine atom, an alkyl group which may have a fluorine atom or an iodine atom, or an aryl group which may have a fluorine atom or an iodine atom.

The alkyl group may be linear or branched chain. The number of carbon atoms of the alkyl group is not particularly limited, but is preferably 1 to 10, and more preferably 1 to 3.

The total number of fluorine atoms and iodine atoms included in the alkyl group having a fluorine atom or an iodine atom is not particularly limited, but is preferably 1 or more, more preferably in a range of 1 to 5, and still more preferably in a range of 1 to 3.

The alkyl group may include a heteroatom such as an oxygen atom other than a halogen atom.

$R_2$ represents a leaving group that leaves due to the action of an acid and may have a fluorine atom or an iodine atom.

Among these, examples of the leaving group include groups represented by Formulae (Z1) to (Z4).

Formula (Z1): $-C(Rx_{11})(Rx_{12})(Rx_{13})$.

Formula (Z2): $-C(=O)OC(Rx_{11})(Px_{12})(Px_{13})$.

Formula (Z3): $-C(R_{136})(R_{137})(OR_{138})$.

Formula (Z4): $-C(Rn_1)(H)(Ar_1)$

In Formulae (Z1) and (Z2), $Rx_{11}$ to $Rx_{13}$ each independently represent an (linear or branched) alkyl group which may have a fluorine atom or an iodine atom, a (monocyclic or polycyclic) cycloalkyl group which may have a fluorine atom or an iodine atom, an (linear or branched chain) alkenyl group which may have a fluorine atom or an iodine atom, or an (monocyclic or polycyclic) aryl group which may have a fluorine atom or an iodine atom. In addition, in a case where all of $Rx_{11}$ to $Rx_{13}$ are (linear or branched chain) alkyl groups, it is preferable that at least two of $Rx_{11}$, ..., or $Rx_{13}$ are methyl groups.

$Rx_{11}$ to $Rx_{13}$ are the same as $Rx_1$ to $Rx_3$ in (Y1) and (Y2) described above, respectively, except that $Rx_{11}$ to $Rx_{13}$ may have a fluorine atom or an iodine atom, and have the same definitions and suitable ranges as those of the alkyl group, the cycloalkyl group, the alkenyl group, and the aryl group.

In Formula (Z3), $R_{136}$ to $R_{138}$ each independently represent a hydrogen atom, or a monovalent organic group which may have a fluorine atom or an iodine atom. $R_{137}$ and $R_{138}$ may be bonded to each other to form a ring. Examples of the monovalent organic group which may have a fluorine atom or an iodine atom include an alkyl group which may have a fluorine atom or an iodine atom, a cycloalkyl group which may have a fluorine atom or an iodine atom, an aryl group which may have a fluorine atom or an iodine atom, an aralkyl group which may have a fluorine atom or an iodine atom, and a group formed by combination thereof (for example, a group formed by combination of an alkyl group and a cycloalkyl group).

In addition, a heteroatom such as an oxygen atom, in addition to the fluorine atom and the iodine atom, may be included in the alkyl group, the cycloalkyl group, the aryl group, and the aralkyl group. That is, in the alkyl group, the cycloalkyl group, the aryl group, and the aralkyl group, for example, one methylene group may be substituted with a heteroatom such as an oxygen atom, or a group having a heteroatom, such as a carbonyl group.

In addition, $R_{138}$ and another substituent contained in the main chain of the repeating unit may be bonded to each other to form a ring. In this case, a group formed by the mutual bonding of $R_{138}$ and another substituent on the main chain of the repeating unit is preferably an alkylene group such as a methylene group.

As Formula (Z3), a group represented by Formula (Z3-1) is preferable.

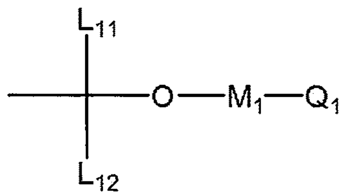

(Z3-1)

Here, $L_{11}$ and $L_{12}$ each independently represent a hydrogen atom; an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; or a group formed by combination thereof (for example, a group formed by combination of an alkyl group and a cycloalkyl group, each of which may have a heteroatom selected from the group consisting of a fluorine atom, an iodine atom, and an oxygen atom).

$M_1$ represents a single bond or a divalent linking group.

$Q_1$ represents an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; an amino group; an ammonium group; a mercapto group; a cyano group; an aldehyde group; a group formed by combination thereof (for example, a group formed by combination of the alkyl group and the cycloalkyl group, each of which may have a heteroatom selected from the group consisting of a fluorine atom, an iodine atom, and an oxygen atom).

In Formula (Z4), $Ar_1$ represents an aromatic ring group which may have a fluorine atom or an iodine atom. $Rn_1$ represents an alkyl group which may have a fluorine atom or an iodine atom, a cycloalkyl group which may have a fluorine atom or an iodine atom, or an aryl group which may have a fluorine atom or an iodine atom. $Rn_1$ and $Ar_1$ may be bonded to each other to form a non-aromatic ring.

As the repeating unit having an acid-decomposable group, a repeating unit represented by General Formula (AI) is also preferable.

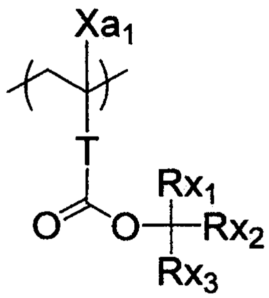

(A I)

In General Formula (AI), Xai represents a hydrogen atom, or an alkyl group which may have a substituent.

T represents a single bond or a divalent linking group.

$Rx_1$ to $Rx_3$ each independently represent an (linear or branched chain) alkyl group, a (monocyclic or polycyclic) cycloalkyl group, an (linear or branched chain) alkenyl group, or an (monocyclic or polycyclic) aryl group. Here, in a case where all of $Rx_1$ to $Rx_3$ represent an (linear or branched chain) alkyl group, it is preferable that at least two of $Rx_1$, $Rx_2$, or $Rx_3$ represent a methyl group.

Two of $Rx_1$ to $Rx_3$ may be bonded to each other to form a monocycle or polycycle (a monocyclic or polycyclic cycloalkyl group and the like).

Examples of the alkyl group which may have a substituent, represented by $Xa_1$, include a methyl group and a group represented by $-CH_2-R_{11}$. $R_{11}$ represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom; and an alkyl group having 3 or less carbon atoms is preferable, and a methyl group is more preferable. Xai is preferably a hydrogen atom, a methyl group, a trifluoromethyl group, or a hydroxymethyl group.

Examples of the divalent linking group of T include an alkylene group, an aromatic ring group, a -COO-Rt- group, and an -O-Rt- group. In the formulae, Rt represents an alkylene group or a cycloalkylene group.

T is preferably a single bond or a -COO-Rt- group. In a case where T represents the -COO-Rt-group, Rt is preferably an alkylene group having 1 to 5 carbon atoms, and more preferably a -CH2- group, a $-(CH_2)_2-$ group, or a $-(CH_2)_3-$ group.

As the alkyl group as $Rx_1$ to $R_{X3}$, an alkyl group having 1 to 4 carbon atoms, such as a methyl group, an ethyl group, an n-propyl group, an isopropyl group, an n-butyl group, an isobutyl group, and a t-butyl group, is preferable.

As the cycloalkyl group as $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group represented by $Rx_1$ to $Rx_3$, an aryl group having 6 to 10 carbon atoms is preferable, and examples thereof include a phenyl group, a naphthyl group, and an anthryl group.

As the alkenyl group represented by $Rx_1$ to $Rx_3$, a vinyl group is preferable.

As the cycloalkyl group formed by the bonding of two of $Rx_1$ to $Rx_3$, a monocyclic cycloalkyl group such as a cyclopentyl group and a cyclohexyl group is preferable, and in addition, a polycyclic cycloalkyl group such as norbornyl group, a tetracyclodecanyl group, a tetracyclododecanyl group, and an adamantyl group is preferable. Among these, a monocyclic cycloalkyl group having 5 or 6 carbon atoms is preferable.

In the cycloalkyl group formed by two of $Rx_1$ to $Rx_3$ being bonded to each other, for example, one of the methylene groups constituting the ring may be substituted with a heteroatom such as an oxygen atom, a group having a heteroatom, such as a carbonyl group, or a vinylidene group. In addition, in the cycloalkyl group, one or more of the ethylene groups constituting the cycloalkane ring may be substituted with a vinylene group.

With regard to the repeating unit represented by General Formula (AI), for example, an aspect in which $Rx_1$ is a methyl group or an ethyl group, and $Rx_2$ and $Rx_3$ are bonded to each other to form the above-described cycloalkyl group is preferable.

In a case where each of the groups has a substituent, examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms). The substituent preferably has 8 or less carbon atoms.

The repeating unit represented by General Formula (AI) is preferably an acid-decomposable tertiary alkyl

(meth)acrylate ester-based repeating unit (the repeating unit in which $Xa_1$ represents a hydrogen atom or a methyl group, and T represents a single bond).

The content of the repeating unit containing an acid-decomposable group is preferably 15% by mole or greater, more preferably 20% by mole or greater, still more preferably 25% by mole or greater, and particularly preferably 30% by mole or greater with respect to all repeating units in the resin (A). In addition, the upper limit thereof is not particularly limited, but is preferably 90% by mole or less, more preferably 80% by mole or less, and still more preferably 70% by mole or less.

Specific examples of the repeating unit having an acid-decomposable group are shown below, but the present invention is not limited thereto. Further, in the formulae, $Xa_1$ represents H, $CH_3$, $CF_3$, or $CH_2OH$, and Rxa and Rxb each represent a linear or branched chain alkyl group having 1 to 5 carbon atoms.

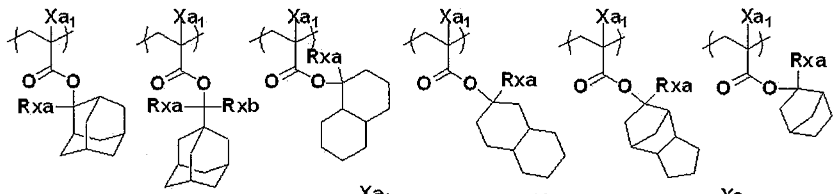

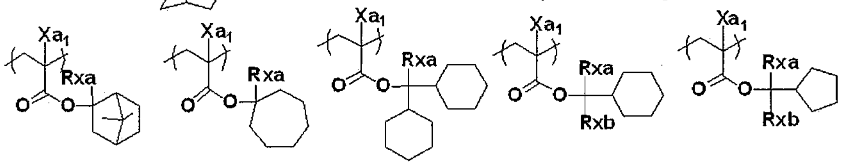

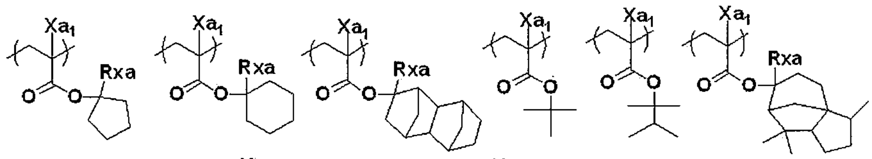

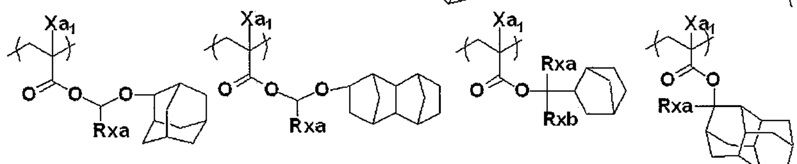

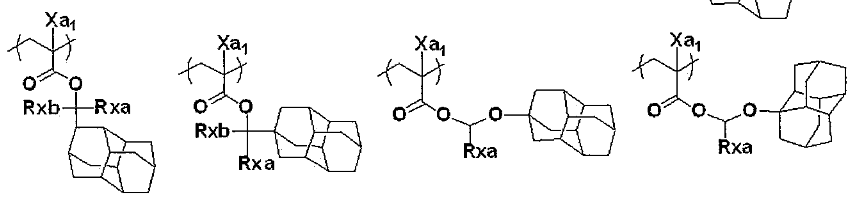

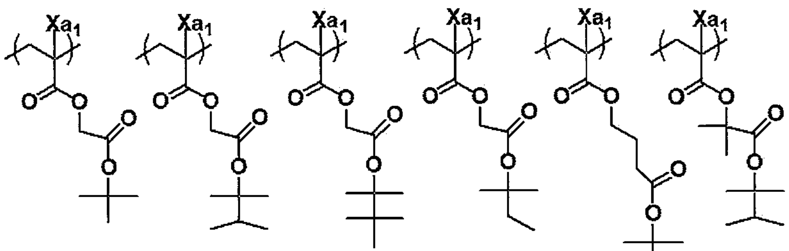

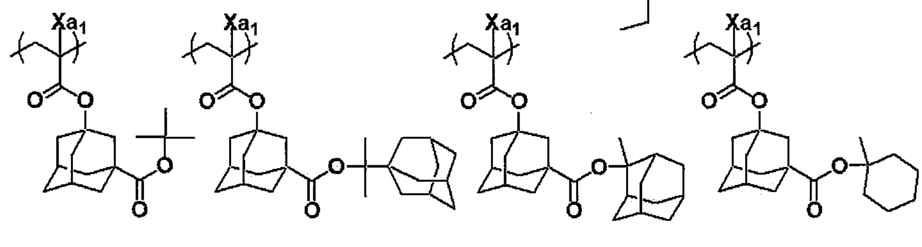

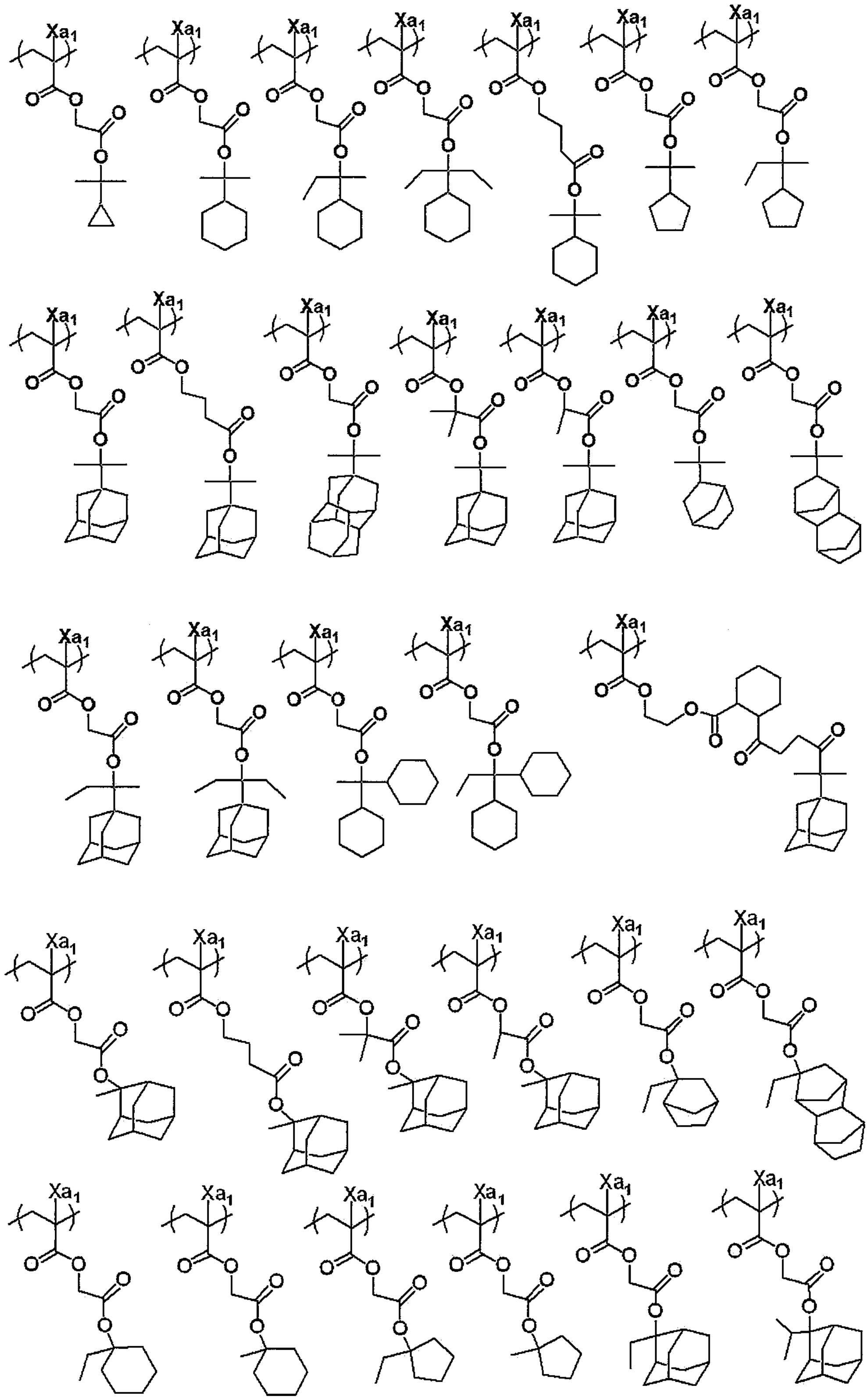

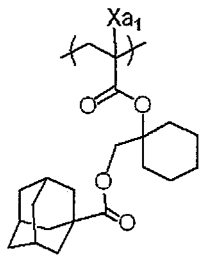

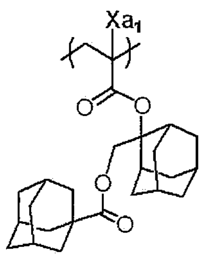

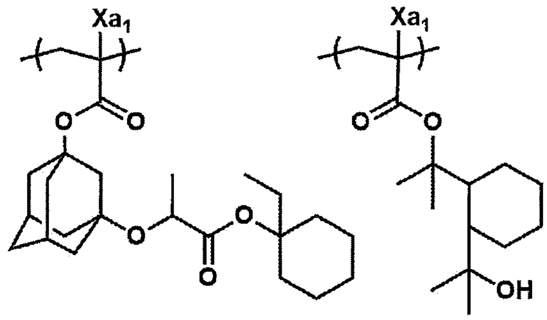

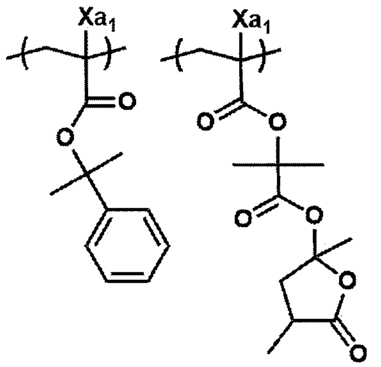

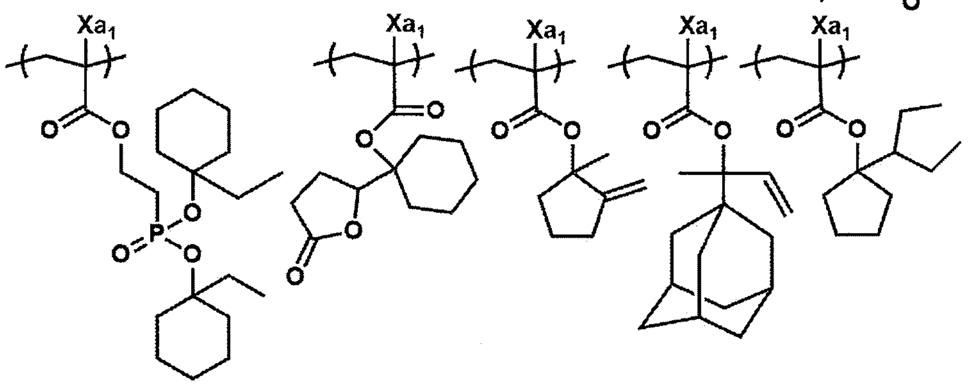

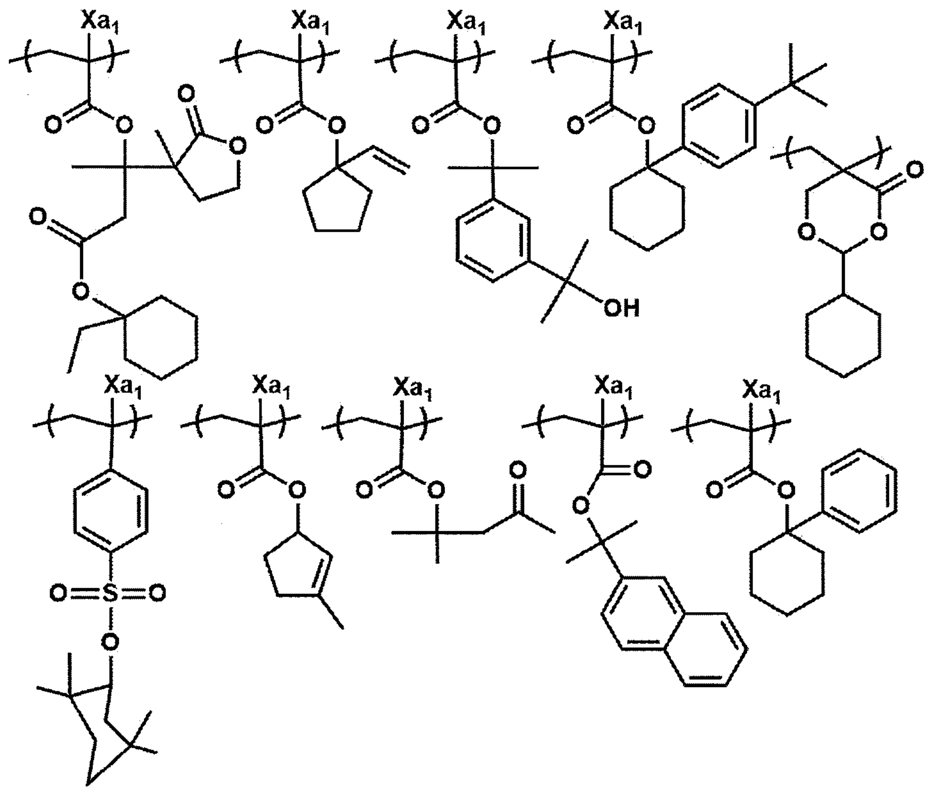

The resin (A) may include a repeating unit other than the above-described repeating units.

For example, the resin (A) may include at least one repeating unit selected from the group consisting of the following group A and/or at least one repeating unit selected from the group consisting of the following group B.

Group A: A group consisting of the following repeating units (20) to (29).

(20) A repeating unit having an acid group, which will be described later.
(21) A repeating unit having a fluorine atom or an iodine atom, which will be described later.
(22) A repeating unit having a lactone group, a sultone group, or a carbonate group, which will be described later.
(23) A repeating unit having a photoacid generating group, which will be described later.
(24) A repeating Unit represented by General Formula (V-1) or General Formula (V-2), which will be described later.
(25) A repeating unit represented by Formula (A), which will be described later.
(26) A repeating unit represented by Formula (B), which will be described later.
(27) A repeating unit represented by Formula (C), which will be described later.
(28) A repeating unit represented by Formula (D), which will be described later.
(29) A repeating unit represented by Formula (E), which will be described later.

Group B: A group consisting of the following repeating units (30) to (32).

(30) A repeating unit having at least one group selected from a lactone group, a sultone group, a carbonate group, a hydroxyl group, a cyano group, and an alkali-soluble group, which will be described later.
(31) A repeating unit having an alicyclic hydrocarbon structure and not exhibiting acid decomposability described later.
(32) A repeating unit represented by General Formula (III) having neither a hydroxyl group nor a cyano group, which will be described later.

In a case where the resist composition is used for EUV exposure or electron beam exposure, it is preferable that the resin (A) has at least one repeating unit selected from the group consisting of the group A.

Further, in a case where the resist composition is used for EUV exposure or electron beam exposure, it is also preferable that the resin (A) has at least one of a fluorine atom or an iodine atom. In a case where the resin (A) includes both a fluorine atom and an iodine atom, the resin (A) may have one repeating unit including both a fluorine atom and an iodine atom, and the resin (A) may include two kinds of repeating units, that is, a repeating unit having a fluorine atom and a repeating unit having an iodine atom.

Further, in the case where the resist composition is used for EUV exposure or electron beam exposure, it is also preferable that the resin (A) has a repeating unit containing an aromatic group.

In a case where the resist composition is used for ArF exposure, it is preferable that the resin (A) has at least one repeating unit selected from the group consisting of the group B.

Further, in the case where the resist composition is used for ArF exposure, it is preferable that the resin (A) does not have any of a fluorine atom or a silicon atom.

Further, in a case where the composition is used for ArF applications, it is preferable that the resin (A) does not contain an aromatic group.

«Repeating unit containing acid group»

The resin (A) may have a repeating unit having an acid group.

As the acid group, an acid group having a pKa of 13 or less is preferable.

As the acid group, for example, a carboxyl group, a phenolic hydroxyl group, a fluorinated alcohol group (preferably a hexafluoroisopropanol group), a sulfonic acid group, a sulfonamide group, or an isopropanol group is preferable.

In addition, in the hexafluoroisopropanol group, one or more (preferably one or two) fluorine atoms may be substituted with a group (an alkoxycarbonyl group and the like) other than a fluorine atom.

$-C(CF_3)(OH)-CF_2-$ formed as above is also preferable as the acid group. In addition, one or more fluorine atoms may be substituted with a group other than a fluorine atom to form a ring including $-C(CF_3)(OH)-CF_2-$.

The repeating unit having an acid group is preferably a repeating unit different from a repeating unit having the structure in which a polar group is protected by the leaving group that leaves due to the action of an acid as described above, and a repeating unit having a lactone group, a sultone group, or a carbonate group which will be described later.

The repeating unit having an acid group may have a fluorine atom or an iodine atom.

As the repeating unit having an acid group, a repeating unit represented by Formula (B) is preferable.

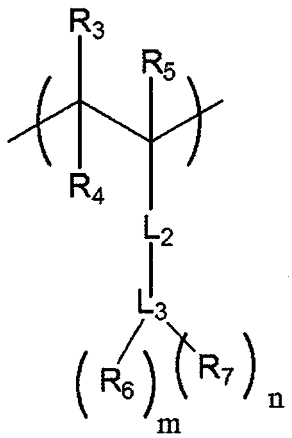

(B)

$R_3$ represents a hydrogen atom or a monovalent organic group which may have a fluorine atom or an iodine atom.

As the monovalent organic group which may have a fluorine atom or an iodine atom, a group represented by $-L_4-R_8$ is preferable. $L_4$ represents a single bond or an ester group. $R_8$ is an alkyl group which may have a fluorine atom or an iodine atom, a cycloalkyl group which may have a fluorine atom or an iodine atom, an aryl group which may have a fluorine atom or an iodine atom, or a group formed by combination thereof.

$R_4$ and $R_5$ each independently represent a hydrogen atom, a fluorine atom, an iodine atom, or an alkyl group which may have a fluorine atom or an iodine atom.

$L_2$ represents a single bond or an ester group.

L3 represents an (n + m + 1)-valent aromatic hydrocarbon ring group or an (n + m + 1)-valent alicyclic hydrocarbon ring group. Examples of the aromatic hydrocarbon ring group include a benzene ring group and a naphthalene ring group. The alicyclic hydrocarbon ring group may be either a monocycle or a polycycle, and examples thereof include a cycloalkyl ring group.

$R_6$ represents a hydroxyl group or a fluorinated alcohol group (preferably a hexafluoroisopropanol group). Further, in a case where $R_6$ is a hydroxyl group, $L_3$ is preferably the (n + m + 1)-valent aromatic hydrocarbon ring group.

$R_7$ represents a halogen atom. Examples of the halogen atom include a fluorine atom, a chlorine atom, a bromine atom, and an iodine atom.

m represents an integer of 1 or greater. m is preferably an integer of 1 to 3 and more preferably an integer of 1 or 2.

n represents 0 or an integer of 1 or greater. n is preferably an integer of 1 to 4.

Furthermore, (n + m + 1) is preferably an integer of 1 to 5.

As the repeating unit having an acid group, a repeating unit represented by General Formula (I) is also preferable.

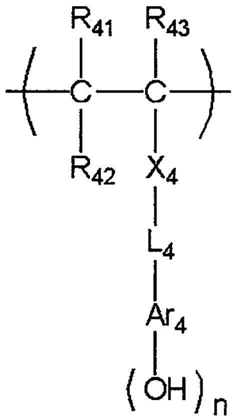

(I)

In General Formula (I), $R_{41}$, $R_{42}$, and $R_{43}$ each independently represent a hydrogen atom, an alkyl group, a cycloalkyl group, a halogen atom, a cyano group, or an alkoxycarbonyl group. Here, $R_{42}$ may be bonded to $Ar_4$ to form a ring, and in this case, $R_{42}$ represents a single bond or an alkylene group.

$X_4$ represents a single bond, -COO-, or -CONR$_{64}$-, and $R_{64}$ represents a hydrogen atom or an alkyl group.
L4 represents a single bond or an alkylene group.
$Ar_4$ represents an (n+1)-valent aromatic ring group, and in a case where $Ar_4$ is bonded to $R_{42}$ to form a ring, $Ar_4$ represents an (n+2)-valent aromatic ring group.
n represents an integer of 1 to 5.

As the alkyl group represented by each of $R_{41}$, $R_{42}$, and $R_{43}$ in General Formula (I), an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group is preferable, an alkyl group having 8 or less carbon atoms is more preferable, and an alkyl group having 3 or less carbon atoms is still more preferable.

The cycloalkyl group as $R_{41}$, $R_{42}$, and $R_{43}$ in General Formula (I) may be monocyclic or polycyclic. Among these, a monocyclic cycloalkyl group having 3 to 8 carbon atoms, such as a cyclopropyl group, a cyclopentyl group, and a cyclohexyl group, is preferable.

Examples of the halogen atom as $R_{41}$, $R_{42}$, and $R_{43}$ in General Formula (I) include a fluorine atom, a chlorine atom, a bromine atom, and an iodine atom, and the fluorine atom is preferable. As the alkyl group included in the alkoxycarbonyl group as $R_{41}$, $R_{42}$, and $R_{43}$ in General Formula (I), those exemplified as the alkyl group as $R_{41}$, $R_{42}$, and $R_{43}$ are preferable.

Preferred examples of the substituent in each of the groups include an alkyl group, a cycloalkyl group, an aryl group, an amino group, an amide group, a ureide group, a urethane group, a hydroxyl group, a carboxyl group, a halogen atom, an alkoxy group, a thioether group, an acyl group, an acyloxy group, an alkoxycarbonyl group, a cyano group, and a nitro group. The substituent has preferably 8 or less carbon atoms.

$Ar_4$ represents an (n+1)-valent aromatic ring group. The divalent aromatic ring group in a case where n is 1 is preferably, for example, an arylene group having 6 to 18 carbon atoms, such as a phenylene group, a tolylene group, a naphthylene group, and an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, and a thiazole ring. Furthermore, the aromatic ring group may have a substituent.

Specific examples of the (n + 1)-valent aromatic ring group in a case where n is an integer of 2 or greater include groups formed by removing any (n - 1) hydrogen atoms from the above-described specific examples of the divalent aromatic ring group.

The (n + 1)-valent aromatic ring group may further have a substituent.

Examples of the substituent which can be contained in the alkyl group, the cycloalkyl group, the alkoxycarbonyl group, the alkylene group, and the (n + 1)-valent aromatic ring group, each mentioned above, include the alkyl groups; the alkoxy groups such as a methoxy group, an ethoxy group, a hydroxyethoxy group, a propoxy group, a hydroxypropoxy group, and a butoxy group; the aryl groups such as a phenyl group; and the like, as mentioned for each of $R_{41}$, $R_{42}$, and $R_{43}$ in General Formula (I).

Examples of the alkyl group of $R_{64}$ in $-CONR_{64}-$ represented by $X_4$ ($R_{64}$ represents a hydrogen atom or an alkyl group) include an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group, and an alkyl group having 8 or less carbon atoms, is preferable.

As $X_4$, a single bond, -COO-, or -CONH- is preferable, and the single bond or -COO-is more preferable.

As the alkylene group in $L_4$, an alkylene group having 1 to 8 carbon atoms, such as a methylene group, an ethylene group, a propylene group, a butylene group, a hexylene group, and an octylene group, is preferable.

As $Ar_4$, an aromatic ring group having 6 to 18 carbon atoms is preferable, and a benzene ring group, a naphthalene ring group, and a biphenylene ring group are more preferable.

The repeating unit represented by General Formula (I) preferably comprises a hydroxystyrene structure. That is, $Ar_4$ is preferably a benzene ring group.

The repeating unit represented by General Formula (I) is preferably a repeating unit represented by General Formula (1).

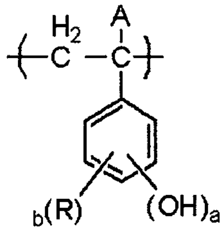

(1)

In General Formula (1), A represents a hydrogen atom, an alkyl group, a cycloalkyl group, a halogen atom, or a cyano group.

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, and in a case where a plurality of R's are present, R's may be the same as or different from each other. In a case where a plurality of R's are present, R's may be combined with each other to form a ring. As R, the hydrogen atom is preferable.
a represents an integer of 1 to 3.
b represents an integer of 0 to (5-a).

Here, it is preferable that the resin contained in the resist composition has a hydroxystyrene-based repeating unit.

Examples of the hydroxystyrene-based repeating unit include a repeating unit in which A represents a hydrogen atom in General Formula (1).

Examples of the repeating unit containing an acid group are shown below. In the formula, a represents 1 or 2.

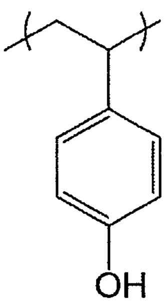

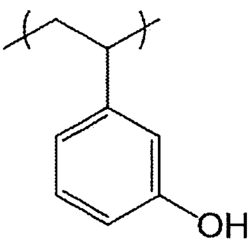

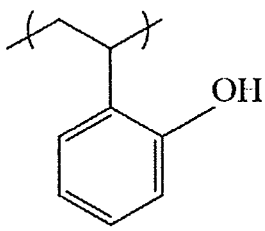

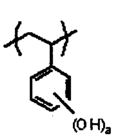

(B - 1)

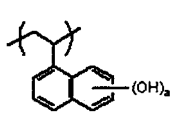

(B - 2)

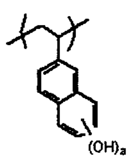

(B-3)

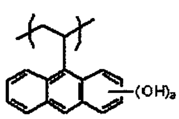

(B-4)

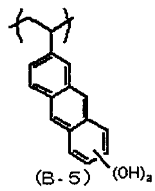

(B-5)

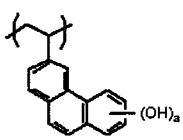
(B-6)

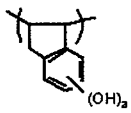
(B-7)

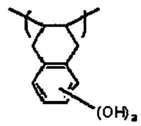
(B-8)

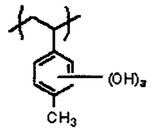
(B-9)

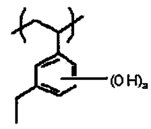
(B-10)

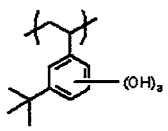
(B-11)

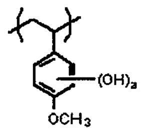
(B-12)

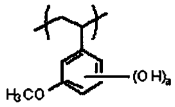
(B-13)

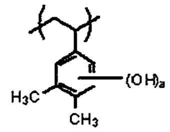
(B-14)

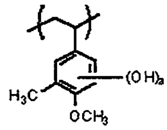
(B-15)

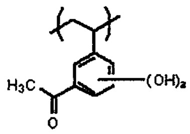
(B-16)

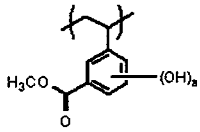
(B-17)

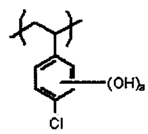
(B-18)

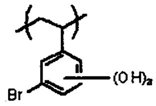
(B-19)

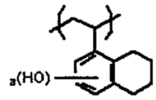
(B-20)

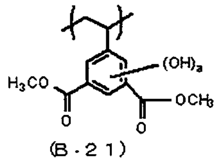
(B-21)

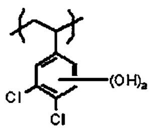
(B-22)

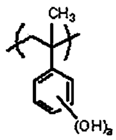
(B-23)

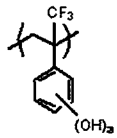
(B-24)

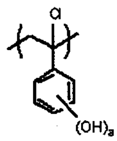
(B-25)

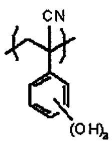
(B-26)

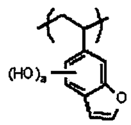
(B-27)

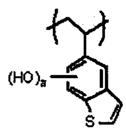
(B-28)

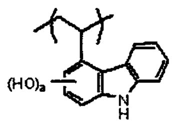
(B-29)

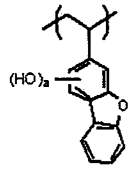
(B-30)

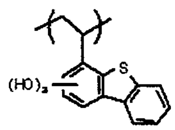
(B-31)

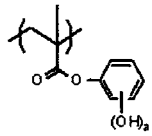
(B-32)

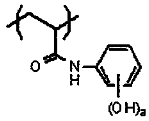
(B-33)

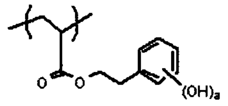
(B-34)

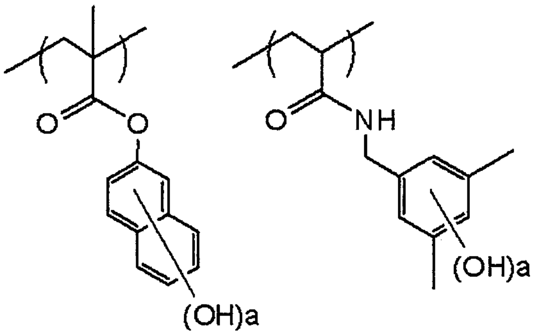

(B-35) (B-36)

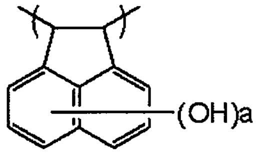

(B-37)

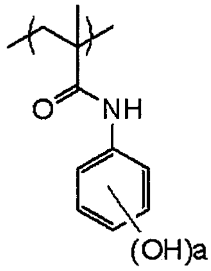

(B-38)

Moreover, among the repeating units, the repeating units specifically described below are preferable. In the formula, R represents a hydrogen atom or a methyl group, and a represents 2 or 3.

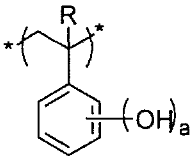

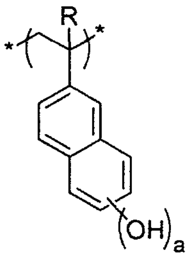

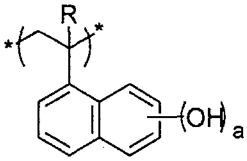

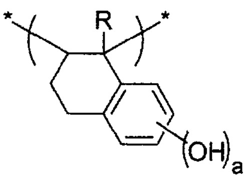

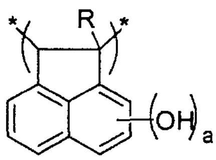

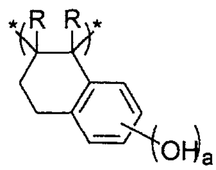

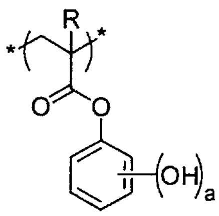

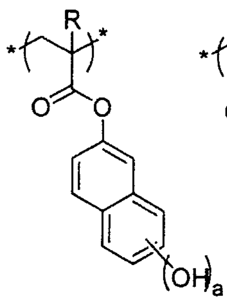

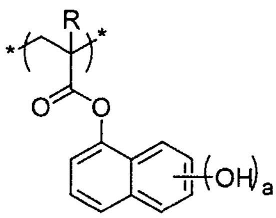

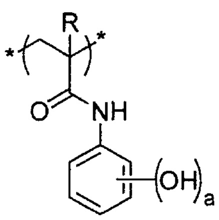

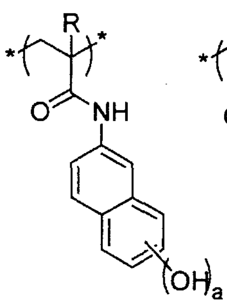

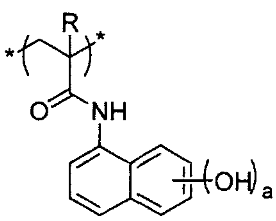

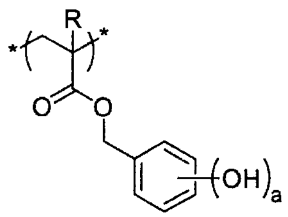

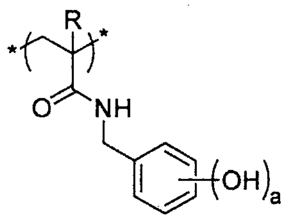

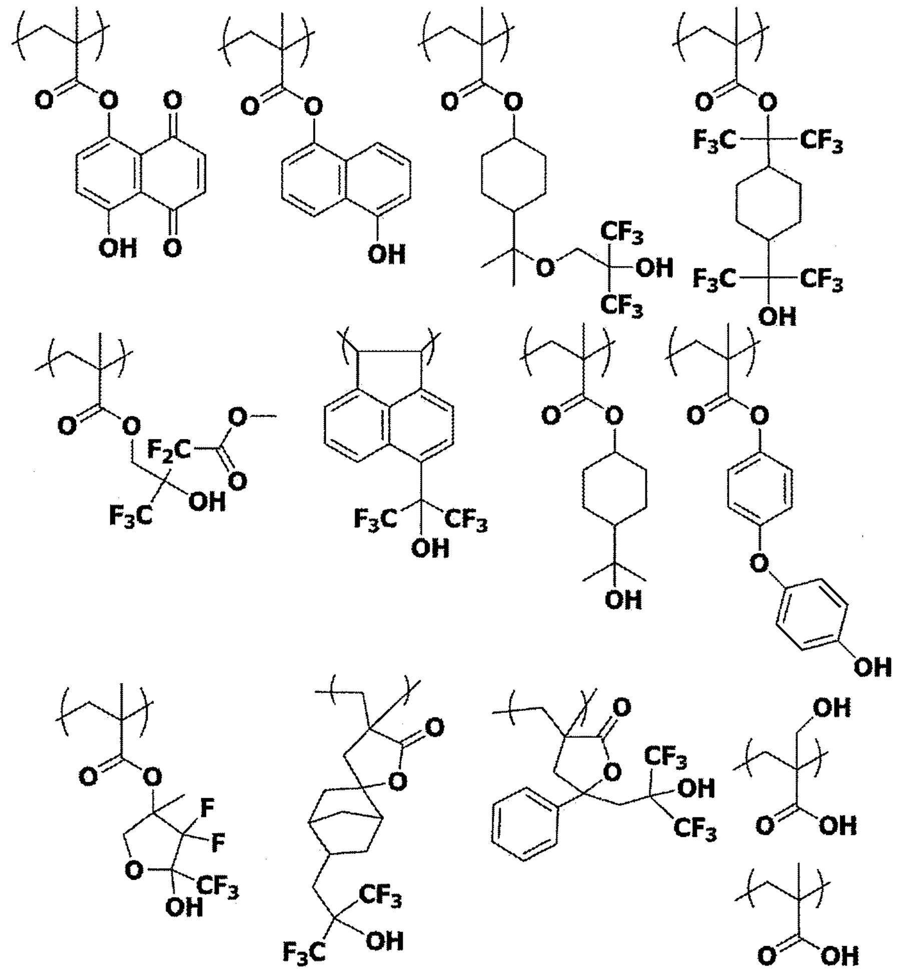

The content of the repeating unit containing an acid group (preferably a hydroxystyrene-based repeating unit) is preferably 5% by mole or greater and more preferably 10% by mole or greater with respect to all repeating units in the resin (A). In addition, the upper limit thereof is not particularly limited, but is preferably 50% by mole or less, more preferably 45% by mole or less, and still more preferably 40% by mole or less.

«Repeating unit having fluorine atom or iodine atom»

The resin (A) may have a repeating unit having a fluorine atom or an iodine atom, in addition to the repeating units described in the sections of «Repeating unit having acid-decomposable group» and «Repeating unit having acid group» above. Further, it is preferable that the repeating unit in «Repeating unit having fluorine atom or iodine atom» described here is different from other repeating units belonging to the group A, such as the repeating units described in the sections of «Repeating unit having lactone group, sultone group, or carbonate group» and «Repeating unit having photoacid generating group» described below.

As the repeating unit having a fluorine atom or an iodine atom, a repeating unit represented by Formula (C) is preferable.

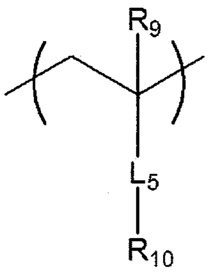

(C)

$L_5$ represents a single bond or an ester group.

$R_9$ represents a hydrogen atom or an alkyl group which may have a fluorine atom or an iodine atom.

$R_{10}$ represents a hydrogen atom, an alkyl group which may have a fluorine atom or an iodine atom, a cycloalkyl group which may have a fluorine atom or an iodine atom, an aryl group which may have a fluorine atom or an iodine atom, or a group formed by combination thereof.

The repeating unit having a fluorine atom or an iodine atom will be exemplified below.

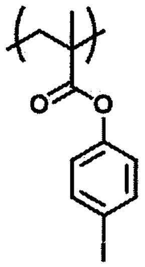
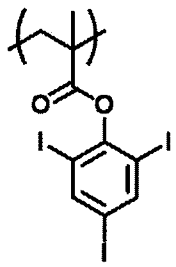
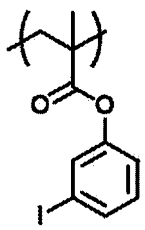
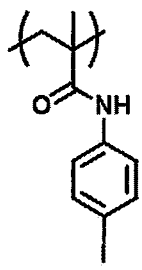
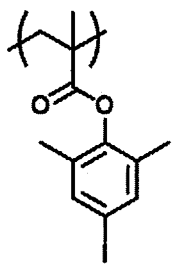
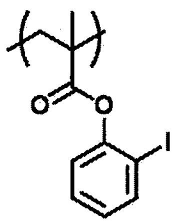

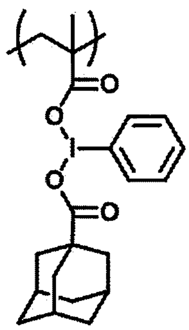
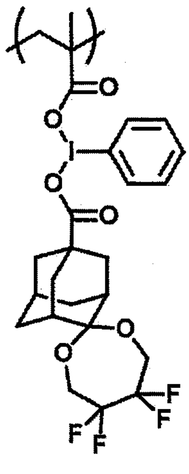
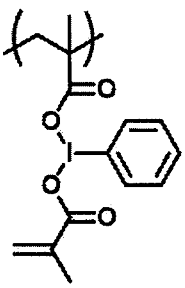

The content of the repeating unit having a fluorine atom or an iodine atom is preferably 0% by mole or greater, more preferably 5% by mole or greater, and still more preferably 10% by mole or greater with respect to all the repeating units in the resin (A). In addition, an upper limit thereof is preferably 50% by mole or less, more preferably 45% by mole or less, and still more preferably 40% by mole or less.

Further, since the repeating unit having a fluorine atom or an iodine atom does not include the repeating units described in the sections of «Repeating unit having acid-decomposable group» and «Repeating unit having acid group» as described above, the content of the repeating unit having a fluorine atom or an iodine atom also denotes the content of the repeating unit having a fluorine atom or an iodine atom, excluding the repeating units described in the sections of «Repeating unit having acid-decomposable group» and «Repeating unit having acid group».

The total content of the repeating units including at least one of a fluorine atom or an iodine atom in the repeating units of the resin (A) is preferably 20% by mole or greater, more preferably 30% by mole or greater, and still more preferably 40% by mole or greater with respect to all the repeating units of the resin (A). An upper limit thereof is not particularly limited, but is, for example, 100% by mole or less.

In addition, examples of the repeating unit having at least one of a fluorine atom or an iodine atom include a

repeating unit having a fluorine atom or an iodine atom and containing an acid-decomposable group, a repeating unit having a fluorine atom or an iodine atom and containing an acid group, and a repeating unit having a fluorine atom or an iodine atom.

«Repeating unit having lactone group, sultone group, or carbonate group»

The resin (A) may have a repeating unit having at least one selected from the group consisting of a lactone group, a sultone group, and a carbonate group (hereinafter also collectively referred to as a "repeating unit having a lactone group, a sultone group, or a carbonate group").

It is also preferable that the repeating unit having a lactone group, a sultone group, or a carbonate group has no acid group such as a hexafluoropropanol group.

The lactone group or the sultone group may have a lactone structure or a sultone structure. The lactone structure or the sultone structure is preferably a 5- to 7-membered ring lactone structure or a 5- to 7-membered ring sultone structure. Among these, the structure is more preferably a 5- to 7-membered ring lactone structure with which another ring structure is fused so as to form a bicyclo structure or a spiro structure or a 5- to 7-membered ring sultone structure with which another ring structure is fused so as to form a bicyclo structure or a spiro structure.

The resin (A) preferably has a repeating unit having a lactone group or a sultone group, formed by extracting one or more hydrogen atoms from a ring member atom of a lactone structure represented by any of General Formulae (LC1-1) to (LC1-21) or a sultone structure represented by any of General Formulae (SL1-1) to (SL1-3).

In addition, the lactone group or the sultone group may be bonded directly to the main chain. For example, a ring member atom of the lactone group or the sultone group may constitute the main chain of the resin (A).

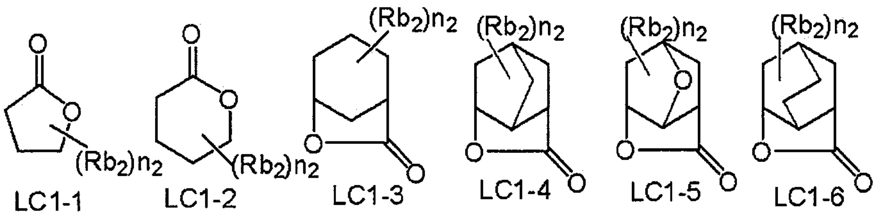

LC1-1 LC1-2 LC1-3 LC1-4 LC1-5 LC1-6

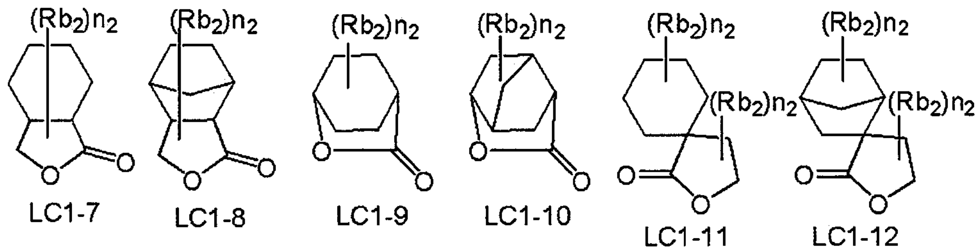

LC1-7 LC1-8 LC1-9 LC1-10 LC1-11 LC1-12

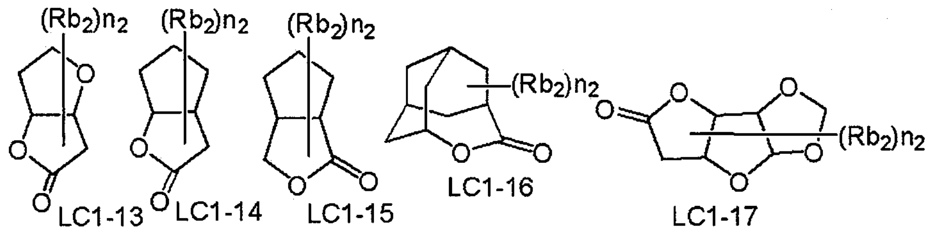

LC1-13 LC1-14 LC1-15 LC1-16 LC1-17

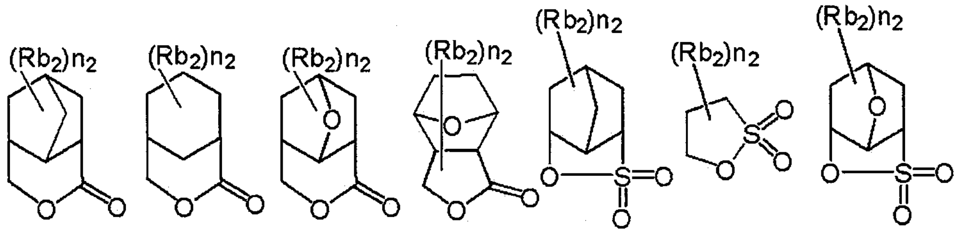

LC1-18 LC1-19 LC1-20 LC1-21 SL1-1 SL1-2 SL1-3

The moiety of the lactone structure or the sultone structure may have a substituent (Rb2). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, a cyano group, and an acid-decomposable group. n2 represents an integer of 0 to 4. In a case where n2 represents 2 or greater, a plurality of $Rb_2$'s may be different from each other and the plurality of $Rb_2$'s may be bonded to each other to form a ring.

Examples of the repeating unit containing a group having the lactone structure represented by any of General Formulae (LC1-1) to (LC1-21) or the sultone structure represented by any of General Formulae (SL1-1) to (SL1-3) include a repeating unit represented by General Formula (AI).

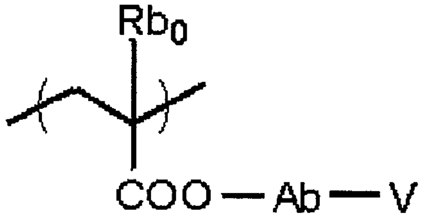

(AI)

In General Formula (AI), $Rb_0$ represents a hydrogen atom, a halogen atom, or an alkyl group having 1 to 4 carbon atoms.

Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. $Rb_0$ is preferably the hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent group formed by combination thereof. Among these, the single bond or a linking group represented by $-Ab_1-CO_2-$ is preferable. Abi is a linear or branched chain alkylene group, or a monocyclic or polycyclic cycloalkylene group, and is preferably a methylene group, an ethylene group, a cyclohexylene group, an adamantylene group, or a norbornylene group.

V represents a group formed by extracting one hydrogen atom from a ring member atom of the lactone structure represented by any of General Formulae (LC1-1) to (LC1-21) or a group formed by extracting one hydrogen atom from a ring member atom of the sultone structure represented by any of General Formulae (SL1-1) to (SL1-3).

In a case where an optical isomer is present in the repeating unit containing a lactone group or a sultone group, any optical isomer may be used. In addition, one optical isomer may be used alone or a mixture of a plurality of the optical isomers may be used. In a case where one kind of optical isomers is mainly used, an optical purity (ee) thereof is preferably 90 or greater, and more preferably 95 or greater.

As the carbonate group, a cyclic carbonic acid ester group is preferable.

As the repeating unit having a cyclic carbonic acid ester group, a repeating unit represented by General Formula (A-1) is preferable.

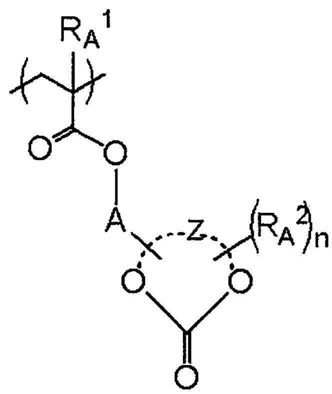

(A-1)

In General Formula (A-1), $R_A{}^1$ represents a hydrogen atom, a halogen atom, or a monovalent organic group (preferably a methyl group).

n represents an integer of 0 or greater.

$R_A{}^2$ represents a substituent. In a case where n is 2 or greater, a plurality of $R_A{}^2$'s may be the same as or different from each other.

A represents a single bond or a divalent linking group. As the divalent linking group, an alkylene group, a divalent linking group having a monocyclic or polycyclic alicyclic hydrocarbon structure, an ether group, an ester group, a carbonyl group, a carboxyl group, or a divalent group formed by combination thereof is preferable.

Z represents an atomic group that forms a monocycle or polycycle with a group represented by -O-CO-O- in the formula.

The repeating unit having a lactone group, a sultone group, or a carbonate group will be exemplified below.

(In the formulae, Rx represents H, $CH_3$, $CH_2OH$, or $CF_3$)

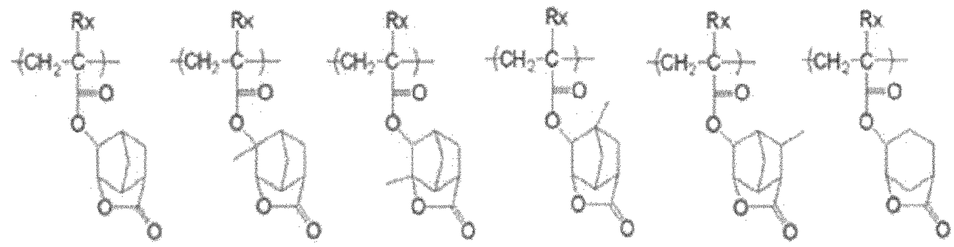

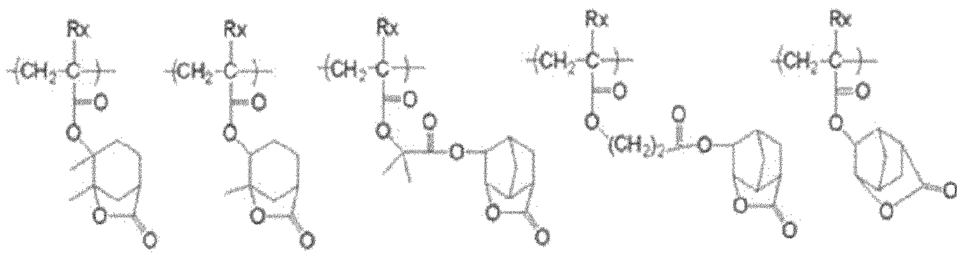

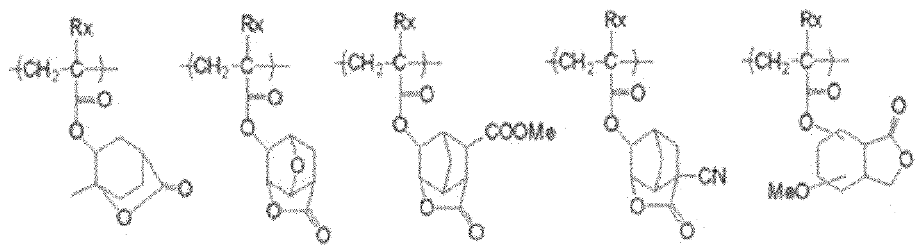

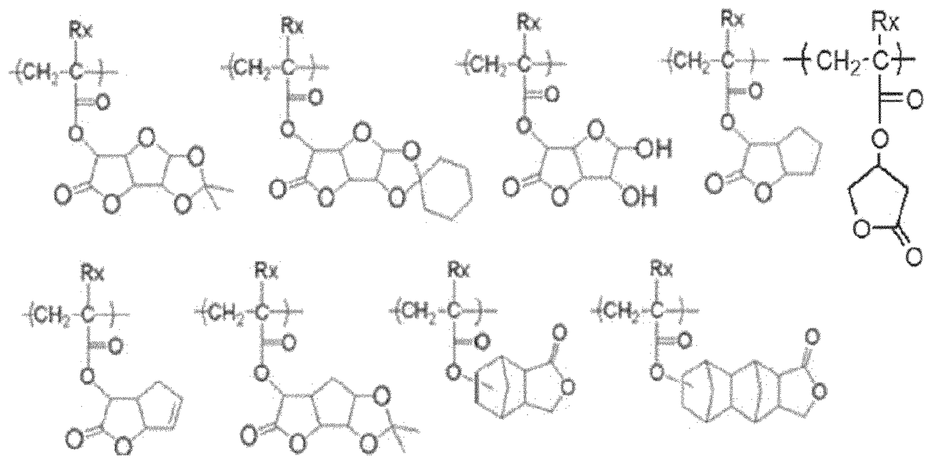

(In the formulae, Rx represents H, $CH_3$, $CH_2OH$, or $CF_3$)

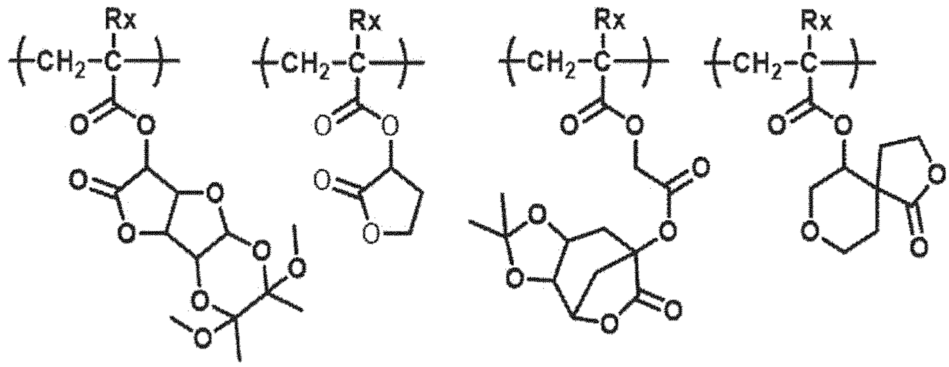

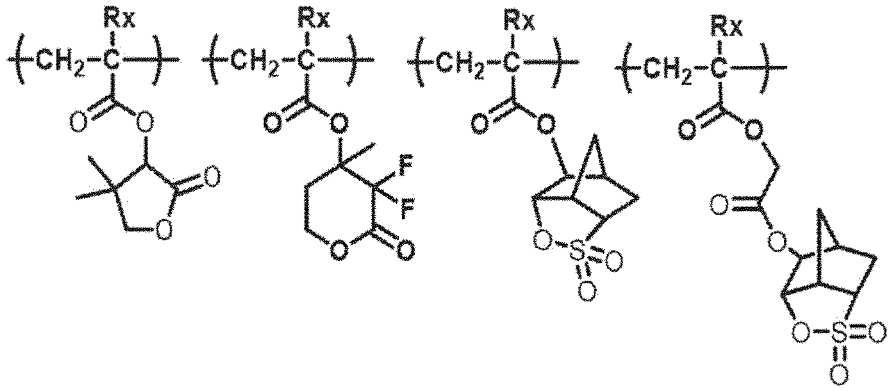

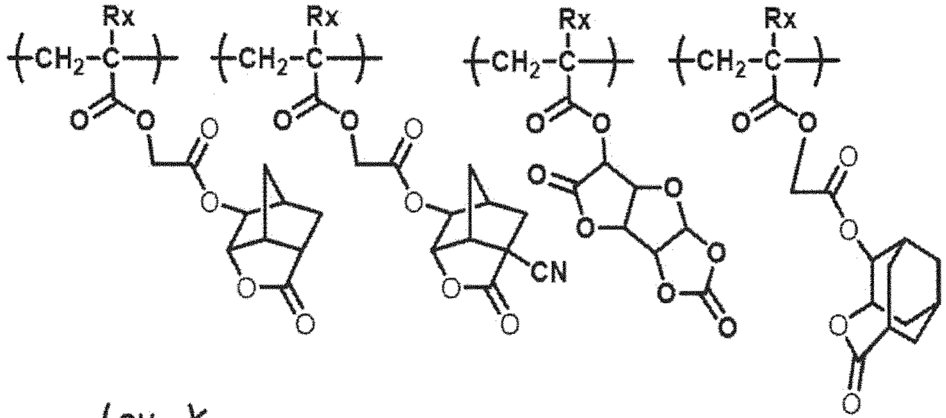

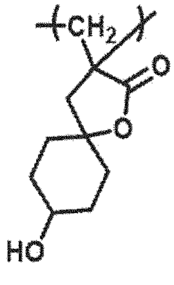

(In the formulae, Rx represents H, $CH_3$, $CH_2OH$, or $CF_3$)

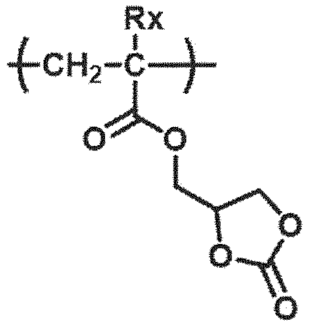

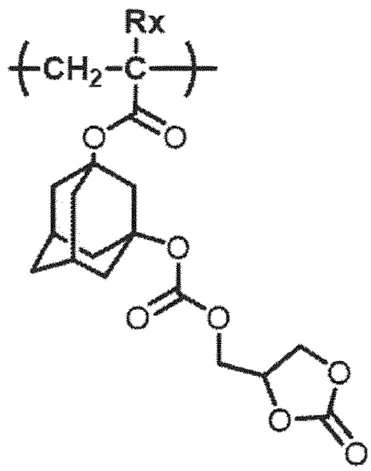

The content of the repeating unit containing a lactone group, a sultone group, or a carbonate group is preferably 1% by mole or greater and more preferably 5% by mole or greater with respect to all repeating units in the resin (A). In addition, the upper limit thereof is not particularly limited, but is preferably 65% by mole or less, more preferably 30% by mole or less, still more preferably 25% by mole or less, and particularly preferably 20% by mole or less.

«Repeating unit having photoacid generating group»

The resin (A) may have, as a repeating unit other than those above, a repeating unit containing a group that generates an acid upon irradiation with actinic rays or radiation (hereinafter also referred to as a "photoacid generating group").

In this case, it can be considered that the repeating unit having a photoacid generating group corresponds to a compound that generates an acid upon irradiation with actinic rays or radiation which will be described later (also referred to as a "photoacid generator").

Examples of such the repeating unit include a repeating unit represented by General Formula (4).

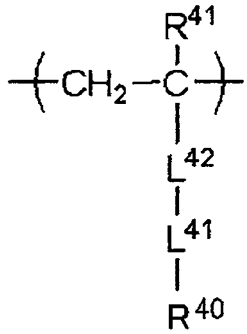

(4)

$R^{41}$ represents a hydrogen atom or a methyl group. $L^{41}$ represents a single bond or a divalent linking group. $L^{42}$ represents a divalent linking group. $R^{40}$ represents a structural site that is decomposed upon irradiation with actinic rays or radiation and generates an acid in a side chain.

The repeating unit having a photoacid generating group is exemplified below.

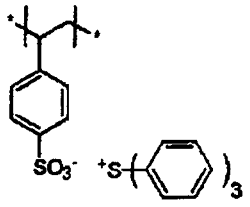

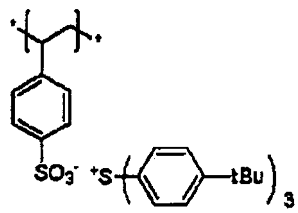

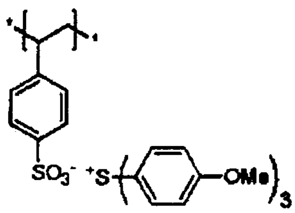

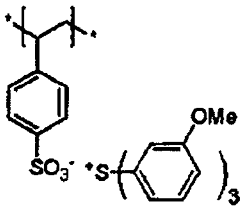

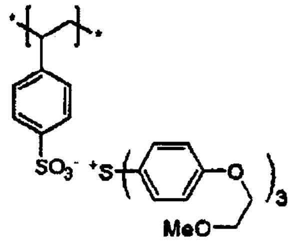

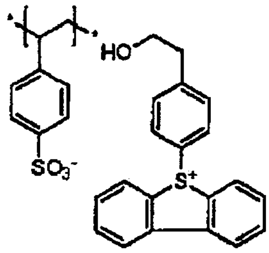

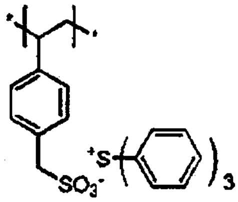

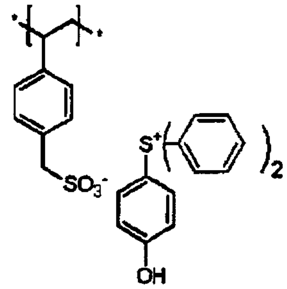

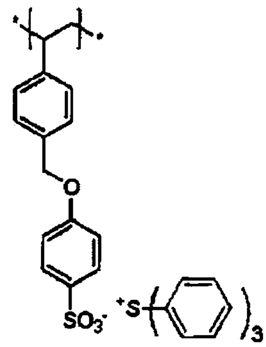

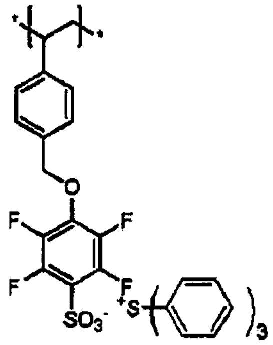

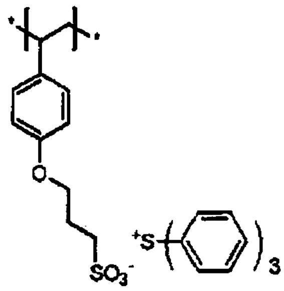

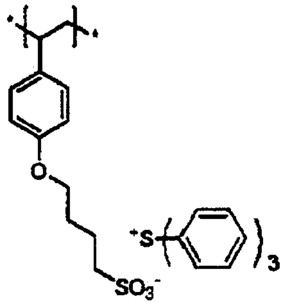

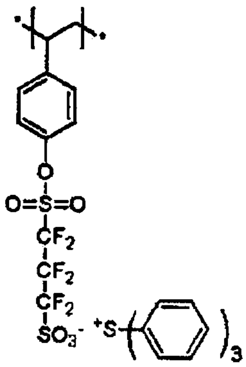

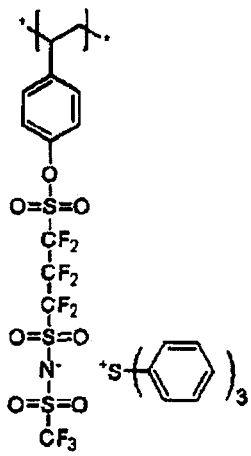

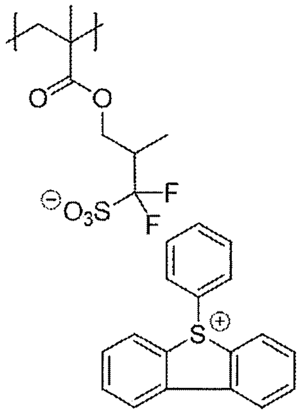

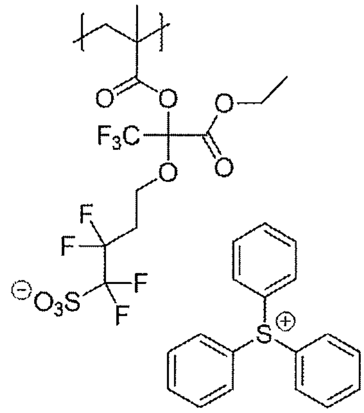

In addition, examples of the repeating unit represented by General Formula (4) include the repeating units described in paragraphs [0094] to [0105] of JP2014-041327A.

The content of the repeating unit having a photoacid generating group is preferably 1% by mole or greater, and more preferably 5% by mole or greater with respect to all the repeating units in the resin (A). In addition, the upper limit thereof is preferably 40% by mole or less, more preferably 35% by mole or less, and still more preferably 30% by mole or less.

«Repeating unit represented by General Formula (V-1) or General Formula (V-2)»

The resin (A) may have a repeating unit represented by General Formula (V-1) or General Formula (V-2).

The repeating unit represented by General Formula (V-1) and General Formula (V-2) is preferably a repeating unit different from the above-described repeating units.

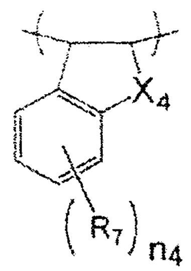

(V-1)

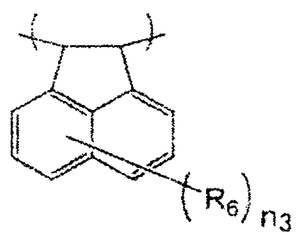

(V-2)

In the formula, $R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR: R is an alkyl group or fluorinated alkyl group having 1 to 6 carbon atoms), or a carboxyl group. As the alkyl group, a linear, branched chain, or cyclic alkyl group having 1 to 10 carbon atoms is preferable.

$n_3$ represents an integer of 0 to 6.
$n_4$ represents an integer of 0 to 4.
$X^4$ represents a methylene group, an oxygen atom, or a sulfur atom.

The repeating unit represented by General Formula (V-1) or (V-2) will be exemplified below.

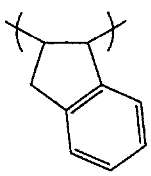 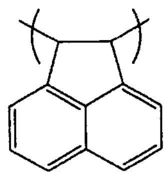 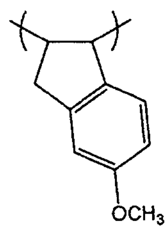 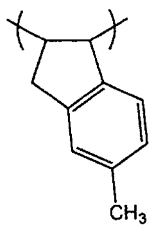 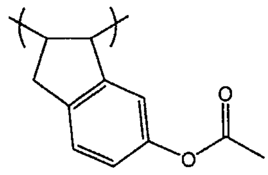

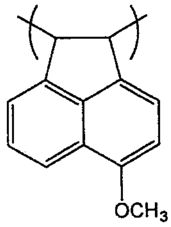 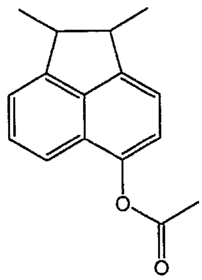 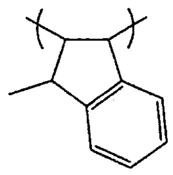

«Repeating unit for reducing mobility of main chain»

The resin (A) preferably has a high glass transition temperature (Tg) from the viewpoint that excessive diffusion of an acid generated or pattern collapse during development can be suppressed. The Tg is preferably higher than 90°C, more preferably higher than 100°C, still more preferably higher than 110°C, and particularly preferably higher than 125°C. Further, since an excessively high Tg causes a decrease in a dissolution rate in a developer, the Tg is preferably 400°C or lower, and more preferably 350°C or lower.

Furthermore, in the present specification, the glass transition temperature (Tg) of a polymer such as the resin (A) is calculated by the following method. First, each Tg of homopolymers consisting of only the respective repeating units included in the polymer is calculated by the Bicerano method. Hereinafter, the Tg calculated is referred to as a "Tg of the repeating unit. Next, the mass proportion (%) of each repeating unit to all the repeating units in the polymer is calculated. Next, the Tg at each mass ratio is calculated using a Fox's equation (described in Materials Letters 62 (2008) 3152, and the like), and these are summed to obtain the Tg (°C) of the polymer.

The Bicerano method is described in Prediction of polymer properties, Marcel Dekker Inc., New York (1993), and the like. The calculation of the Tg by the Bicerano method can be carried out using MDL Polymer (MDL Information Systems, Inc.), which is software for estimating physical properties of a polymer.

From the viewpoint of increasing the Tg of the resin (A) (preferably to raise the Tg to higher than 90°C), it is preferable to reduce the mobility of the main chain of the resin (A). Examples of a method of lowering the mobility of the main chain of the resin (A) include the following (a) to (e) methods.

(a) Introduction of a bulky substituent into the main chain.
(b) Introduction of a plurality of substituents into the main chain.
(c) Introduction of a substituent causing an interaction between the resins (A) into the vicinity of the main chain.
(d) Formation of the main chain in a cyclic structure.
(e) Linking of a cyclic structure to the main chain

Furthermore, the resin (A) preferably has a repeating unit in which the homopolymer exhibits a Tg of 130°C or higher.

In addition, the type of the repeating unit in which the homopolymer exhibits a Tg of 130°C or higher is not particularly limited, and may be any of repeating units in which the homopolymer exhibits a Tg of 130°C or higher, as calculated by a Bicerano method. Further, it corresponds to a repeating unit having a Tg of a homopolymer exhibiting 130°C or higher, depending on the type of a functional group in the repeating units represented by Formulae (A) to (E) which will be described later.

(Repeating unit represented by Formula (A))

As an example of a specific unit for accomplishing (a) above, a method of introducing a repeating unit represented by Formula (A) into the resin (A) may be mentioned.

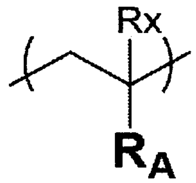

(A)

In Formula (A), $R_A$ represents a group having a polycyclic structure. $R_x$ represents a hydrogen atom, a methyl group, or an ethyl group. The group having a polycyclic structure is a group having a plurality of ring structures, and the plurality of ring structures may or may not be fused.

Specific examples of the repeating unit represented by Formula (A) include the following repeating units.

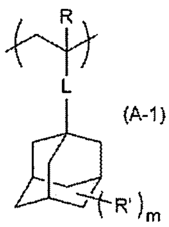

(A-1)

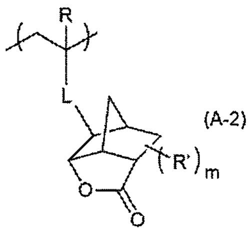

(A-2)

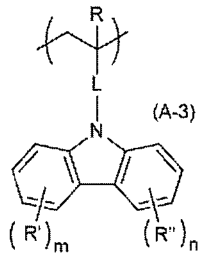

(A-3)

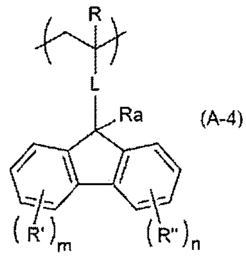

(A-4)

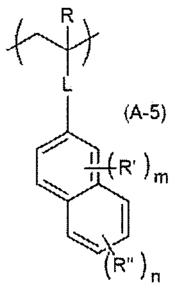

(A-5)

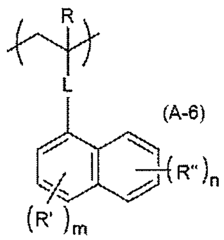

(A-6)

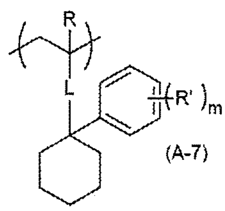

(A-7)

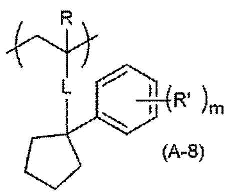

(A-8)

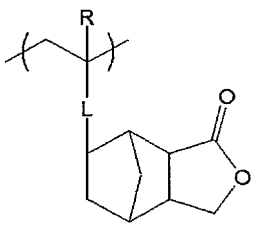

(A-9)

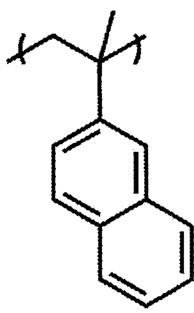

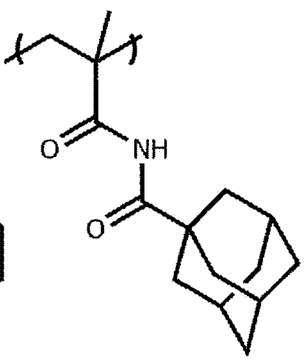

In the formulae, R represents a hydrogen atom, a methyl group, or an ethyl group.

Ra represents a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen

atom, an ester group (-OCOR‴ or -COOR‴: R‴ is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the group represented by Ra may be substituted with a fluorine atom or an iodine atom.

Moreover, R' and R" each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR‴ or -COOR‴: R‴ is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, a hydrogen atom bonded to the carbon atom in the groups represented by each of R' and R" may be substituted with a fluorine atom or an iodine atom.

L represents a single bond or a divalent linking group. Examples of the divalent linking group include -COO-, -CO-, -O-, -S-, -SO-, $-SO_2-$, an alkylene group, a cycloalkylene group, an alkenylene group, and a linking group in which a plurality of these groups are linked.

m and n each independently represent an integer of 0 or greater. The upper limit of each of m and n is not particularly limited, but is 2 or less in many cases, and 1 or less in more cases.

(Repeating unit represented by Formula (B))

As an example of a specific unit for accomplishing (b) above, a method of introducing a repeating unit represented by Formula (B) into the resin (A) may be mentioned.

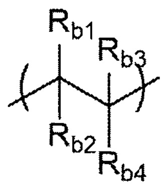
(B)

In Formula (B), $R_{b1}$ to $R_{b4}$ each independently represent a hydrogen atom or an organic group, and at least two or more of $R_{b1}$,., or $R_{b4}$ represent an organic group.

Furthermore, in a case where at least one of the organic groups is a group in which a ring structure is directly linked to the main chain in the repeating unit, the types of the other organic groups are not particularly limited.

In addition, in a case where none of the organic groups is a group in which a ring structure is directly linked to the main chain in the repeating unit, at least two or more of the organic groups are substituents having three or more constituent atoms excluding hydrogen atoms.

Specific examples of the repeating unit represented by Formula (B) include the following repeating units.

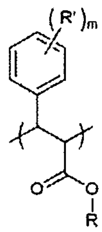
(B-1)
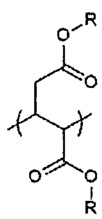
(B-2)
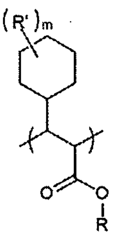
(B-3)
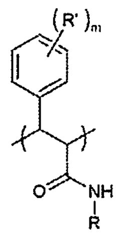
(B-4)

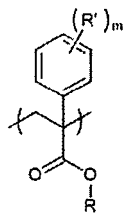
(B-5)
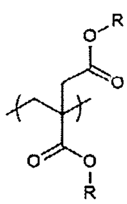
(B-6)

In the formula, R's each independently represent a hydrogen atom or an organic group. Examples of the organic group include an organic group such as an alkyl group, a cycloalkyl group, an aryl group, an aralkyl group, and an alkenyl group, each of which may have a substituent.

R"s each independently represent an alkyl group, a cycloalkyl group, an aryl group, an aralkyl group, an alkenyl

group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. Incidentally, a hydrogen atom bonded to the carbon atom in the group represented by R' may be substituted with a fluorine atom or an iodine atom.

m represents of an integer of 0 or greater. The upper limit of m is not particularly limited, but is 2 or less in many cases, and 1 or less in more cases.

(Repeating unit represented by Formula (C))

As an example of a specific unit for accomplishing (c) above, a method of introducing a repeating unit represented by Formula (C) into the resin (A) may be mentioned.

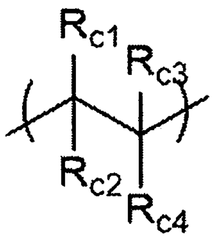 (C)

In Formula (C), $R_{c1}$ to $R_{c4}$ each independently represent a hydrogen atom or an organic group, and at least one of $R_{c1}$,., or $R_{c4}$ is a group having a hydrogen-bonding hydrogen atom with a number of atoms of 3 or less from the main chain carbon. Among these, it is preferable that the group has hydrogen-bonding hydrogen atoms with a number of atoms of 2 or less (on a side closer to the vicinity of the main chain) to induce an interaction between the main chains of the resin (A).

Specific examples of the repeating unit represented by Formula (C) include the following repeating units.

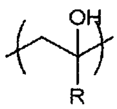 (C-1) 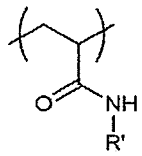 (C-2) 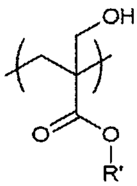 (C-3)

In the formula, R represents an organic group. The organic group may have a substituent, and examples thereof include an alkyl group, a cycloalkyl group, an aryl group, an aralkyl group, an alkenyl group, and an ester group (-OCOR or -COOR: R is an alkyl group or fluorinated alkyl group having 1 to 20 carbon atoms).

R' represents a hydrogen atom or an organic group. Examples of the organic group include an organic group such as an alkyl group, a cycloalkyl group, an aryl group, an aralkyl group, and an alkenyl group. In addition, a hydrogen atom in the organic group may be substituted with a fluorine atom or an iodine atom.

(Repeating unit represented by Formula (D))

As an example of a specific unit for accomplishing (d) above, a method of introducing a repeating unit represented by Formula (D) into the resin (A) may be mentioned.

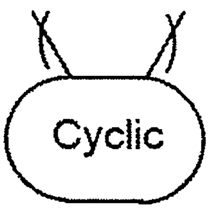 (D)

In Formula (D), "Cyclic" represents a group that forms a main chain with a cyclic structure. The number of the ring-constituting atoms is not particularly limited.

Specific examples of the repeating unit represented by Formula (D) include the following repeating units.

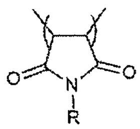 (D-1) 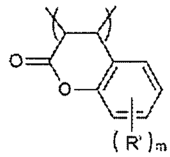 (D-2) 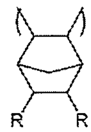 (D-3) 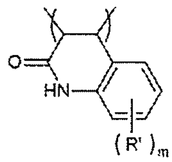 (D-4)

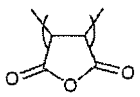 (D-5) 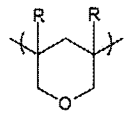 (D-6) 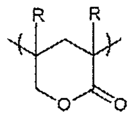 (D-7) 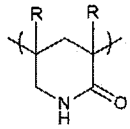 (D-8)

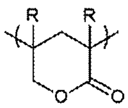 (D-9) 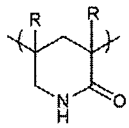 (D-10) 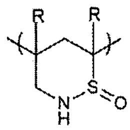 (D-11) 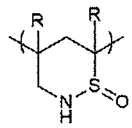 (D-12)

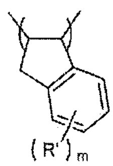 (D-13) 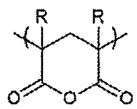 (D-14) 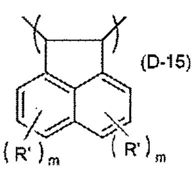 (D-15) 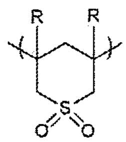 (D-16)

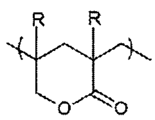 (D-17) 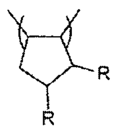 (D-18) 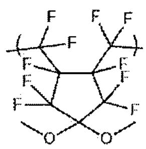 (D-19)

In the formula, R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, the hydrogen atom bonded to the carbon atom in the group represented by R may be substituted with a fluorine atom or an iodine atom.

In the formula, R"s each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. Incidentally, a hydrogen atom bonded to the carbon atom in the group represented by R' may be substituted with a fluorine atom or an iodine atom.

m represents of an integer of 0 or greater. The upper limit of m is not particularly limited, but is 2 or less in many cases, and 1 or less in more cases.

(Repeating unit represented by Formula (E))

As an example of a specific unit for accomplishing (e) above, a method of introducing a repeating unit represented by Formula (E) into the resin (A) may be mentioned.

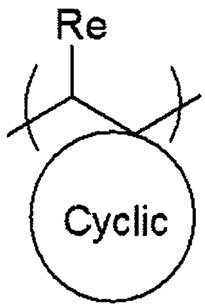

(E)

In Formula (E), Re's each independently represent a hydrogen atom or an organic group. Examples of the organic group include an alkyl group, a cycloalkyl group, an aryl group, an aralkyl group, and an alkenyl group, each of which may have a substituent.

"Cyclic" is a cyclic group including a carbon atom of the main chain. The number of the atoms included in the cyclic group is not particularly limited.

Specific examples of the repeating unit represented by Formula (E) include the following repeating units.

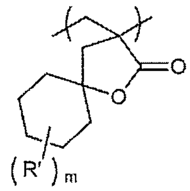
(E-1)
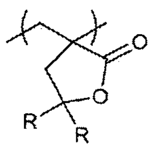
(E-2)
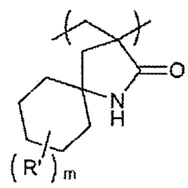
(E-3)
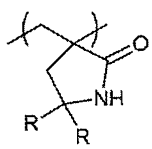
(E-4)

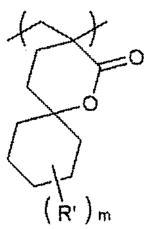
(E-5)
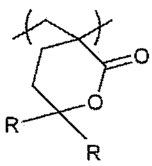
(E-6)
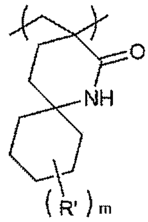
(E-7)
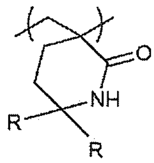
(E-8)

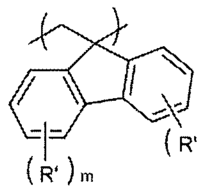
(E-9)
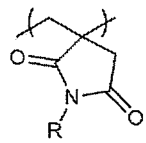
(E-10)
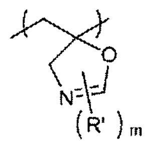
(E-11)
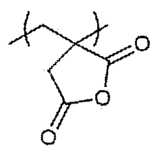
(E-12)

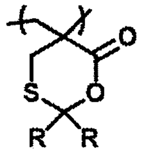
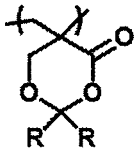
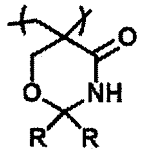

In the formulae, R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" is an alkyl group or fluorinated alkyl group having 1 to 20 carbon atoms), or a carboxyl group. Further, the alkyl group, the cycloalkyl group, the aryl group, the aralkyl group, and the alkenyl group may each have a substituent. In addition, the hydrogen atom bonded to the carbon atom in the group represented by R may be substituted with a fluorine atom or an iodine atom.

R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR": R" represents an alkyl group or fluorinated alkyl group

having 1 to 20 carbon atoms), or a carboxyl group. Further, the alkyl group, the cycloalkyl group, the aryl group, the aralkyl group, and the alkenyl group may each have a substituent. Incidentally, a hydrogen atom bonded to the carbon atom in the group represented by R' may be substituted with a fluorine atom or an iodine atom.

m represents of an integer of 0 or greater. The upper limit of m is not particularly limited, but is 2 or less in many cases, and 1 or less in more cases.

In addition, in Formula (E-2), Formula (E-4), Formula (E-6), and Formula (E-8), two R's may be bonded to each other to form a ring.

The content of the repeating unit represented by Formula (E) is preferably 5% by mole or greater, and more preferably 10% by mole or greater with respect to all the repeating units in the resin (A). In addition, the upper limit thereof is preferably 60% by mole or less and more preferably 55% by mole or less.

<<Repeating unit having at least one group selected from lactone group, sultone group, carbonate group, hydroxyl group, cyano group, and alkali-soluble group>

The resin (A) may have a repeating unit containing at least one group selected from a lactone group, a sultone group, a carbonate group, a hydroxyl group, a cyano group, and an alkali-soluble group.

Examples of the repeating unit containing a lactone group, a sultone group, or a carbonate group contained in the resin (A) include the repeating units described in the section of «Repeating unit containing lactone group, sultone group, or carbonate group» above. The preferred content thereof is also as described in the section of «Repeating unit containing lactone group, sultone group, or carbonate group» above.

The resin (A) may have a repeating unit having a hydroxyl group or a cyano group. As a result, the adhesiveness to a substrate and the affinity for a developer are improved.

The repeating unit having a hydroxyl group or a cyano group is preferably a repeating unit having an alicyclic hydrocarbon structure substituted with a hydroxyl group or a cyano group.

The repeating unit having a hydroxyl group or a cyano group preferably has no acid-decomposable group. Examples of the repeating unit having a hydroxyl group or a cyano group include repeating units represented by General Formulae (AIIa) to (AIId).

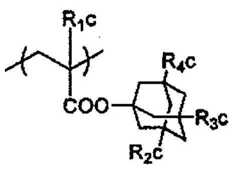
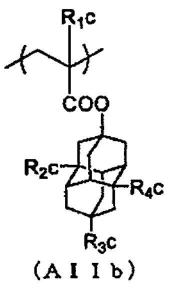
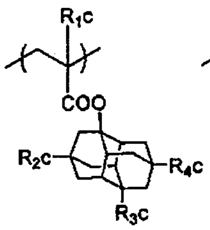
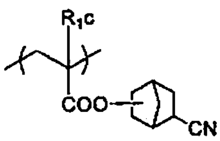

(A I I a) (A I I b) (A I I c) (A I I d)

In General Formulae (AIIa) to (AIId), $R_{1c}$ represents a hydrogen atom, a methyl group, a trifluoromethyl group, or a hydroxymethyl group.

$R_{2c}$ to $R_{4c}$ each independently represent a hydrogen atom, a hydroxyl group, or a cyano group. Here, at least one of $R_{2x}$, ..., or $R_{4c}$ represents a hydroxyl group or a cyano group. It is preferable that one or two of $R_{2c}$ to $R_{4c}$ are hydroxyl groups, and the rest are hydrogen atoms. It is more preferable that two of $R_{2c}$ to $R_{4c}$ are hydroxyl groups and the rest are hydrogen atoms.

The content of the repeating unit having a hydroxyl group or a cyano group is preferably 5% by mole or greater, and more preferably 10% by mole or greater with respect to all the repeating units in the resin (A). In addition, the upper limit thereof is preferably 40% by mole or less, more preferably 35% by mole or less, and still more preferably 30% by mole or less.

Specific examples of the repeating unit having a hydroxyl group or a cyano group are shown below, but the present invention is not limited thereto.

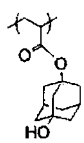
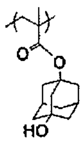
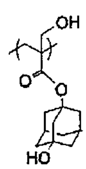
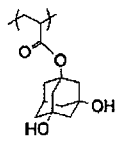
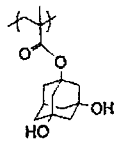
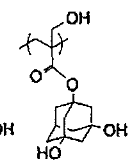

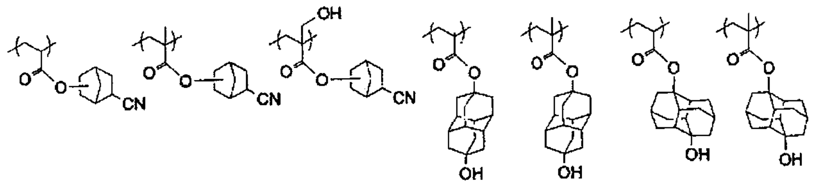

The resin (A) may have a repeating unit having an alkali-soluble group.

Examples of the alkali-soluble group include a carboxyl group, a sulfonamide group, a sulfonylimide group, a bissulfonylimide group, or an aliphatic alcohol (for example, a hexafluoroisopropanol group) in which the $\alpha$-position is substituted with an electron-withdrawing group, and the carboxyl group is preferable. In a case where the resin (A) includes a repeating unit having an alkali-soluble group, the resolution for use in contact holes is increased.

Examples of the repeating unit having an alkali-soluble group include a repeating unit in which an alkali-soluble group is directly bonded to the main chain of a resin such as a repeating unit with acrylic acid and methacrylic acid, or a repeating unit in which an alkali-soluble group is bonded to the main chain of the resin via a linking group. Further, the linking group may have a monocyclic or polycyclic cyclic hydrocarbon structure.

The repeating unit having an alkali-soluble group is preferably a repeating unit with acrylic acid or methacrylic acid.

The content of the repeating unit having an alkali-soluble group is preferably 0% by mole or greater, more preferably 3% by mole or greater, and still more preferably 5% by mole or greater with respect to all the repeating units in the resin (A). An upper limit thereof is preferably 20% by mole or less, more preferably 15% by mole or less, and still more preferably 10% by mole or less.

Specific examples of the repeating unit having an alkali-soluble group are shown below, but the present invention is not limited thereto. In the specific examples, Rx represents H, $CH_3$, $CH_2OH$, or $CF_3$.

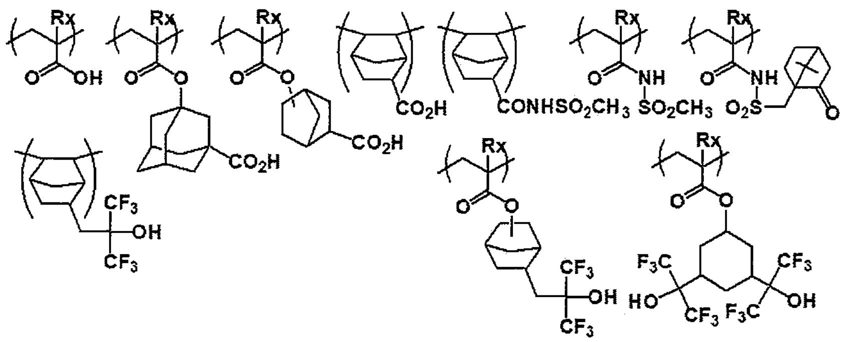

As the repeating unit having at least one group selected from a lactone group, a hydroxyl group, a cyano group, and an alkali-soluble group, a repeating unit having at least two selected from a lactone group, a hydroxyl group, a cyano group, and an alkali-soluble group is preferable, a repeating unit having a cyano group and a lactone group is more preferable, and a repeating unit having a structure in which a cyano group is substituted in the lactone structure represented by General Formula (LC1-4) is still more preferable.

«Repeating unit having alicyclic hydrocarbon structure and not exhibiting acid decomposability»

The resin (A) may have a repeating unit having an alicyclic hydrocarbon structure and not exhibiting acid decomposability. This can reduce the elution of low-molecular-weight components from the resist film into an immersion liquid during liquid immersion exposure. Examples of such the repeating unit include repeating units derived from 1-adamantyl (meth)acrylate, diamantyl (meth)acrylate, tricyclodecanyl (meth)acrylate, and cyclohexyl (meth)acrylate.

<<Repeating unit represented by General Formula (III) containing none of hydroxyl group or cyano group)

The resin (A) may have a repeating unit represented by General Formula (III), which contains none of a hydroxyl group or a cyano group.

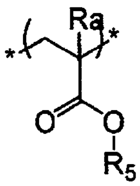
(III)

In General Formula (III), $R_5$ represents a hydrocarbon group having at least one cyclic structure and having neither a hydroxyl group nor a cyano group.

Ra represents a hydrogen atom, an alkyl group, or a $-CH_2-O-Ra_2$ group. In the formula, $Ra_2$ represents a hydrogen atom, an alkyl group, or an acyl group.

The cyclic structure contained in $R_5$ includes a monocyclic hydrocarbon group and a polycyclic hydrocarbon group. Examples of the monocyclic hydrocarbon group include a cycloalkyl group having 3 to 12 carbon atoms (more preferably 3 to 7 carbon atoms) or a cycloalkenyl group having 3 to 12 carbon atoms.

Examples of the polycyclic hydrocarbon group include a ring assembly hydrocarbon group and a crosslinked cyclic hydrocarbon group.

Examples of the crosslinked cyclic hydrocarbon ring include a bicyclic hydrocarbon ring, a tricyclic hydrocarbon ring, and a tetracyclic hydrocarbon ring. Further, examples of the crosslinked cyclic hydrocarbon ring also include a fused ring formed by fusing a plurality of 5- to 8-membered cycloalkane rings.

As the crosslinked cyclic hydrocarbon group, a norbornyl group, an adamantyl group, a bicyclooctanyl group, or a tricyclo[5,2,1,$0^{2,6}$]decanyl group is preferable, and the norbornyl group or the adamantyl group is more preferable.

The alicyclic hydrocarbon group may have a substituent, and examples of the substituent include a halogen atom, an alkyl group, a hydroxyl group protected by a protective group, and an amino group protected by a protective group.

The halogen atom is preferably a bromine atom, a chlorine atom, or a fluorine atom.

As the alkyl group, a methyl group, an ethyl group, a butyl group, or a t-butyl group is preferable.

The alkyl group may further have a substituent, and examples of the substituent include a halogen atom, an alkyl group, a hydroxyl group protected by a protective group, and an amino group protected by a protective group.

Examples of the protective group include an alkyl group, a cycloalkyl group, an aralkyl group, a substituted methyl group, a substituted ethyl group, an alkoxycarbonyl group, and an aralkyloxycarbonyl group.

As the alkyl group, an alkyl group having 1 to 4 carbon atoms is preferable.

As the substituted methyl group, a methoxymethyl group, a methoxythiomethyl group, a benzyloxymethyl group, a t-butoxymethyl group, or a 2-methoxyethoxymethyl group is preferable.

The substituted ethyl group is preferably a 1-ethoxyethyl group or a 1-methyl-1-methoxyethyl group.

As the acyl group, an aliphatic acyl group having 1 to 6 carbon atoms, such as a formyl group, an acetyl group, a propionyl group, a butyryl group, an isobutyryl group, a valeryl group, and a pivaloyl group, is preferable.

As the alkoxycarbonyl group, an alkoxycarbonyl group having 1 to 4 carbon atoms is preferable.

The content of the repeating unit represented by General Formula (III), which has neither a hydroxyl group nor a cyano group, is preferably 0% to 40% by mole, and more preferably 0% to 20% by mole with respect to all repeating units in the resin (A).

Specific examples of the repeating unit represented by General Formula (III) are shown below, but the present invention is not limited thereto. In the formulae, Ra represents H, $CH_3$, $CH_2OH$, or $CF_3$.

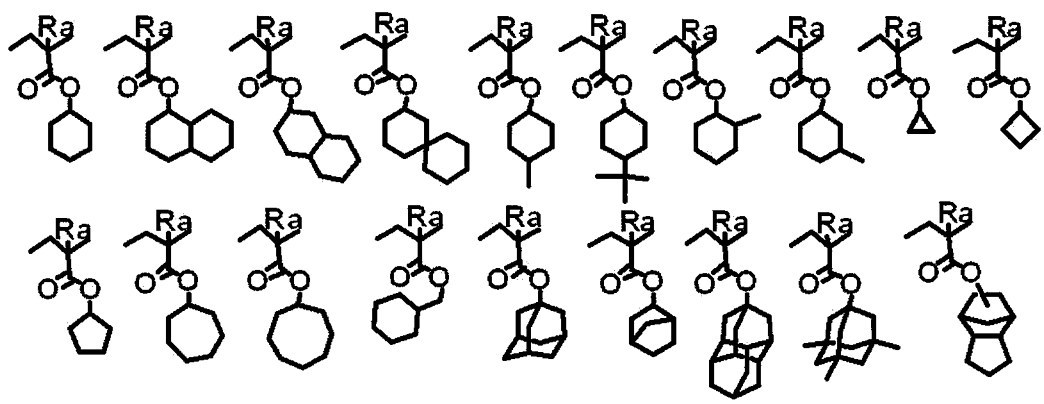

«Other repeating units»

The resin (A) may further have a repeating unit other than the above-described repeating units.

For example, the resin (A) may have a repeating unit selected from the group consisting of a repeating unit having an oxathiane ring group, a repeating unit having an oxazolone ring group, a repeating unit having a dioxane ring group, and a repeating unit having a hydantoin ring group.

Such repeating units will be exemplified below.

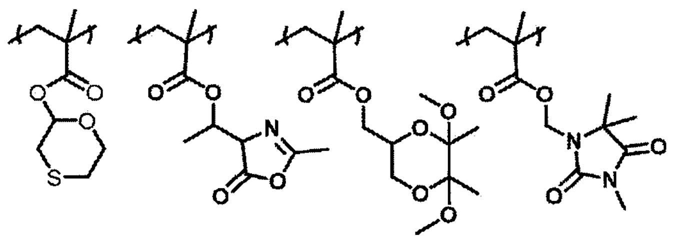

The resin (A) may have a variety of repeating structural units, in addition to the repeating structural units described above, for the purpose of adjusting dry etching resistance, suitability for a standard developer, adhesiveness to a substrate, a resist profile, resolving power, heat resistance, sensitivity, and the like.

As the resin (A), it is also preferable that all repeating units are formed of (meth)acrylate-based repeating units (particularly in a case where the composition is used for ArF applications). In this case, any of a resin in which all the repeating units are methacrylate-based repeating units, a resin in which all the repeating units are acrylate-based repeating units, or a resin in which all the repeating units are methacrylate-based repeating units and acrylate-based repeating units can be used, and it is preferable that the amount of the acrylate-based repeating units is 50% by mole or less with respect to all the repeating units.

The resin (A) can be synthesized in accordance with an ordinary method (for example, radical polymerization).

The weight-average molecular weight of the resin (A) as a value expressed in terms of polystyrene by a GPC method is preferably 1,000 to 200,000, more preferably 3,000 to 20,000, and still more preferably 5,000 to 15,000. By setting the weight-average molecular weight of the resin (A) to 1,000 to 200,000, deterioration of heat resistance and dry etching resistance can be further suppressed. In addition, deterioration of developability and deterioration of film forming property due to high viscosity can also be further suppressed.

The dispersity (molecular weight distribution) of the resin (A) is usually 1 to 5, preferably 1 to 3, more preferably 1.2 to 3.0, and still more preferably 1.2 to 2.0. The smaller the dispersity, the more excellent the resolution and the resist shape, and the smoother the side wall of the resist pattern, the more excellent the roughness.

The content of the resin (A) in the resist composition is preferably 50% to 99.9% by mass, and more preferably 60% to 99.0% by mass with respect to the total solid content of the composition.

Furthermore, the solid content is intended to be components obtained by removing solvents in the composition, and any of components other than the solvents are regarded as a solid content even in a case where the components are liquid components.

In addition, the resin (A) may be used singly or in combination of a plurality thereof.

<Compound that generates acid with actinic rays or radiation (photoacid generator)>

It is preferable that the chemically amplified resist composition contains a compound that generates an acid with actinic rays or radiation (hereinafter also referred to as "photoacid generator «PAG»").

The photoacid generator may be in a form of a low-molecular-weight compound or in a form of being incorporated into a part of a polymer. Further, a combination of the form of a low-molecular-weight compound and the form incorporated into a part of a polymer may also be used.

In a case where the photoacid generator (A) of the present invention is in the form of the low-molecular-weight compound, the molecular weight is preferably 3,000 or less, more preferably 2,000 or less, and still more preferably 1,000 or less.

In a case where the photoacid generator is in the form of being incorporated into a part of a polymer, it may be incorporated into a part of the resin (A) or into a resin different from the resin (A).

In the present invention, the photoacid generator is preferably a low-molecular-weight compound.

The photoacid generator is not particularly limited as long as a known photoacid generator is used, but a compound that generates an organic acid, for example, at least any of sulfonic acid, bis(alkylsulfonyl)imide, or tris(alkylsulfonyl)methide, upon irradiation with actinic rays or radiation and preferably with electron beams or extreme ultraviolet

rays is preferable.

More preferred examples of the photoacid generator include compounds represented by General Formulae (ZI), (ZII), and (ZIII).

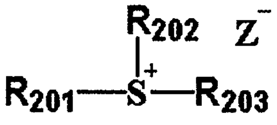
(ZI)

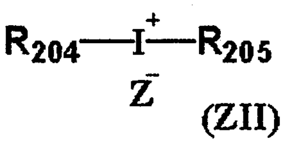
(ZII)

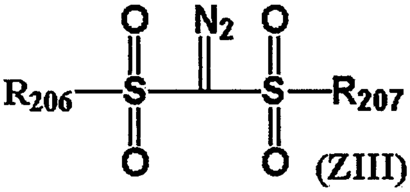
(ZIII)

In General Formula (ZI), $R_{201}$, $R_{202}$, and $R_{203}$ each independently represent an organic group.

The number of carbon atoms of the organic group as $R_{201}$, $R_{202}$, and $R_{203}$ is generally 1 to 30, and preferably 1 to 20.

In addition, two of $R_{201}$ to $R_{203}$ may be bonded to each other to form a ring structure, and the ring may include an oxygen atom, a sulfur atom, an ester bond, an amide bond, or a carbonyl group. Examples of the group formed by the bonding of two of $R_{201}$ to $R_{203}$ include an alkylene group (such as a butylene group or a pentylene group).

$Z^-$ represents a non-nucleophilic anion (anion having a remarkably low ability of causing a nucleophilic reaction).

Examples of the non-nucleophilic anion include a sulfonate anion (such as an aliphatic sulfonate anion, aromatic sulfonate anion, and a camphorsulfonate anion), a carboxylate anion (such as an aliphatic carboxylate anion, an aromatic carboxylate anion, and an aralkyl carboxylate anion), a sulfonylimide anion, a bis(alkylsulfonyl)imide anion, and a tris(alkylsulfonyl)methide anion.

The aliphatic moiety in the aliphatic sulfonate anion and the aliphatic carboxylate anion may be an alkyl group or a cycloalkyl group, and preferred examples thereof include a linear or branched chain alkyl group having 1 to 30 carbon atoms and a cycloalkyl group having 3 to 30 carbon atoms.

As the aromatic group in the aromatic sulfonate anion and the aromatic carboxylate anion, an aryl group having 6 to 14 carbon atoms is preferable, and examples thereof include a phenyl group, a tolyl group, and a naphthyl group.

The alkyl group, the cycloalkyl group, and the aryl group exemplified above may have a substituent. Specific examples of the substituent include a nitro group, a halogen atom such as fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), an aryloxysulfonyl group (preferably having 6 to 20 carbon atoms), an alkylaryloxysulfonyl group (preferably having 7 to 20 carbon atoms), a cycloalkylaryloxysulfonyl group (preferably having 10 to 20 carbon atoms), an alkyloxyalkyloxy group (preferably having 5 to 20 carbon atoms), and a cycloalkylalkyloxyalkyloxy group (preferably having 8 to 20 carbon atoms).

With regard to the aryl group and the ring structure contained in each group, other examples of the substituent include an alkyl group (preferably having 1 to 15 carbon atoms).

As the aralkyl group in the aralkylcarboxylate anion, an aralkyl group having 7 to 12 carbon atoms is preferable, and examples thereof include a benzyl group, a phenethyl group, a naphthylmethyl group, a naphthylethyl group, and a naphthylbutyl group.

Examples of the sulfonylimide anion include a saccharin anion.

As the alkyl group in the bis(alkylsulfonyl)imide anion and the tris(alkylsulfonyl)methide anion, an alkyl group having 1 to 5 carbon atoms is preferable. Examples of substituents of these alkyl groups include a halogen atom, an alkyl group substituted with a halogen atom, an alkoxy group, an alkylthio group, an alkyloxysulfonyl group, an aryloxysulfonyl group, and a cycloalkylaryloxysulfonyl group. Among these, a fluorine atom or an alkyl group substituted with a fluorine atom is preferable.

In addition, the alkyl groups in the bis(alkylsulfonyl)imide anion may be bonded to each other to form a ring structure. Thus, the acid strength is increased.

Examples of other non-nucleophilic anions include fluorinated phosphorus (for example, $PF_6^-$), fluorinated boron (for example, $BF_4^-$), and fluorinated antimony (for example, $SbF_6^-$).

As the non-nucleophilic anion, an aliphatic sulfonate anion in which at least an α-position of the sulfonic acid is substituted with a fluorine atom, an aromatic sulfonate anion substituted with a fluorine atom or a group having a fluorine atom, a bis(alkylsulfonyl)imide anion in which an alkyl group is substituted with a fluorine atom, or a tris(alkylsulfonyl)methide anion in which an alkyl group is substituted with a fluorine atom is preferable. As the non-nucleophilic

anion, a perfluoroaliphatic sulfonate anion (still more preferably having 4 to 8 carbon atoms) or a benzene sulfonate anion having a fluorine atom is more preferable, and a nonafluorobutane sulfonate anion, a perfluorooctane sulfonate anion, a pentafluorobenzene sulfonate anion, or a 3,5-bis(trifluoromethyl) benzene sulfonate anion is still more preferable.

From the viewpoint of the acid strength, it is preferable that the pKa of the acid generated is -1 or less to improve the sensitivity.

Moreover, an anion represented by General Formula (AN1) may also be mentioned as a preferred aspect of the non-nucleophilic anion.

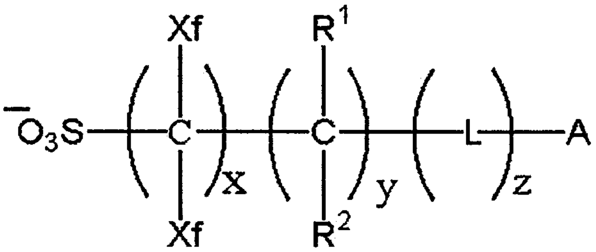

(AN1)

Xf's each independently represent a fluorine atom or an alkyl group substituted with at least one fluorine atom.

$R^1$ and $R^2$ each independently represent a hydrogen atom, a fluorine atom, or an alkyl group. In a case where a plurality of $R^1$'s and a plurality of $R^2$'s are present, $R^1$'s and $R^2$'s may be the same as or different from each other.
L represents a divalent linking group, and in a case where a plurality of L's are present, L's may be the same as or different from each other.
A represents a cyclic organic group.
x represents an integer of 1 to 20, y represent an integer of 0 to 10, and z represents an integer of 0 to 10.

General Formula (AN1) will be described in more detail.

The alkyl group with regard to the alkyl group substituted with the fluorine atom of Xf preferably has 1 to 10 carbon atoms, and more preferably has 1 to 4 carbon atoms. In addition, the alkyl group substituted with the fluorine atom of Xf is preferably a perfluoroalkyl group.

As Xf, a fluorine atom or a perfluoroalkyl group having 1 to 4 carbon atoms is preferable. Specific examples of Xf include a fluorine atom, $CF_3$, $C_2F_5$, $C_3F_7$, $C_4F_9$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$. Among these, a fluorine atom and $CF_3$ are preferable.

In particular, it is preferable that both Xf's are a fluorine atom.

The alkyl group as $R^1$ and $R^2$ may have a substituent (preferably a fluorine atom), and preferably has 1 to 4 carbon atoms. The alkyl group is more preferably a perfluoroalkyl group having 1 to 4 carbon atoms. Specific examples of the alkyl group having a substituent as $R^1$ and $R^2$ include $CF_3$, $C_2F_5$, $C_3F_7$, $C_4F_9$, $C_5F_{11}$, $C_6F_{13}$, $C_7F_{15}$, $C_8F_{17}$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$. Among these, $CF_3$ is preferable.

$R^1$ and $R^2$ represent each preferably a fluorine atom or $CF_3$.

x is preferably 1 to 10, and more preferably 1 to 5.

y is preferably 0 to 4, and more preferably 0.

z is preferably 0 to 5, and more preferably 0 to 3.

The divalent linking group as L is not particularly limited, and examples thereof include -COO-, -OCO-, -CO-, -O-, -S-, -SO-, $-SO_2-$, an alkylene group, a cycloalkylene group, an alkenylene group, and a linking group to which a plurality of these groups are linked, and a linking group having a total of 12 or less carbon atoms is preferable. Among these, -COO-, -OCO-, -CO-, or -O- is preferable, and -COO- or -OCO- is more preferable.

In General Formula (AN1), preferred examples of a combination of partial structures other than A include $SO^{3-}-CF_2-CH_2-OCO-$, $SO^{3-}-CF_2-CHF-CH_2-OCO-$, $SO^{3-}-CF_2-COO-$, $SO^{3-}-CF_2-CF_2-CH_2-$, and $SO^{3-}-CF_2-CH(CF_3)-OCO-$.

The cyclic organic group as A is not particularly limited as long as the cyclic organic group has a cyclic structure, and examples thereof include an alicyclic group, an aryl group, and a heterocyclic group (also including a group having aromaticity as well as a group having no aromaticity).

The alicyclic group may be either a monocycle or a polycycle, and a monocyclic cycloalkyl group such as a cyclopentyl group, a cyclohexyl group, and a cyclooctyl group, or a polycyclic cycloalkyl group such as a norbornyl group, a tricyclodecanyl group, a tetracyclodecanyl group, a tetracyclododecanyl group, and an adamantyl group is preferable. Among these, from the viewpoint of suppressing in-membrane diffusion in the post-exposure bake step and improving the mask error enhancement factor (MEEF), an alicyclic group with a bulky structure having 7 or more carbon atoms,

such as a norbornyl group, a tricyclodecanyl group, a tetracyclodecanyl group, a tetracyclododecanyl group, or an adamantyl group, is preferable.

Examples of the aryl group include a benzene ring, a naphthalene ring, a phenanthrene ring, and an anthracene ring.

Examples of the heterocyclic group include those derived from a furan ring, a thiophene ring, a benzofuran ring, a benzothiophene ring, a dibenzofuran ring, a dibenzothiophene ring, or a pyridine ring. Among these, a furan ring, a thiophene ring, or a group derived from a pyridine ring is preferable.

Moreover, examples of the cyclic organic group also include a lactone structure, and specific examples thereof include lactone structures represented by General Formulae (LC1-1) to (LC1-17).

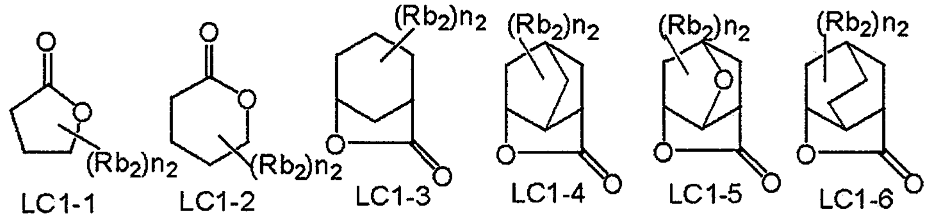
LC1-1 LC1-2 LC1-3 LC1-4 LC1-5 LC1-6

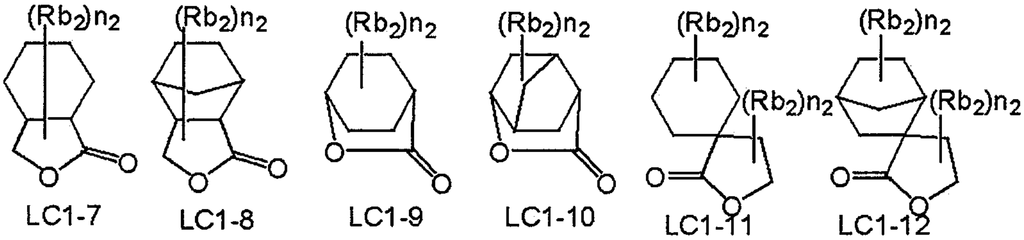
LC1-7 LC1-8 LC1-9 LC1-10 LC1-11 LC1-12

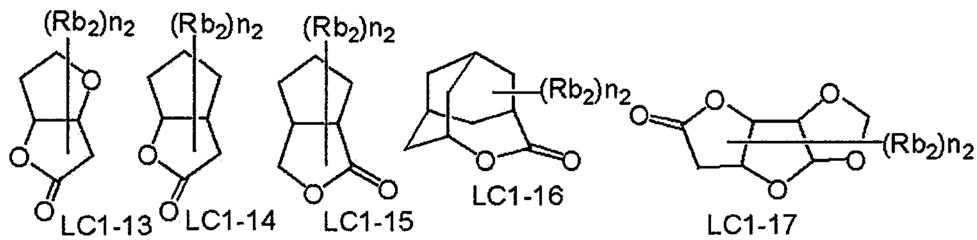
LC1-13 LC1-14 LC1-15 LC1-16 LC1-17

The cyclic organic group may have a substituent, and examples of the substituent include an alkyl group (any of linear, branched chain, or cyclic and preferably having 1 to 12 carbon atoms), a cycloalkyl group (any of a monocycle, a polycycle, or a spiro ring and preferably having 3 to 20 carbon atoms), an aryl group (preferably having 6 to 14 carbon atoms), a hydroxy group, an alkoxy group, an ester group, an amide group, a urethane group, a ureido group, a thioether group, a sulfonamide group, and a sulfonic acid ester group. Incidentally, the carbon constituting the cyclic organic group (carbon contributing to ring formation) may be carbonyl carbon.

Moreover, the substituent corresponds to $Rb_2$ in (LC1-1) to (LC1-17). Further, in (LC1-1) to (LC1-17), n2 represents an integer of 0 to 4. In a case where n2 represents 2 or greater, a plurality of $Rb_2$'s may be the same as or different from each other and the plurality of $Rb_2$'s may be bonded to each other to form a ring.

In General Formula (ZI), examples of the organic groups of $R_{201}$, $R_{202}$, and $R_{203}$ include an aryl group, an alkyl group, and a cycloalkyl group.

It is preferable that at least one of $R_{201}$, $R_{202}$, or $R_{203}$ is an aryl group, and it is more preferable that all of $R_{201}$, $R_{202}$, and $R_{203}$ are aryl groups. As the aryl group, not only a phenyl group, a naphthyl group, or the like but also a heteroaryl group such as an indole residue and a pyrrole residue is also available. Preferred examples of the alkyl group and the cycloalkyl group as $R_{201}$ to $R_{203}$ include a linear or branched chain alkyl group having 1 to 10 carbon atoms and a cycloalkyl group having 3 to 10 carbon atoms. More preferred examples of the alkyl group include a methyl group, an ethyl group, an n-propyl group, an isopropyl group, and an n-butyl group. Still more preferred examples of the cycloalkyl group include a cyclopropyl group, a cyclobutyl group, a cyclopentyl group, a cyclohexyl group, and a cycloheptyl group. These groups may further have a substituent. Examples of the substituent that such groups may further have include, but are not limited to, a nitro group, a halogen atom such as a fluorine atom, a carboxyl group, a hydroxyl group, an amino group, a cyano group, an alkoxy group (preferably having 1 to 15 carbon atoms), a cycloalkyl group (preferably

having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), and an alkoxycarbonyloxy group (preferably having 2 to 7 carbon atoms).

Next, General Formulae (ZII) and (ZIII) will be described.

In General Formulae (ZII) and (ZIII), $R_{204}$ to $R_{207}$ each independently represent an aryl group, an alkyl group, or a cycloalkyl group.

The aryl group as $R_{204}$ to $R_{207}$ is preferably a phenyl group or a naphthyl group, and more preferably a phenyl group. The aryl group as $R_{204}$ to $R_{207}$ may be an aryl group having a heterocyclic structure containing an oxygen atom, a nitrogen atom, a sulfur atom, or the like. Examples of the skeleton of the aryl group having a heterocyclic structure include pyrrole, furan, thiophene, indole, benzofuran, and benzothiophene.

Preferred examples of the alkyl group and the cycloalkyl group as $R_{204}$ to $R_{207}$ include a linear or branched chain alkyl group having 1 to 10 carbon atoms (for example, a methyl group, an ethyl group, a propyl group, a butyl group, or a pentyl group), and a cycloalkyl group having 3 to 10 carbon atoms (a cyclopentyl group, a cyclohexyl group, or a norbornyl group).

The aryl group, the alkyl group, and the cycloalkyl group as $R_{204}$ to $R_{207}$ may have a substituent. Examples of the substituent that the aryl group, alkyl group and cycloalkyl group as $R_{204}$ to $R_{207}$ may have include an alkyl group (for example, having 1 to 15 carbon atoms) and a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group.

Furthermore, in General Formula (ZII), $Z^-$ represents a non-nucleophilic anion. Specifically, $Z^-$ is the same as those described as $Z^-$ in General Formula (ZI), preferred aspects thereof are also the same.

Specific examples of General Formulae (ZI) to (ZIII) are shown below, but are not limited thereto.

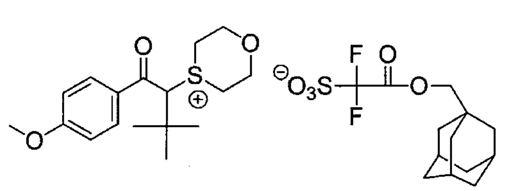

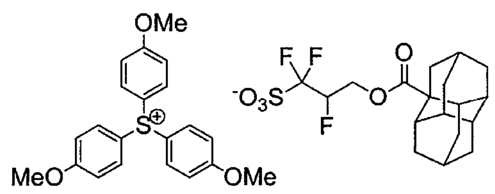

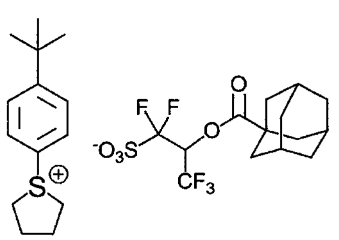

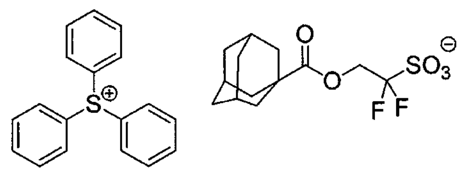

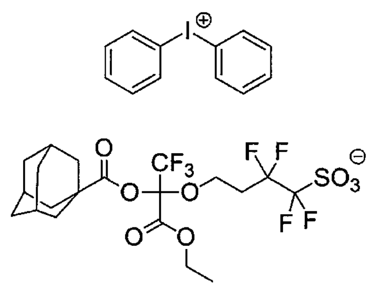

In the present invention, from the viewpoint of suppressing the diffusion of an acid generated by exposure to a unexposed area and improving the resolution, the photoacid generator is a compound which generates an acid (more preferably sulfonic acid) having a volume of 130 $Å^3$ or greater upon irradiation with electron beams or extreme ultraviolet rays, more preferably a compound which generates an acid (more preferably sulfonic acid) having a volume of 190 $Å^3$ or greater, still more preferably a compound which generates an acid (more preferably sulfonic acid) having a volume of 270 $Å^3$ or greater, and particularly preferably a compound which generates an acid (more preferably sulfonic acid) having a volume of 400 $Å^3$ or greater. From the viewpoint of the sensitivity or the solubility in the coating solvent, the volume is preferably 2,000 $Å^3$ or less and more preferably 1,500 $Å^3$ or less. The value of the volume is acquired using "WinMOPAC" (manufactured by FUJITSU). That is, first, the chemical structure of an acid according to each example

is input, next, using this structure as an initial structure, the most stable steric conformation of each acid is determined by molecular force field calculation using an MM3 method, and then, molecular orbital calculation using a PM3 method is performed with respect to the most stable steric conformation, whereby an "accessible volume" of each acid can be calculated. In addition, 1 Å denotes 0.1 nm.

In the present invention, photoacid generators which generate acids exemplified below upon irradiation with actinic rays or radiation are preferable. Further, in some of the examples, the calculated values of the volumes are added (unit: $Å^3$). The calculated value obtained here is a volume value of an acid in which a proton is bonded to the anionic moiety.

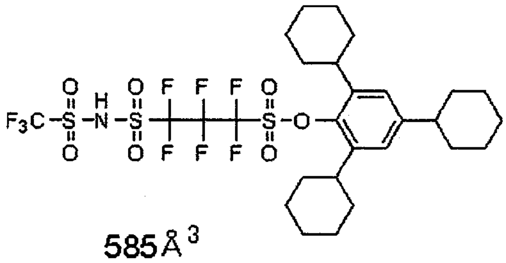

585 $Å^3$

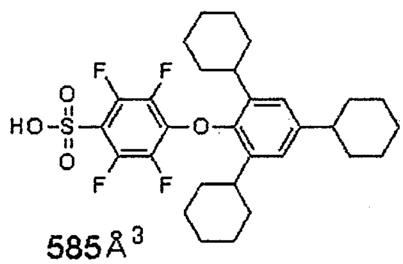

585 $Å^3$

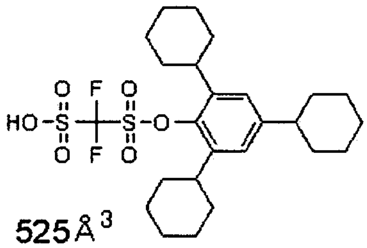

525 $Å^3$

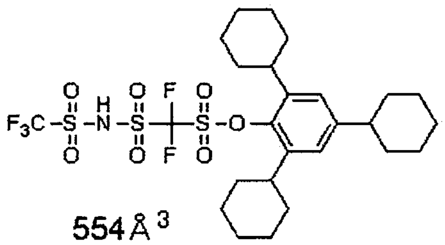

554 $Å^3$

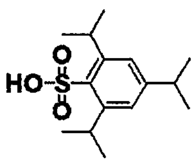

303 $Å^3$

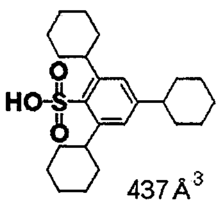

437 $Å^3$

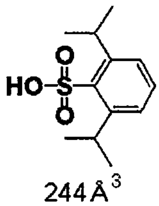

244 $Å^3$

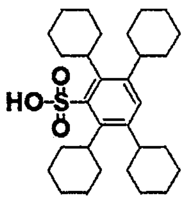

529 $Å^3$

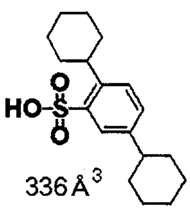

336 $Å^3$

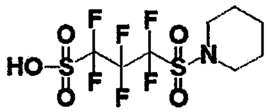

244 $Å^3$

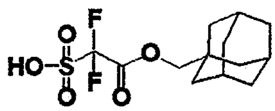

271 $Å^3$

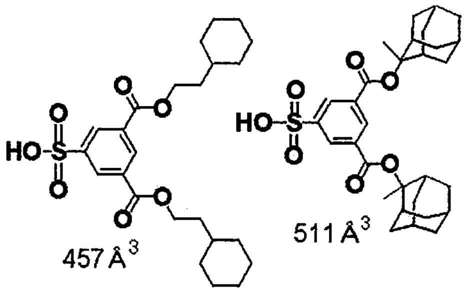

457 $Å^3$

511 $Å^3$

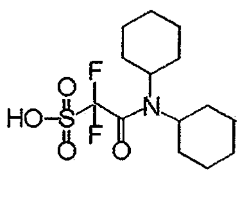

311 $Å^3$

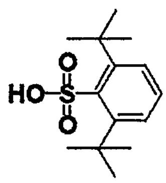

280 $Å^3$

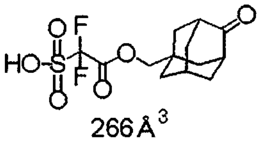

266 Å$^3$

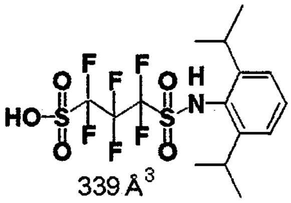

339 Å$^3$

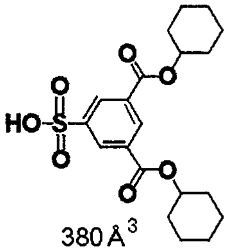

380 Å$^3$

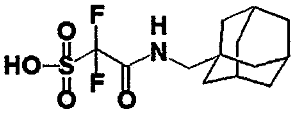

277 Å$^3$

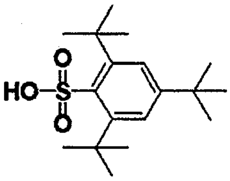

357 Å$^3$

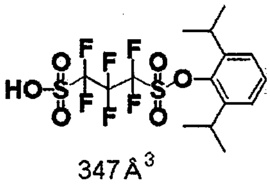

347 Å$^3$

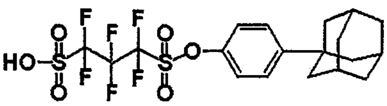

380 Å$^3$

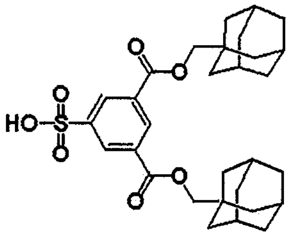

519 Å$^3$

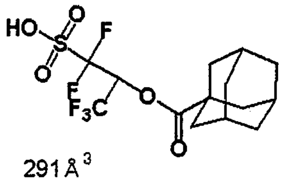

291 Å$^3$

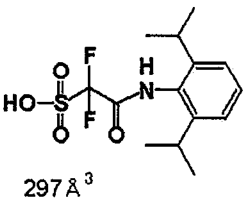

297 Å$^3$

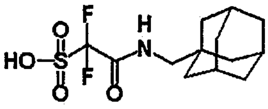

277 Å$^3$

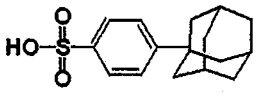

281 Å$^3$

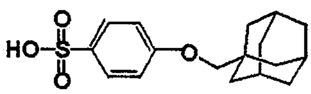

310 Å$^3$

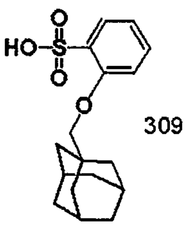

309 Å$^3$

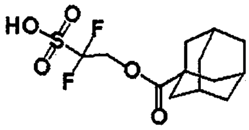

270 Å$^3$

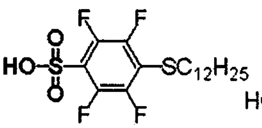

393 Å$^3$

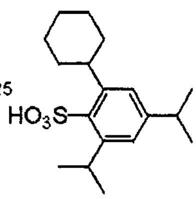

350 Å$^3$

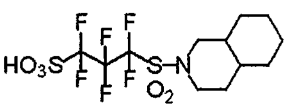

311 Å$^3$

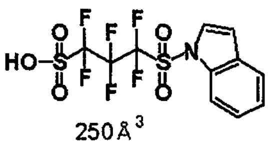

250 Å$^3$

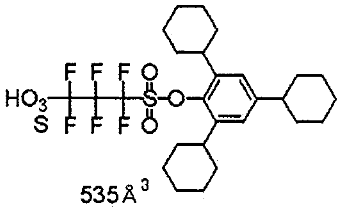

535 Å³

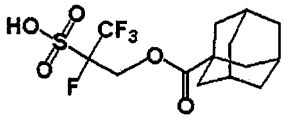

290 Å³

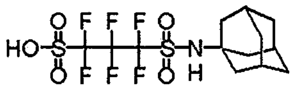

315 Å³

With regard to the photoacid generator, reference can be made to paragraphs <0368> to <0377> of JP2014-41328A and paragraphs <0240> to <0262> of JP2013-228681A (corresponding to <0339> of US2015/004533A), the contents of which are incorporated herein by reference. Specifically, for example, the following compounds are also preferable, but the present invention is not limited thereto.

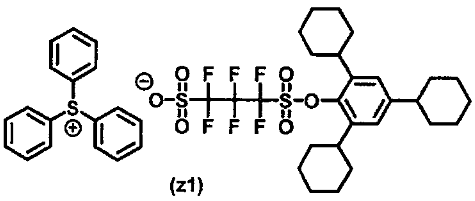

(z1)

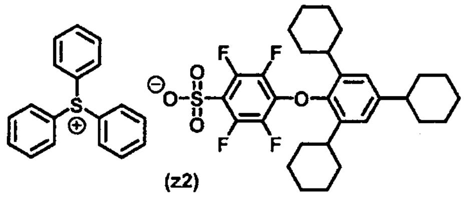

(z2)

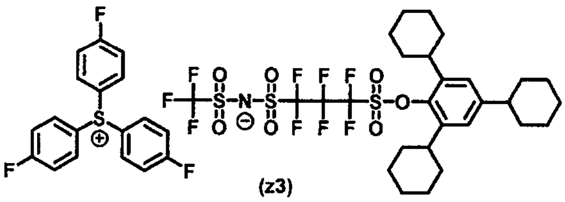

(z3)

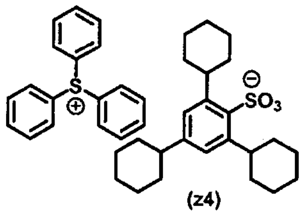

(z4)

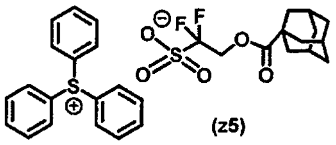

(z5)

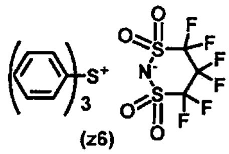

(z6)

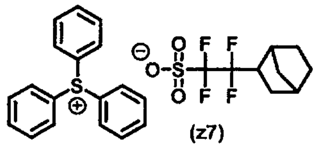

(z7)

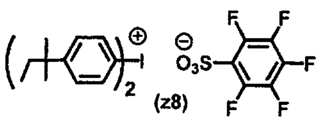

(z8)

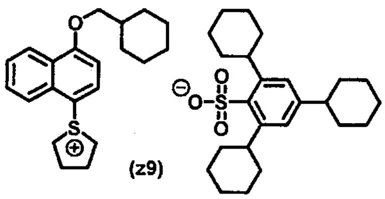

(z9)

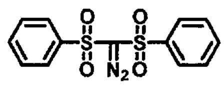

(z10)

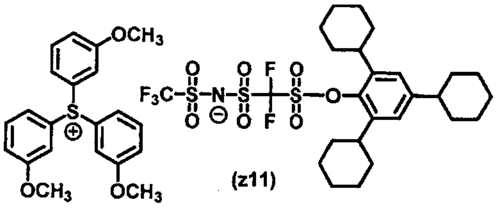

(z11)

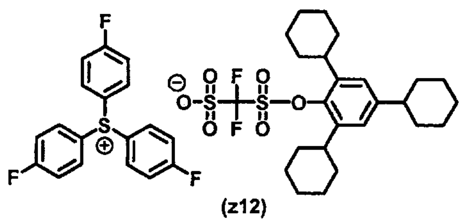

(z12)

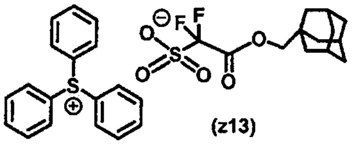
(z13)

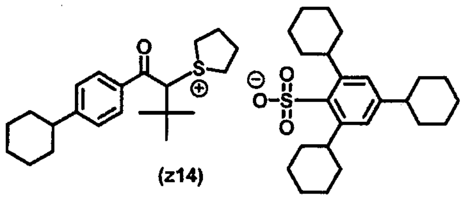
(z14)

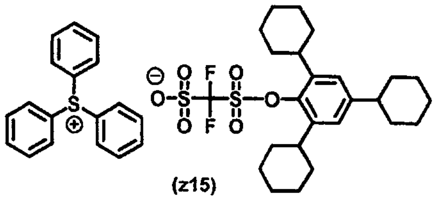
(z15)

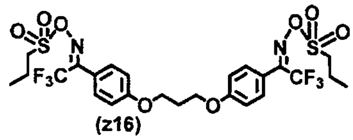
(z16)

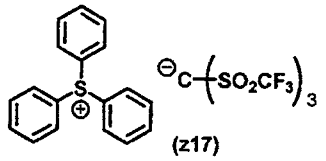
(z17)

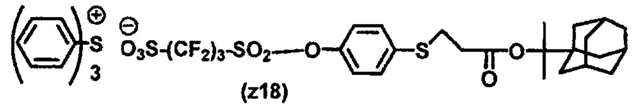
(z18)

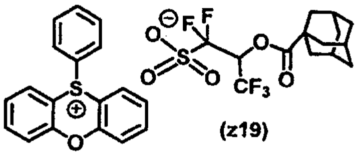
(z19)

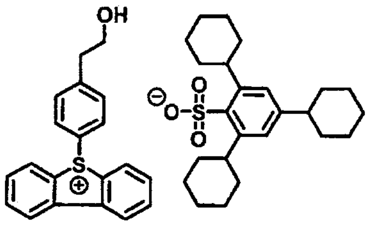
(z20)

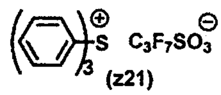
(z21)

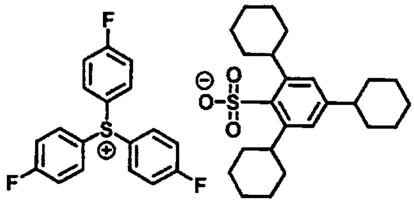
(z22)

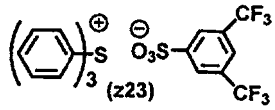
(z23)

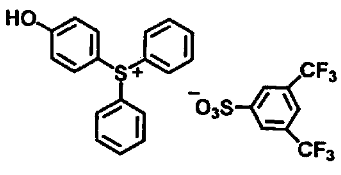
(z24)

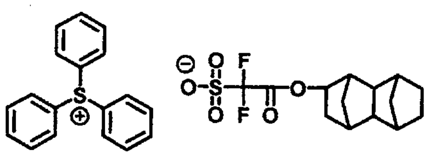
(z25)

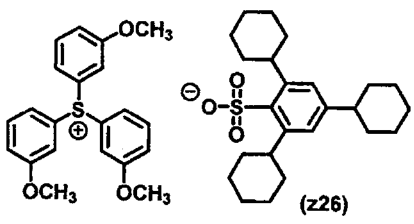
(z26)

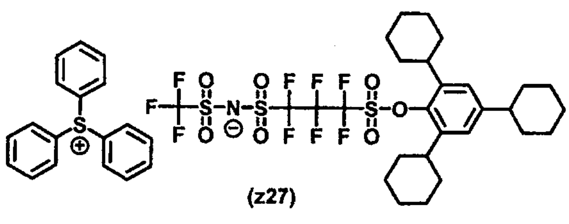
(z27)

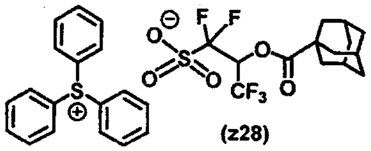

(z28)

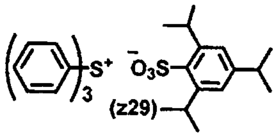

(z29)

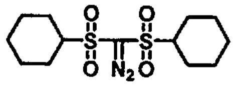

(z30)

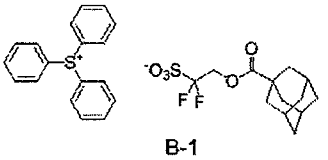

B-1

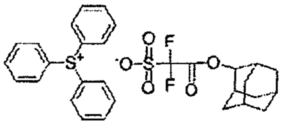

B-2

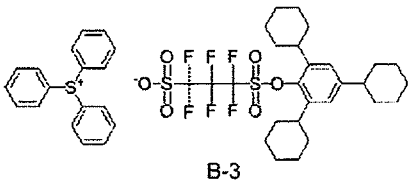

B-3

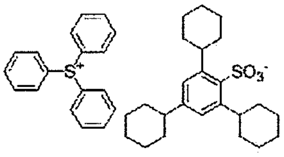

B-4

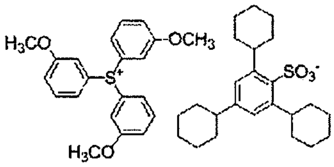

B-5

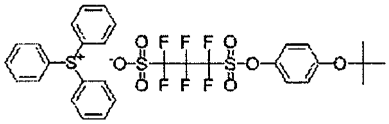

B-6

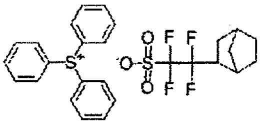

B-7

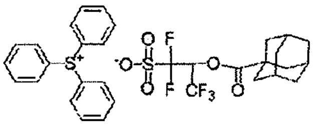

B-8

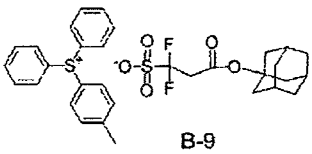

B-9

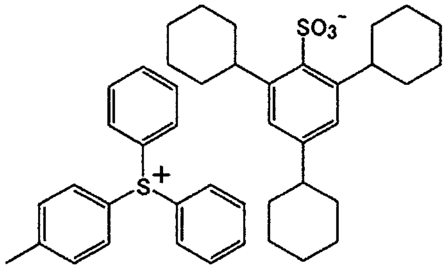

B-10

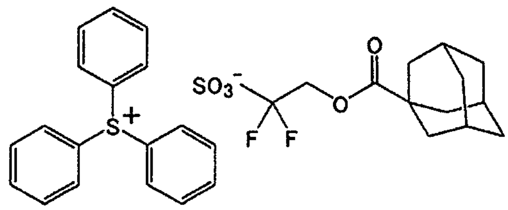

B-11

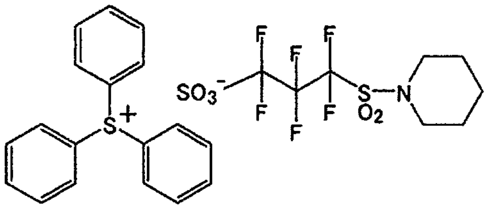

B-12

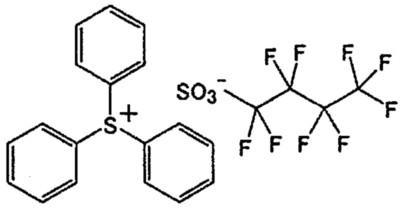

B-13

The photoacid generator may be used singly or in combination of two or more kinds thereof.

The content of the photoacid generator in the resist composition is preferably in a range of 0.1% to 50% by mass, more preferably in a range of 5% to 50% by mass, and still more preferably in a range of 8% to 40% by mass with respect to the total solid content of the composition. In particular, it is preferable that the content of the photoacid generator is high from the viewpoint of achieving both high sensitivity and high resolution during exposure to electron beams or extreme ultraviolet rays. From the above-described viewpoint, the content thereof is preferably in a range of

10% to 40% by mass and more preferably in a range of 10% to 35% by mass.

<Solvent>

A solvent can be used in a case of dissolving each of the above-described components to prepare a resist composition. Examples of the solvent that can be used include an organic solvent such as alkylene glycol monoalkyl ether carboxylate, alkylene glycol monoalkyl ether, alkyl lactate, alkyl alkoxy propionate, cyclic lactone having 4 to 10 carbon atoms, a monoketone compound having 4 to 10 carbon atoms which may have a ring, alkylene carbonate, alkyl alkoxy acetate, and alkyl pyruvate.

Preferred examples of the alkylene glycol monoalkyl ether carboxylate include propylene glycol monomethyl ether acetate, propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate, and ethylene glycol monoethyl ether acetate.

Preferred examples of the alkylene glycol monoalkyl ether include propylene glycol monomethyl ether, propylene glycol monoethyl ether, propylene glycol monopropyl ether, propylene glycol monobutyl ether, ethylene glycol monomethyl ether, and ethylene glycol monoethyl ether.

Preferred examples of the alkyl lactate include methyl lactate, ethyl lactate, propyl lactate, and butyl lactate.

Preferred examples of the alkyl alkoxy propionate include ethyl 3-ethoxypropionate, methyl 3-methoxypropionate, methyl 3-ethoxypropionate, and ethyl 3-methoxypropionate.

Preferred examples of the cyclic lactone having 4 to 10 carbon atoms include β-propiolactone, β-butyrolactone, γ-butyrolactone, α-methyl-γ-butyrolactone, β-methyl-γ-butyrolactone, γ-valerolactone, γ-caprolactone, γ-octanolactone, and α-hydroxy-γ-butyrolactone.

Preferred examples of the monoketone compound having 4 to 10 carbon atoms, which may have a ring, include 2-butanone, 3-methylbutanone, pinacolone, 2-pentanone, 3-pentanone, 3-methyl-2-pentanone, 4-methyl-2-pentanone, 2-methyl-3-pentanone, 4,4-dimethyl-2-pentanone, 2,4-dimethyl-3 -pentanone, 2,2,4,4-tetramethyl-3 -pentanone, 2-hexanone, 3-hexanone, 5-methyl-3-hexanone, 2-heptanone, 3-heptanone, 4-heptanone, 2-methyl-3-heptanone, 5-methyl-3-heptanone, 2,6-dimethyl-4-heptanone, 2-octanone, 3-octanone, 2-nonanone, 3-nonanone, 5-nonanone, 2-decanone, 3-decanone, 4-decanone, 5-hexen-2-one, 3-penten-2-one, cyclopentanone, 2-methylcyclopentanone, 3 -methylcyclopentanone, 2,2-dimethylcyclopentanone, 2,4,4-trimethylcyclopentanone, cyclohexanone, 3-methylcyclohexanone, 4-methylcyclohexanone, 4-ethylcyclohexanone, 2,2-dimethylcyclohexanone, 2,6-dimethylcyclohexanone, 2,2,6-trimethylcyclohexanone, cycloheptanone, 2-methylcycloheptanone, and 3-methylcycloheptanone.

Preferred examples of the alkylene carbonate include propylene carbonate, vinylene carbonate, ethylene carbonate, and butylene carbonate.

Preferred examples of the alkyl alkoxy acetate include 2-methoxyethyl acetate, 2-ethoxyethyl acetate, 2-(2-ethoxyethoxy)ethyl acetate, 3-methoxy-3-methylbutyl acetate, and 1-methoxy-2-propyl acetate.

Preferred examples of the alkyl pyruvate include methyl pyruvate, ethyl pyruvate, and propyl pyruvate.

Examples of the solvent which can be preferably used include a solvent having a boiling point of 130°C or higher at a normal temperature under a normal pressure. Specific examples thereof include cyclopentanone, γ-butyrolactone, cyclohexanone, ethyl lactate, ethylene glycol monoethyl ether acetate, propylene glycol monomethyl ether acetate, ethyl 3-ethoxypropionate, ethyl pyruvate, 2-ethoxyethyl acetate, 2-(2-ethoxyethoxy)ethyl acetate, and propylene carbonate.

In the present invention, the solvent may be used alone or in combination of two or more kinds thereof.

In the present invention, a mixed solvent obtained by mixing a solvent containing a hydroxyl group in a structure and a solvent containing no hydroxyl group may be used as the organic solvent.

Examples of the solvent containing a hydroxyl group include ethylene glycol, ethylene glycol monomethyl ether, ethylene glycol monoethyl ether, propylene glycol, propylene glycol monomethyl ether, propylene glycol monoethyl ether, and ethyl lactate. Among these, propylene glycol monomethyl ether or ethyl lactate is particularly preferable.

Examples of the solvent containing no hydroxyl group include propylene glycol monomethyl ether acetate, ethyl ethoxypropionate, 2-heptanone, γ-butyrolactone, cyclohexanone, butyl acetate, N-methylpyrrolidone, N,N-dimethylacetamide, and dimethyl sulfoxide. Among these, propylene glycol monomethyl ether acetate, ethyl ethoxypropionate, 2-heptanone, γ-butyrolactone, cyclohexanone, or butyl acetate is particularly preferable, and propylene glycol monomethyl ether acetate, ethyl ethoxypropionate, or 2-heptanone is most preferable.

A mixing ratio (mass ratio) of the solvent containing a hydroxyl group to the solvent containing no hydroxyl group is preferably in a range of 1/99 to 99/1, more preferably in a range of 10/90 to 90/10, and still more preferably in a range of 20/80 to 60/40. A mixed solvent containing 50% by mass or greater of the solvent containing no hydroxyl group is particularly preferable from the viewpoint of coating uniformity.

A mixed solvent of two or more kinds of the solvents containing propylene glycol monomethyl ether acetate is preferable as the solvent. Among these, a combination of γ -butyl lactone and butyl acetate is particularly preferable.

As the solvent, for example, the solvents described in paragraphs 0013 to 0029 of JP2014-219664A can also be used.

<Acid Diffusion Control Agent>

It is preferable that the resist composition contains an acid diffusion control agent from the viewpoint of reducing a change in performance over time from exposure to heating.

Examples of the acid diffusion control agent include a basic compound.

Examples the basic compound include compounds having structures represented by Formulae (A1) to (E1).

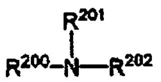
(A1)

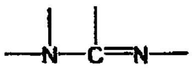
(B1)

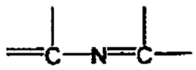
(C1)

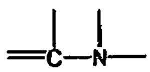
(D1)

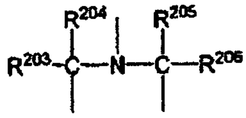
(E1)

In General Formulae (A1) and (E1), $R^{200}$, $R^{201}$, and $R^{202}$ may be the same as or different from each other and each represent a hydrogen atom, an alkyl group (preferably having 1 to 20 carbon atoms), a cycloalkyl group (preferably having 3 to 20 carbon atoms), or an aryl group (preferably having 6 to 20 carbon atoms). Here, $R^{201}$ and $R^{202}$ may be bonded to each other to form a ring.

With regard to the alkyl group, the alkyl group having a substituent is preferably an aminoalkyl group having 1 to 20 carbon atoms, a hydroxyalkyl group having 1 to 20 carbon atoms, or a cyanoalkyl group having 1 to 20 carbon atoms.

$R^{203}$, $R^{204}$, $R^{205}$, and $R^{206}$ may be the same as or different from each other and each represent an alkyl group having 1 to 20 carbon atoms.

The alkyl groups in General Formulae (A1) and (E1) are more preferably unsubstituted.

Preferred examples of the compound include a compound having an imidazole structure, a diazabicyclo structure, an onium hydroxide structure, an onium carboxylate structure, a trialkylamine structure, an aniline structure, or a pyridine structure, an alkylamine derivative having a hydroxyl group and/or an ether bond, and an aniline derivative having a hydroxyl group and/or an ether bond in addition to guanidine, aminopyrrolidine, pyrazole, pyrazoline, piperazine, aminomorpholine, aminoalkylmorpholine, and piperidine.

Examples of the compound having an imidazole structure include imidazole, 2,4,5-triphenylimidazole, and benzimidazole. Examples of the compound having a diazabicyclo structure include 1,4-diazabicyclo[2,2,2]octane, 1,5-diazabicyclo[4,3,0]nona-5-ene, and 1,8-diazabicyclo[5,4,0]undeca-7-ene. Examples of the compound having an onium hydroxide structure include triarylsulfonium hydroxide, phenacylsulfonium hydroxide, sulfonium hydroxide having a 2-oxoalkyl group, and specifically, triphenylsulfonium hydroxide, tris(t-butylphenyl)sulfonium hydroxide, bis(t-butylphenyl)iodonium hydroxide, phenacylthiophenium hydroxide, and 2-oxopropylthiophenium hydroxide. The compound having an onium carboxylate structure is a compound in which the anionic moiety of the compound having an onium hydroxide structure is a carboxylate, and examples thereof include acetate, adamantane-1-carboxylate, and perfluoroalkyl carboxylate. Examples of the compound having a trialkylamine structure include tri(n-butyl)amine and tri(n-octyl)amine. Examples of the aniline compound include 2,6-diisopropylaniline, N,N-dimethylaniline, N,N-dibutylaniline, and N,N-dihexylaniline. Examples of the alkylamine derivative having a hydroxyl group and/or an ether bond include ethanolamine, diethanolamine, triethanolamine, and tris(methoxyethoxyethyl)amine. Examples of the aniline derivative having a hydroxyl group and/or an ether bond include N,N-bis(hydroxyethyl)aniline.

Other examples of the basic compound include an amine compound containing a phenoxy group and an ammonium salt compound containing a phenoxy group.

As the amine compound, a primary, secondary, or tertiary amine compound can be used, and an amine compound having at least one alkyl group bonded to the nitrogen atom thereof is preferable. The amine compound is more preferably a tertiary amine compound. Any amine compound is available as long as at least one alkyl group (preferably having 1 to 20 carbon atoms) is bonded to a nitrogen atom, and a cycloalkyl group (preferably having 3 to 20 carbon atoms) or an aryl group (preferably having 6 to 12 carbon atoms), in addition to the alkyl group, may be bonded to the nitrogen atom.

Furthermore, it is preferable that the amine compound has an oxygen atom in the alkyl chain to form an oxyalkylene group. The number of oxyalkylene groups per molecule may be 1 or more, and is preferably 3 to 9, and more preferably 4 to 6. Among the oxyalkylene groups, an oxyethylene group ($-CH_2CH_2O-$) or an oxypropylene group ($-CH(CH_3)CH_2O-$ or $-CH_2CH_2CH_2O-$) is preferable, and the oxyethylene group is more preferable.

As the ammonium salt compound, a primary, secondary, tertiary, or quaternary ammonium salt compound can be used. An ammonium salt compound having at least one alkyl group bonded to the nitrogen atom thereof is preferable.

Any ammonium salt compound is available as long as at least one alkyl group (preferably having 1 to 20 carbon atoms) is bonded to a nitrogen atom, and a cycloalkyl group (preferably having 3 to 20 carbon atoms) or an aryl group (preferably having 6 to 12 carbon atoms) may be bonded to the nitrogen atom, in addition to the alkyl group. It is preferable that the ammonium salt compound has an oxygen atom in the alkyl chain to form an oxyalkylene group. The number of oxyalkylene groups per molecule may be 1 or more, and is preferably 3 to 9, and more preferably 4 to 6. Among the oxyalkylene groups, an oxyethylene group ($-CH_2CH_2O-$) or an oxypropylene group ($-CH(CH_3)CH_2O-$ or $-CH_2CH_2CH_2O-$) is preferable, and the oxyethylene group is more preferable.

Examples of the anion in the ammonium salt compound include a halogen atom, sulfonate, borate, and phosphate. Among these, a halogen atom and sulfonate are preferable. Among the halogen atoms, chloride, bromide, and iodide are particularly preferable. Among the sulfonates, an organic sulfonate having 1 to 20 carbon atoms is particularly preferable. Examples of the organic sulfonate include aryl sulfonate and alkyl sulfonate having 1 to 20 carbon atoms. The alkyl group in the alkyl sulfonate may have a substituent. Examples of the substituent include fluorine, chlorine, bromine, an alkoxy group, an acyl group, and an aryl group. Specific examples of the alkyl sulfonate include methane sulfonate, ethane sulfonate, butane sulfonate, hexane sulfonate, octane sulfonate, benzyl sulfonate, trifluoromethane sulfonate, pentafluoroethane sulfonate, and nonafluorobutane sulfonate. Examples of the aryl group in the aryl sulfonate include a benzene ring, a naphthalene ring, and an anthracene ring. The benzene ring, the naphthalene ring, or the anthracene ring may have a substituent. Preferred examples of the substituent include a linear or branched chain alkyl group having 1 to 6 carbon atoms and a cycloalkyl group having 3 to 6 carbon atoms. Specific examples of the linear or branched chain alkyl group and cycloalkyl groups include methyl, ethyl, n-propyl, isopropyl, n-butyl, isobutyl, t-butyl, n-hexyl, and cyclohexyl. Other examples of the substituent include an alkoxy group having 1 to 6 carbon atoms, a halogen atom, cyano, nitro, an acyl group, and an acyloxy group.

The amine compound with a phenoxy group and the ammonium salt compound with a phenoxy group are those having a phenoxy group at the terminal of the alkyl group of each of the amine compound and the ammonium salt compound opposite to the nitrogen atom. The phenoxy group may have a substituent. Examples of the substituent of the phenoxy group include an alkyl group, an alkoxy group, a halogen atom, a cyano group, a nitro group, a carboxyl group, a carboxylic acid ester group, a sulfonic acid ester group, an aryl group, an aralkyl group, an acyloxy group, and an aryloxy group. The substitution position of the substituent may be any of 2- to 6-positions. The number of the substituents may be any in the range of 1 to 5.

This compound preferably has at least one oxyalkylene group between the phenoxy group and the nitrogen atom. The number of oxyalkylene groups per molecule may be 1 or more, and is preferably 3 to 9, and more preferably 4 to 6. Among the oxyalkylene groups, an oxyethylene group ($-CH_2CH_2O-$) or an oxypropylene group ($-CH(CH_3)CH_2O-$ or $-CH_2CH_2CH_2O-$) is preferable, and the oxyethylene group is more preferable.

The amine compound having a phenoxy group can be obtained by heating a primary or secondary amine having a phenoxy group with a haloalkyl ether to make a reaction, and then adding an aqueous solution of a strong base such as sodium hydroxide, potassium hydroxide, and tetraalkylammonium thereto, followed by extraction with an organic solvent such as ethyl acetate and chloroform. Alternatively, the amine compound having a phenoxy group can be obtained by heating a primary or secondary amine with a haloalkyl ether having a phenoxy group at a terminal thereof to make a reaction, and then adding an aqueous solution of a strong base such as sodium hydroxide, potassium hydroxide, and tetraalkylammonium thereto, followed by extraction with an organic solvent such as ethyl acetate and chloroform.

(Compound (PA) that contains proton-accepting functional group and is decomposed upon irradiation with actinic rays or radiation to generate compound in which proton-accepting properties are degraded and lost or proton-accepting properties are changed to acidic properties)

The composition according to the present invention may further contain, as an acid diffusion control agent, a compound [hereinafter also referred to as a compound (PA)] that contains a proton-accepting functional group and is decomposed upon irradiation with actinic rays or radiation to generate a compound in which the proton-accepting properties are degraded and lost or the proton-accepting properties are changed to acidic properties.

The proton accepting functional group is a group capable of electrostatically interacting with a proton, or a functional group having an electron, and for example, the proton acceptor functional group means a functional group having a macrocyclic structure such as a cyclic polyether, or a functional group having a nitrogen atom with an unshared electron pair which does not contribute to $\pi$-conjugation. The nitrogen atom having an unshared electron pair not contributing to $\pi$-conjugation is, for example, a nitrogen atom having a partial structure represented by the following general formula.

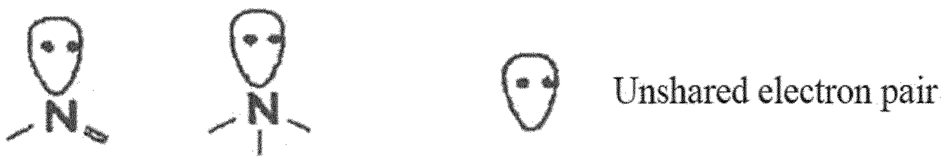


Preferred examples of the partial structure of the proton-accepting functional group include crown ether, azacrown ether, primary to tertiary amines, pyridine, imidazole, and a pyrazine structure.

The compound (PA) is decomposed upon irradiation with actinic rays or radiation to generate a compound in which the proton-accepting properties are degraded and lost or the proton-accepting properties are changed to acidic properties. Here, the expression "the proton-accepting properties are degraded and lost or the proton-accepting properties are changed to acidic properties" denotes a change of proton-accepting properties due to addition of the proton to the proton-accepting functional group, and specifically a decrease in the equilibrium constant at chemical equilibrium in a case where a proton adduct is generated from the compound (PA) containing the proton-accepting functional group and the proton.

Specific examples of the compound (PA) include the following compounds. Further, with regard to specific examples of the compound (PA), reference can be made to those described in paragraphs 0421 to 0428 of JP2014-41328A or paragraphs 0108 to 0116 of JP2014-134686A, the contents of which are incorporated herein by reference.

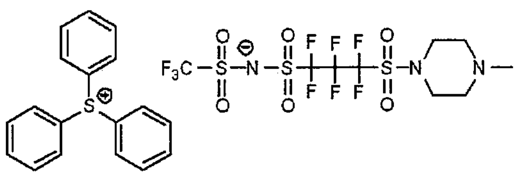
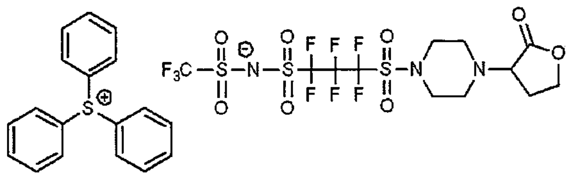

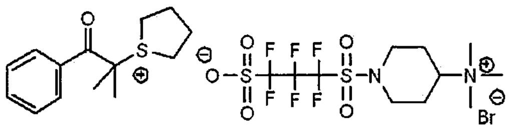
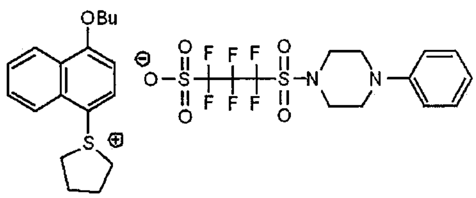

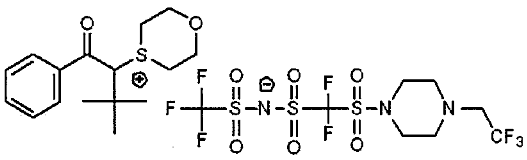
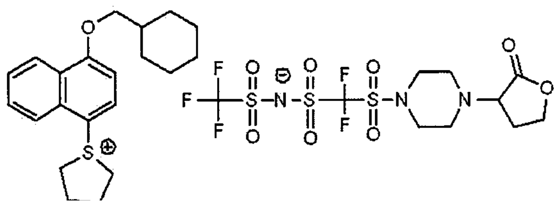

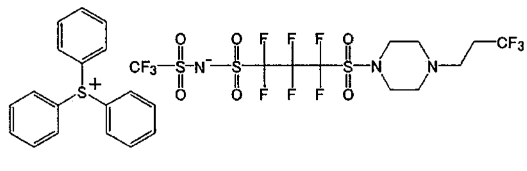
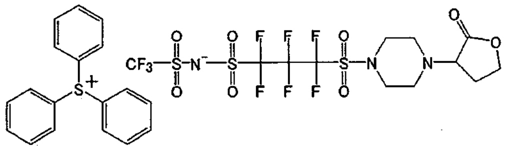

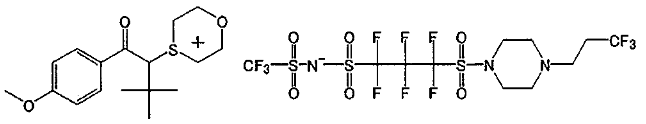

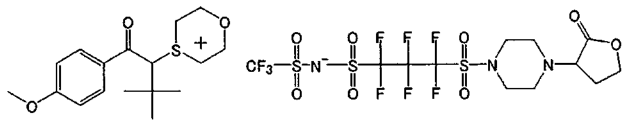

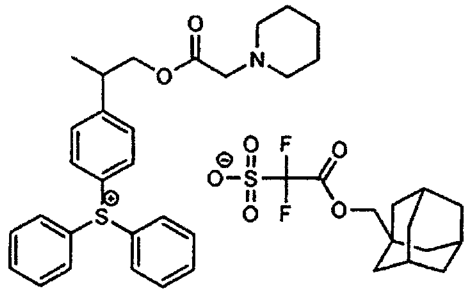

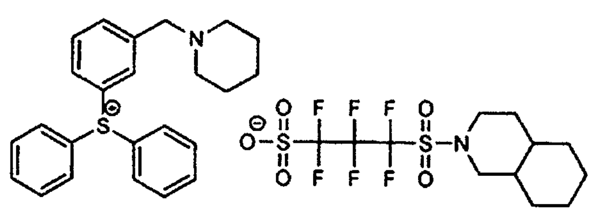

The acid diffusion control agent may be used alone or in combination of two or more kinds thereof.

The content of the acid diffusion control agent is preferably in a range of 0.001% to 10% by mass and more preferably in a range of 0.005% to 5% by mass with respect to the total solid content of the resist composition.

The ratio of the photoacid generator to the acid diffusion control agent used in the composition (photoacid generator/acid diffusion control agent (molar ratio)) is preferably in a range of 2.5 to 300. That is, the molar ratio is preferably 2.5 or greater in view of sensitivity and resolution, and is preferably 300 or less in view of suppressing the reduction in resolution due to thickening of the resist pattern over time from exposure to the heat treatment. The photoacid generator/acid diffusion control agent (molar ratio) is more preferably 5.0 to 200, and still more preferably 7.0 to 150.

As the acid diffusion control agent, for example, the compounds (amine compounds, amide group-containing compounds, urea compounds, nitrogen-containing heterocyclic compounds, and the like) described in paragraphs 0140 to 0144 of JP2013-11833A can also be used.

<Hydrophobic resin>

The resist composition may contain a hydrophobic resin in addition to the resin (A).

It is preferable that the hydrophobic resin is designed to be localized on a surface of a resist film. Unlike the surfactant, the hydrophobic resin does not necessarily contain a hydrophilic group in a molecule and may not contribute to uniform mixing with a polar/non-polar material.

Examples of the effect obtained by adding the hydrophobic resin include control of static and dynamic contact angles of a surface of the resist film with respect to water and suppression of out gas.

From the viewpoint of localization on the film surface layer, the hydrophobic resin includes preferably one or more kinds and more preferably two or more kinds among "a fluorine atom", "a silicon atom", and "a $CH_3$ partial structure included in a side chain of the resin". Further, it is preferable that the hydrophobic resin contains a hydrocarbon group having 5 or more carbon atoms. These groups may be contained in the main chain of the resin or may be substituted in the side chain.

In a case where the hydrophobic resin includes a fluorine atom and/or a silicon atom, the fluorine atom and/or the silicon atom in the hydrophobic resin may be present at a main chain or a side chain of the resin.

In a case where the hydrophobic resin includes a fluorine atom, it is preferably a resin which has an alkyl group having a fluorine atom, a cycloalkyl group having a fluorine atom, or an aryl group having a fluorine atom as a partial structure having a fluorine atom.

The alkyl group having a fluorine atom (preferably having 1 to 10 carbon atoms and more preferably having 1 to 4 carbon atoms) is a linear or branched chain alkyl group in which at least one hydrogen atom is substituted with a fluorine atom, and may further have a substituent other than a fluorine atom.

The cycloalkyl group having a fluorine atom is a monocyclic or polycyclic cycloalkyl group in which at least one hydrogen atom is substituted with a fluorine atom, and may further have a substituent other than a fluorine atom.

Examples of the aryl group having a fluorine atom include an aryl group such as a phenyl group or a naphthyl group, in which at least one hydrogen atom is substituted with a fluorine atom, and may further have a substituent other

than a fluorine atom.

Examples of a repeating unit having a fluorine atom or a silicon atom include those exemplified in paragraph 0519 of US2012/0251948A1.

Furthermore, as described above, it is also preferable that the hydrophobic resin includes a $CH_3$ partial structure in a side chain moiety.

Here, the CH3 partial structure contained in the side chain moiety in the hydrophobic resin includes a CH3 partial structure contained in an ethyl group, a propyl group, or the like.

On the other hand, a methyl group (for example, an $\alpha$-methyl group of a repeating unit having a methacrylic acid structure) which is directly bonded to a main chain of the hydrophobic resin has little contribution to the surface localization of the hydrophobic resin caused by the effect of the main chain, and thus is not included in examples of the CH3 partial structure according to the present invention.

With regard to the hydrophobic resin, reference can be made to the description in <0348> to <0415> of JP2014-010245A, the contents of which are incorporated herein by reference.

Further, the resins described in JP2011-248019A, JP2010-175859A, and/or JP2012-032544A, in addition to those described above, can also be preferably used as the hydrophobic resin.

<Surfactant>

The resist composition may further contain a surfactant. In a case where an exposure light source having a wavelength of 250 nm or less and particularly 220 nm or less is used, a pattern with satisfactory sensitivity and resolution and less adhesiveness and development defects can be formed by allowing the resin composition to contain the surfactant.

It is particularly preferable to use a fluorine-based and/or silicon-based surfactant as the surfactant.

Examples of the fluorine- and/or silicon-based surfactants include the surfactants described in <0276> of US2008/0248425A. In addition, EFTOP EF301 or EF303 (manufactured by Shin-Akita Chemical Co., Ltd.); FLORAD FC430, 431, or 4430 (manufactured by Sumitomo 3M Inc.); MEGAFACE F171, F173, F176, F189, F113, F110, F177, F120, or R08 (manufactured by DIC Corporation); SURFLON S-382, SC101, 102, 103, 104, 105, or 106 (manufactured by Asahi Glass Co., Ltd.); TROYSOL S-366 (manufactured by Troy Chemical Corporation); GF-300 or GF-150 (manufactured by Toagosei Chemical Industry Co., Ltd.); SURFLON S-393 (manufactured by Seimi Chemical Co., Ltd.); EFTOP EF121, EF122A, EF122B, RF122C, EF125M, EF135M, EF351, EF352, EF801, EF802, or EF601 (manufactured by JEMCO Inc.); PF636, PF656, PF6320, or PF6520 (manufactured by OMNOVA Solutions Inc.); or FTX-204G, 208G, 218G, 230G, 204D, 208D, 212D, 218D, or 222D (manufactured by NEOS COMPANY LIMITED) may be used. In addition, a polysiloxane polymer KP-341 (manufactured by Shin-Etsu Chemical Co., Ltd.) can also be used as the silicon-based surfactant.

Moreover, in addition to the known surfactants as shown above, a surfactant may be synthesized using a fluoroaliphatic compound produced using a telomerization method (also referred to as a telomer method) or an oligomerization method (also referred to as an oligomer method). Specifically, a polymer containing a fluoroaliphatic group derived from fluoroaliphatic compound may be used as the surfactant. The fluoroaliphatic compound can be synthesized in accordance with the method described in JP2002-90991A.

In addition, another surfactant other than the fluorine-based and/or silicon-based surfactants, described in <0280> of US2008/0248425A, may also be used.

These surfactants may be used alone or in combination of two or more kinds thereof.

In a case where the resist composition contains a surfactant, the content thereof is preferably in a range of 0% to 2% by mass, more preferably in a range of 0.0001% to 2% by mass, and still more preferably in a range of 0.0005% to 1% by mass with respect to the total solid content of the composition.

<Other additives>

The chemically amplified resist composition may further contain a dissolution inhibiting compound, a dye, a plasticizer, a photosensitizer, a light absorbing agent, and/or a compound promoting the solubility in a developer (for example, a phenol compound having a molecular weight of 1,000 or less or an alicyclic or aliphatic compound containing a carboxy group).

The resist composition may further include a dissolution inhibiting compound.

Here, the "dissolution inhibiting compound" is intended to mean a compound having a molecular weight of 3,000 or less, whose solubility in an organic developer decreases by decomposition due to the action of an acid.

[Method of producing treatment liquid]

It is preferable that the treatment liquid according to the embodiment of the present invention is obtained by carrying out the following purifying step in order to set the contents of a metal component, an organic substance having a boiling point of 300°C or higher, and the like to be in desired ranges.

<Purifying step>

The purifying step may be carried out at any timing. Examples of the purifying step include the following purification treatments I to IV.

That is, the purification treatment I is a treatment of performing purification on raw materials used for producing the organic solvent before the production of the organic solvent constituting the treatment liquid.

Further, the purification treatment II is a treatment of performing purification on the organic solvent constituting the treatment liquid during production and/or after production of the organic solvent.

Further, the purification treatment III is a treatment of performing purification on each component before two or more kinds of organic solvents are mixed during the production of the treatment liquid.

Further, the purification treatment IV is a treatment of performing purification on the mixture after two or more kinds of organic solvents are mixed during the production of the treatment liquid.

As described above, it is preferable that the purification is performed to obtain the desired treatment liquid. The purification of each organic solvent may be performed before or after the organic solvents are mixed. In particular, a method of blending the purified organic solvents is preferable in terms that the treatment liquid can be produced by setting the blend ratio of the organic solvents to be constant.

Each of the purification treatments I to IV may be carried out only once or twice or more times.

In addition, the organic solvent to be used can be used by purchasing high-purity grade products (particularly products having a low content of organic impurities, metal impurities, water, or the like described above) and further performing the following purification treatment on the purchased products.

Hereinafter, an example of the purifying step will be presented. In the following description, the purification targets in the purifying step are simply collectively referred to as "the liquid to be purified".

Examples of the purifying step include an aspect of carrying out a first ion exchange treatment of performing an ion exchange treatment for a liquid to be purified, a dehydration treatment of performing dehydration of the liquid to be purified after the first ion exchange treatment, a distillation treatment of performing distillation of the liquid to be purified after the dehydration treatment, a second ion exchange treatment of performing an ion exchange treatment for the liquid to be purified after the distillation treatment, and an organic impurity removing treatment of removing organic impurities of the liquid to be purified after the second ion exchange treatment in this order. Hereinafter, the description will be made using the purifying step as an example, but the purification method in a case of preparing the treatment liquid according to the embodiment of the present invention is not limited thereto. For example, an aspect in which a dehydration treatment of dehydrating the liquid to be purified, a distillation treatment of distilling the liquid to be purified after the dehydration treatment, a first ion exchange treatment of performing an ion exchange treatment on the liquid to be purified, and an organic impurity removing treatment of removing organic impurities of the liquid to be purified after the second ion exchange treatment are performed in this order may also be employed.

According to the first ion exchange treatment, it is possible to remove the ion components (for example, the metal component) in the liquid to be purified.

In the first ion exchange treatment, the first ion exchange means such as an ion exchange resin is used. The ion exchange resins may be any of those having a cation exchange resin or an anion exchange resin provided on a single bed, those having a cation exchange resin and an anion exchange resin provided on a double bed, or those having a cation exchange resin and an anion exchange resin provided on a mixed bed.

Incidentally, in order to reduce elution of moisture from the ion exchange resin, it is preferable to use a dry resin that includes moisture as least as possible as the ion exchange resin. As such a dry resin, a commercially available product can be used, and examples thereof include 15JS-HG·DRY (trade name, dry cation exchange resin, moisture content of 2% or less) and MSPS2-1·DRY (trade name, mixed-bed resin, moisture content of 10% or less) (manufactured by Organo Corporation).

By the dehydration treatment, it is possible to remove water in the liquid to be purified. Further, in a case where zeolite described below (in particular, Molecular Sieve (trade name), manufactured by Union Showa K. K., or the like) is used in the dehydration treatment, olefins can also be removed.

Examples of the dehydrating means used for the dehydration treatment include a dehydrating film, a water adsorbent that is insoluble in the liquid to be purified, an aeration replacement device using a dry inert gas, and a heating or vacuum heating device.

In a case of using the dehydrating film, film dehydration is performed by pervaporation (PV) or vapor permeation

(VP). The dehydrating film is constituted as, for example, a water-permeable film module. As the dehydrating film, a film formed of a polymer-based material such as a polyimide-based polymer, a cellulose-based polymer, or a polyvinyl alcohol-based polymer or an inorganic material such as zeolite can be used.

The water adsorbent is used after being added to the liquid to be purified. Examples of the water adsorbent include zeolite, diphosphorus pentaoxide, silica gel, calcium chloride, sodium sulfate, magnesium sulfate, anhydrous zinc chloride, fumed sulfuric acid, and soda lime.

According to the distillation treatment, it is possible to remove impurities eluted from the dehydrating film, the metal component in the liquid to be purified, which is hardly removed in the first ion exchange treatment, fine particles (in a case where the metal component is a fine particle, it is also included), and water in the liquid to be purified.

The distillation means is formed of, for example, a single-stage distillation device. Although the impurities are concentrated in a distillation device or the like by a distillation treatment, it is preferable to provide a means that discharges a part of the liquid having concentrated impurities to the outside periodically or constantly in the distillation means in order to prevent some of the concentrated impurities from flowing out.

According to the second ion exchange treatment, impurities can be removed in a case where the impurities accumulated in the distillation device flow out or eluates can be removed from pipes made of stainless steel (SUS) or the like used as a liquid feeding line.

Examples of the second ion exchange means include those having a column-shaped container filled with an ion exchange resin, and an ion adsorption film, and the ion adsorption film is preferable in view of its capability of performing a treatment at a high flow speed.

Examples of the ion adsorption film include NEOSEPTA (trade name, manufactured by ASTOM Corporation).

Each of the above-described treatments is preferably performed in an inert gas atmosphere which is in a closed state and has a low potential of incorporation of water into the liquid to be purified.

In order to suppress the incorporation of moisture as much as possible, each of the treatments is preferably performed in an inert gas atmosphere at a dew point temperature of -70°C or lower. Since the moisture concentration in the gas phase is 2 ppm by mass or less in an inert gas atmosphere at -70°C or lower, the moisture is less likely to be mixed into the liquid to be purified.

Examples of the purifying step include a treatment for absorbing and purifying the metal component using silicon carbide, described in WO2012/043496A, in addition to the above-described treatments.

According to the organic impurity removing treatment, high-boiling point organic impurities and the like (including organic substances having a boiling point of 300°C or higher) that are contained in the liquid to be purified after the distillation treatment and are difficult to remove by the distillation treatment can be removed.

As the organic impurity removing unit, for example, the organic impurities can be removed by an organic impurity absorption member provided with an organic impurity adsorption filter capable of adsorbing organic impurities. Further, the organic impurity adsorption member is typically configured to include an organic impurity adsorption filter and a base material that fixes the impurity adsorption filter.

From the viewpoint of improving the performance for adsorbing organic impurities, it is preferable that the organic impurity adsorption filter has an organic substance skeleton capable of interacting with organic impurities on a surface thereof (in other words, the surface is modified with an organic substance skeleton capable of interacting with organic impurities). Further, as an example for the expression of "has an organic substance skeleton capable of interacting with organic impurities on a surface thereof', a form in which an organic substance skeleton capable of interacting with the organic impurities is adhered to the surface of the base material constituting the organic impurity absorption filter described below may be exemplified.

Examples of the organic substance skeleton capable of interacting with the organic impurities include a chemical structure which can react with the organic impurities so that the organic impurities are trapped by the organic impurity adsorption filter. More specifically, in a case where the organic impurities include dioctyl phthalate, diisononyl phthalate, dioctyl adipate, and dibutyl phthalate, a benzene ring skeleton is exemplified as the organic substance skeleton. Further, in a case where the organic impurities include ethylene propylene rubber, an alkyl skeleton is exemplified as the organic substance skeleton. More specifically, in a case where the organic impurities include n-long-chain alkyl alcohol (structural isomer in a case of using 1-long-chain alkyl alcohol as a solvent), an alkyl group is exemplified as the organic skeleton.

Examples of the base material (material) constituting the organic impurity adsorption filter include activated carbon-carried cellulose, diatomaceous earth, nylon, polyethylene, polypropylene, polystyrene, and a fluororesin.

Further, as the organic impurity removal filter, filters obtained by fixing activated carbon to nonwoven fabric which are described in JP2002-273123A and JP2013-150979A can be used.

Further, the organic impurity removing treatment is not limited to an aspect of using the organic impurity adsorption filter capable of adsorbing the organic impurities as described above, and for example, an aspect of physically trapping the organic impurities may be employed. Since organic impurities having a relatively high boiling point of 250°C or higher are coarse in many cases (for example, a compound having 8 or more carbon atoms), the organic impurities can be physically trapped by using a filter having a pore diameter of approximately 1 nm.

For example, in a case where the organic impurities include dioctyl phthalate, the structure of the dioctyl phthalate is greater than 10 Å (= 1 nm). Therefore, dioctyl phthalate cannot pass through the pores of the filter by using an organic impurity removal filter having a pore diameter of 1 nm. That is, dioctyl phthalate is physically trapped by the filter and is thus removed from the liquid to be purified.

In this manner, not only the chemical interaction but also the physical removal method can be applied to the removal of the organic impurities. Here, in this case, a filter having a pore diameter of 3 nm or greater is used as "filtration member" described below, and a filter having a pore diameter less than 3 nm is used as "organic impurity removal filter".

Further, the purifying step may further include a purification treatment V and a purification treatment VI described below. The purification treatment V and the purification treatment VI may be carried out at any timing, for example, after the purifying step IV or the like.

The purification treatment V is a filtering treatment using a metal ion adsorption member for the purpose of removing metal ions.

Further, the purification treatment VI is a filtration treatment for removing coarse particles.

Hereinafter, the purification treatment V and the purification treatment VI will be described.

Examples of the metal ion removal means in the purification treatment VI include filtering with a metal ion adsorption member provided with a metal ion adsorption filter.

The metal ion adsorption member may be configured to include at least one metal ion adsorption filter or may be configured such that a plurality of metal ion adsorption filters are stacked according to a target purification level. The metal ion adsorption member is typically configured to include the metal ion adsorption filter and a base material that fixes the metal ion adsorption filter.

The metal ion adsorption filter has a function of adsorbing metal ions in the liquid to be purified. Further, it is preferable that the metal ion adsorption filter is a filter which can perform ion exchange.

Here, the metal ions to be adsorbed are not particularly limited, but Fe, Cr, Ni, and Pb are preferable from the viewpoint of easily causing defects of a semiconductor device.

From the viewpoint of improving the performance of adsorbing metal ions, it is preferable that the metal ion adsorption filter contains an acid group on the surface. Examples of the acid group include a sulfo group and a carboxy group.

Examples of the base material (material) constituting the metal ion adsorption filter include cellulose, diatomaceous earth, nylon, polyethylene, polypropylene, polystyrene, and a fluororesin.

As the filtration means in the purification treatment VI, an aspect in which the filtration is performed using a filtration member provided with a filter having a particle removal diameter of 20 nm or less is exemplified. Particulate impurities can be removed from the liquid to be purified by adding the above-described filter. Here, examples of "particulate impurities" include particles such as dust, dirt, organic solids, and inorganic solids contained as impurities in the raw materials used during the production of the liquid to be purified and particles such as dust, dirt, organic solids, and inorganic solids brought in as a contaminant during the purification of the liquid to be purified, and the particulate impurities correspond to those that finally exist as particles without being dissolved in the liquid to be purified.

Further, "particulate impurities" also include colloidized impurities having metal atoms. The metal atoms are not particularly limited, but in a case where the content of at least one metal atom selected from the group consisting of Na, K, Ca, Fe, Cu, Mg, Mn, Li, Al, Cr, Ni, Zn, and Pb (preferably Fe, Cr, Ni, and Pb) is particularly low (for example, in a case where the content of each of the metal atoms in the liquid to be purified is 1,000 mass ppt or less), impurities having the metal atoms are likely to be colloidized. The colloidized impurities are unlikely to be removed with the metal ion adsorption member. Therefore, the colloidized impurities are effectively removed by using a filter having a particle removal diameter of 20 nm or less (for example, a microfiltration film having a pore diameter of 20 nm or less).

The particulate impurities are particles having a size that enables removal with a filter having a particle removal diameter of 20 nm or less and specifically having a diameter of 20 nm or greater. In the present specification, particulate impurities may also be referred to as "coarse particles".

Further, the particle removal diameter of the filter is preferably in a range of 1 to 15 nm and more preferably in a range of 1 to 12 nm. Finer particulate impurities can be removed in a case where the particle removal diameter thereof is 15 nm or less, and the filtration efficiency of the liquid to be purified is improved in a case where the particle removal diameter thereof is 1 nm or greater.

Here, the particle removal diameter denotes the minimum size of a particle that can be removed by a filter. For example, in a case were the particle removal diameter of the filter is 20 nm, particles having a diameter of 20 nm or greater can be removed.

Examples of the material of the filter include 6-nylon, 6,6-nylon, polyethylene, polypropylene, polystyrene, and a fluororesin.

The filtration member may further include a filter having a particle removal diameter of 50 nm or greater (for example, a microfiltration film for removing fine particles having a pore diameter of 50 nm or greater). In a case where fine particles are present in the liquid to be purified in addition to colloidized impurities, in particular, colloidized impurities

having metal atoms such as iron and aluminum, the filtering efficiency of a filter having a particle removal diameter of 20 nm or less (for example, a microfiltration film having a pore diameter of 20 nm or less) is improved and the performance of removing coarse particles is further improved, by carrying out the filtration of the liquid to be purified using a filter having a particle removal diameter of 50 nm or greater (for example, a microfiltration film for removing fine particles, having a pore diameter of 50 nm or greater) before performing filtration using a filter having a particle removal diameter of 20 nm or less (for example, a microfiltration film having a pore diameter of 20 nm or less).

The liquid to be purified obtained by performing each of the treatments can be used in the preparation of the treatment liquid according to the embodiment of the present invention or can be used as the treatment liquid according to the embodiment of the present invention as it is.

In addition, as an example of the above-described purifying step, the case where the respective treatments are all performed has been described, but the present invention is limited thereto, and the respective treatments may be performed singly or in combination of a plurality of the treatments. In addition, the respective treatments may be performed once or a plurality of times.

As a method of setting the content of the organic substance, the metal component, and water having a boiling point of 300°C or higher contained in the treatment liquid to be in a desired range, a method of accommodating the raw material of the organic solvent constituting the treatment liquid or the treatment liquid in a container with less elution of impurities is exemplified in addition to the purifying step. Other examples of the method include a method of carrying out lining of a fluorine-based resin for an inner wall of a "pipe" to prevent elution of metal fractions from the pipe or the like during the production of the treatment liquid.

[Container (accommodation container)]

Unless the corrosion property causes a problem, any container can be used to be filled with the treatment liquid according to the embodiment of the present invention for storage and transportation.

It is preferable to use a container for semiconductors which has a high internal cleanliness and is unlikely to cause elution of impurities.

Specific examples of usable containers include "CLEAN Bottle" series (manufactured by AICELLO CORPORATION) and "Pure Bottle" (manufactured by KODAMA PLASTICS Co., Ltd.), but examples are not limited thereto. It is preferable that the inner wall of the container (the liquid contact portion in contact with the solution in the container) is formed of a nonmetallic material.

As the nonmetallic material, at least one selected from the group consisting of a polyethylene resin, a polypropylene resin, a polyethylene-polypropylene resin, polytetrafluoroethylene (PTFE), a polytetrafluoroethylene-perfluoroalkyl vinyl ether copolymer (PFA), a polytetrafluoroethylene-hexafluoropropylene copolymer resin (FEP), a polytetrafluoroethylene-ethylene copolymer resin (ETFE), a chlorotrifluoroethylene-ethylene copolymer resin (ECTFE), a vinylidene fluoride resin (PVDF), a chlorotrifluoroethylene copolymer resin (PCTFE), and a vinyl fluoride resin (PVF) is more preferable.

Among these, particularly in a case where a container having an inner wall formed of a fluorine-based resin is used, occurrence of failure of elution of ethylene or propylene oligomers can be suppressed, as compared with a case of using a container having an inner wall formed of a polyethylene resin, a polypropylene resin, or a polyethylene-polypropylene resin.

Specific examples of such a container having an inner wall formed of a fluorine-based resin include a FluoroPurePFA composite drum (manufactured by Entegris Inc). In addition, the containers described on page 4 of JP1991-502677A (JP-H03-502677A), page 3 of WO2004/016526A, pages 9 and 16 of the WO99/46309A, and the like can also be used.

Further, it is preferable that a nonmetallic material is used for the inner wall from the viewpoint that the elution of organic components in the nonmetallic material into the treatment liquid is suppressed.

Further, as the inner wall of the container, a quartz or metal material (more preferably, an electropolished metal material, that is, a metal material after completion of electropolishing) is also preferably used in addition to the above-described nonmetallic material.

It is preferable that the metal material (particularly, a metal material used for producing an electropolished metal material) contains greater than 25% by mass of chromium with respect to the mass of the metal material, and examples thereof include stainless steel.

The content of chromium in the metal material is more preferably 30% by mass or greater with respect to the total mass of the metal material. Further, the upper limit thereof is not particularly limited, but is preferably 90% by mass or less in general.

The stainless steel is not particularly limited, and known stainless steel can be used as the stainless steel.

Particularly, an alloy containing 8% by mass or greater of nickel is preferable, and austenite-based stainless steel containing 8% by mass or greater of nickel is more preferable. Examples of the austenite-based stainless steel

include Steel Use Stainless (SUS) 304 (Ni content: 8% by mass, Cr content: 18% by mass), SUS304L (Ni content: 9% by mass, Cr content: 18% by mass), SUS316 (Ni content: 10% by mass, Cr content: 16% by mass), and SUS316L (Ni content: 12% by mass, Cr content: 16% by mass).

As the method of electropolishing the metal material, known methods can be used without particular limitation. For example, the methods described in paragraphs <0011> to <0014> in JP2015-227501A, paragraphs <0036> to <0042> in JP2008-264929A, and the like can be used.

In a case where the metal material is electropolished, it is presumed that the content of chromium in a passivation layer on a surface is greater than the content of chromium in a primary phase. Therefore, it is presumed that since the metal component is unlikely to flow out into the treatment liquid from the inner wall coated with the electropolished metal material, a solution with a reduced amount of the metal component (metal impurities) can be obtained.

It is preferable that the metal material have undergone buffing. The buffing method is not particularly limited, and a known method can be used. The size of abrasive grains used for finishing the buffing is not particularly limited, but is preferably # 400 or less from the viewpoint of easily reducing surface unevenness of the metal material.

Further, it is preferable that the buffing is performed before the electropolishing.

Furthermore, one of the multistage buffing carried out by changing the size of abrasive grains, acid pickling, magnetorheological finishing, and the like or a combination of two or more treatments selected from the above may be performed on the metal material.

In the present invention, the container, and the treatment liquid accommodated in the container may be referred to as a solution container in some cases.

The inside of these containers is preferably washed before the containers are filled with the treatment liquid. In a case where the liquid used for washing is the treatment liquid according to the embodiment of the present invention or the organic solvent contained in the treatment liquid according to the embodiment of the present invention, the effects of the present invention can be remarkably obtained. The treatment liquid according to the embodiment of the present invention may be bottled in a container such as a gallon bottle and a quart bottle after the production, transported, and stored. The gallon bottle may be formed of a glass material or other materials.

In order to prevent a change in the components of the treatment liquid during the storage, the inside of the container may be substituted with inert gas (nitrogen, argon, or the like) with a purity of 99.99995% by volume or greater. Particularly, a gas with a low moisture content is preferable. In addition, during the transportation or storage, the temperature may be controlled to room temperature or to be in a range of -20°C to 20°C to prevent deterioration.

[Clean room]

It is preferable that handling including production of the treatment liquid according to the embodiment of the present invention, opening and/or washing of an accommodation container, filling of the container with the treatment liquid, and the like, treatment analysis, and measurement are all performed in a clean room. It is preferable that the clean room satisfies 14644-1 clean room standards. The clean room satisfies preferably any of International Organization for Standardization (ISO) class 1, ISO class 2, ISO class 3, and ISO class 4, more preferably ISO class 1 or ISO class 2, and still more preferably ISO class 1. The handling including production of the treatment liquid, opening and/or washing of an accommodation container, filling of the container with the treatment liquid, and the like, treatment analysis, and measurement in the examples below are all performed in a clean room of the class 2.

[Electricity removing step]

In the preparation and purification of the treatment liquid according to the embodiment of the present invention or the organic solvent contained in the treatment liquid, an electricity removing step may be further provided. The electricity removing step is a step of reducing the charged potential of a purified product or the like by removing electricity of at least one selected from the group consisting of a raw material, a reactant, and a purified product (hereinafter, referred to as "purified product or the like").

The electricity removing method is not particularly limited, and a known electricity removing method can be used. Examples of the electricity removing method include a method of bringing the purified liquid or the like into contact with a conductive material.

The contact time for which the purified liquid or the like is brought into contact with a conductive material is preferably in a range of 0.001 to 60 seconds, more preferably in a range of 0.001 to 1 second, and still more preferably in a range 0.01 to 0.1 seconds. Examples of the conductive material include stainless steel, gold, platinum, diamond, and glassy carbon.

Examples of the method of bringing the purified liquid or the like into contact with a conductive material include a method in which a grounded mesh consisting of a conductive material is disposed inside a pipe line and the purified liquid or the like is allowed to pass therethrough.

The electricity removing step may be performed at any time from the supply of the raw material to the filling of the purified product, and it is preferable that the electricity removing step is performed before at least one step selected from the group consisting of, for example, a raw material supply step, a reaction step, a liquid preparing step, a purifying step, a filtering step, and a filling step. In particular, it is preferable that the electricity removing step is performed before a purified product or the like is injected into the container used in each of the above-described steps. In this manner, it is possible to suppress impurities derived from the container or the like from being mixed into the purified product or the like.

Examples

Hereinafter, the present invention will be described in detail with reference to examples, but the present invention is not limited thereto.

[Actinic ray-sensitive or radiation-sensitive composition (resist composition)]

A actinic ray-sensitive or radiation-sensitive composition (resist composition) was prepared using the materials described below.

<Resin (A)>

(Synthesis Example 1): synthesis of resin (A-1)

Cyclohexanone (600 g) was added to a 2 L flask, and the cyclohexanone was substituted with nitrogen at a flow rate of 100 mL/min for 1 hour. Thereafter, a polymerization initiator V-601 (manufactured by FUJIFILM Wako Pure Chemical Corporation) (4.60 g (0.02 mol)) was added to the flask and heated until the internal temperature of the contents in the flask reached 80°C.

Next, 4-acetoxystyrene (48.66 g (0.3 mol)), 1-ethylcyclopentyl methacrylate (109.4 g (0.6 mol)), a monomer 1 (22.2 g (0.1 mol)), and the polymerization initiator V-601 (manufactured by FUJIFILM Wako Pure Chemical Corporation) (4.60 g (0.02 mol)) were dissolved in cyclohexanone (200 g), thereby preparing a monomer solution. The monomer solution was added dropwise over 6 hours to the flask heated to an internal temperature of 80°C as described above. After completion of the dropwise addition, the mixture was allowed to further react at an internal temperature of 80°C for 2 hours.

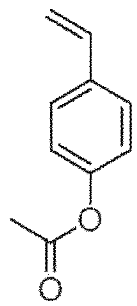

4-Acetoxystyrene

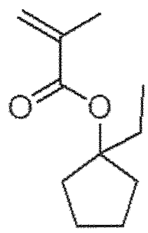

1-Ethylcyclopentyl methacrylate

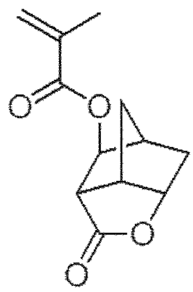

Monomer 1

The reaction solution (contents in the flask) was cooled to room temperature and added dropwise to hexane (3 L), thereby obtaining a mixed solution in which the polymer was precipitated. The mixed solution was filtered to obtain a solid (filtered material). The obtained solid (filtered material) was dissolved in acetone (500 ml) and added dropwise to hexane (3 L) again to obtain a solid (filtered material) again in the same manner as described above. The obtained solid was dried under reduced pressure, thereby obtaining a copolymer (A-la) (160 g) of 4-acetoxystyrene/1-ethylcyclopentyl methacrylate/monomer 1.

The copolymer (A-1a) (10 g), methanol (40 ml), 1-methoxy-2-propanol (200 ml), and concentrated hydrochloric acid (1.5 ml) obtained in the above-described manner were added to an empty flask, and the reaction solution (contents in the flask) was heated to 80°C and stirred for 5 hours. The reaction solution was allowed to be naturally cooled to room temperature and added dropwise to distilled water (3 L), thereby obtaining a mixed solution. The mixed solution was filtered to obtain a solid (filtered material). The obtained solid (filtered material) was dissolved in acetone (200 ml) and

added dropwise again in distilled water (3 L), thereby obtaining a solid (filtered material) again in the same manner as described above. The obtained solid was dried under reduced pressure to obtain the resin (A-1) (8.5 g). The weight-average molecular weight of the resin (A-1) was 10800 and the molecular weight dispersion (Mw/Mn) thereof was 1.55.

(Synthesis Examples 2 to 5): synthesis of resins (A-2) to (A-5)

Resins (A-2) to (A-5) were further synthesized by the same method as in Synthesis Example 1 except that the monomer used was changed. In addition, the compositional ratio (molar ratio) of each repeating unit in the resins was calculated by measuring the nuclear magnetic resonance (1H-NMR).

The resins used in the resist composition are listed in the following table.

In the table, the columns of "compositional ratio (molar ratio)" denotes the content (compositional ratio (molar ratio)) of each repeating unit constituting each resin. The content of each repeating unit shown in the columns of "structure" corresponds to the values shown in the columns of "compositional ratio (molar ratio)" in order from the left side.

[Table 1]

| | Structure | Compositional ratio (molar ratio) | Mw | Mw/Mn |
|---|---|---|---|---|
| A-1 | 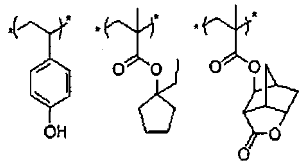 | 30/60/10 | 10,800 | 1.55 |
| A-2 | 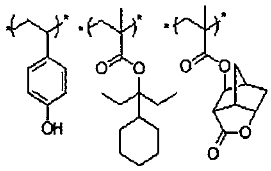 | 30/55/15 | 9,500 | 1.56 |
| A-3 | 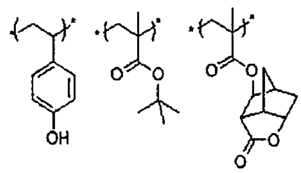 | 30/60/20 | 10,100 | 1.55 |
| A-4 | 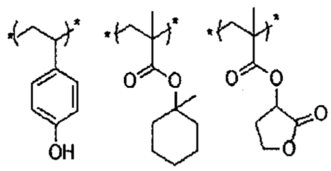 | 30/50/20 | 9,800 | 1.58 |
| A-5 | 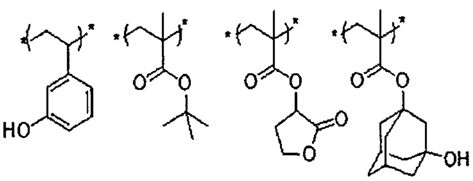 | 20/50/20/10 | 8,500 | 1.65 |

<Photoacid generator>

The following components were used as the photoacid generator.

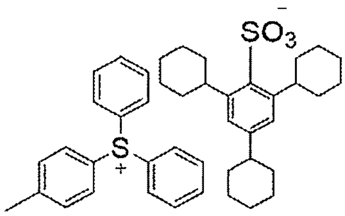
(B-1)

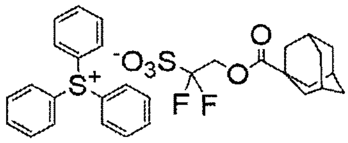
(B-2)

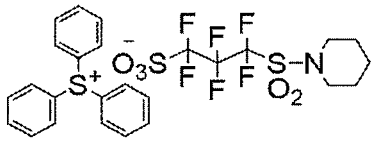
(B-3)

<Basic compound (acid diffusion control agent)>

The following components were used as the basic compound.

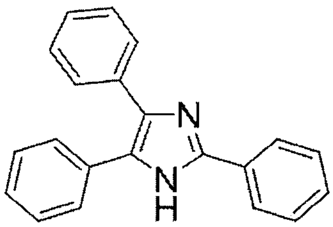
(E-1)

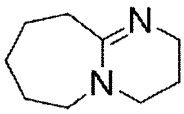
(E-2)

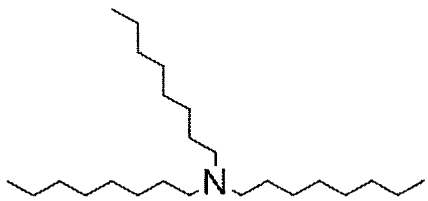
(E-3)

<Solvent>

The following components were used as the solvent.

C-1: propylene glycol monomethyl ether acetate
C-2: propylene glycol
C-3: ethyl lactate
C-4: cyclohexanone

<Other additives>

The following components were used as other additives.

Additive 1: 2-hydroxy-3-naphthoic acid
Additive 2: Surfactant PF6320 (manufactured by OMNOVA Solutions Inc.)

<Preparation of resist composition>

Each component listed in Table 2 below was dissolved in the solvent listed in the same table with the formulation listed in the same table. The obtained mixed solution was filtered using a polyethylene filter having a pore diameter of 0.03 μm to obtain resist compositions 1 to 7.

[Table 2]

| | Resin (A) | Photoacid generator | Basic compound | Solvent (C) | | Other additives |
|---|---|---|---|---|---|---|
| Resist composition 1 | A-1 | B-3 | E-3 | C-1 | C-3 | |
| | 0.78 g | 0.19 g | 0.02 g | 40 g | 10g | |
| Resist composition 2 | A-2 | B-1 | E-1 | C-1 | C-4 | |
| | 0.77 g | 0.20 g | 0.03 | 30 g | 20 g | |

(continued)

| | Resin (A) | Photoacid generator | Basic compound | Solvent (C) | | Other additives |
|---|---|---|---|---|---|---|
| Resist composition 3 | A-3 | B-2 | E-1 | C-1 | C-3 | |
| | 0.79 g | 0.18 g | 0.03 g | 40 g | 10g | |
| Resist composition 4 | A-4 | B-2 | E-2 | C-1 | C-2 | |
| | 0.81 g | 0.18 g | 0.008 g | 40 g | 10 g | |
| Resist composition 5 | A-5 | B-3 | E-1 | C-1 | C-4 | Additive 2 |
| | 0.78 g | 0.19 g | 0.02 g | 20 g | 30 g | 0.01g |
| Resist composition 6 | A-1 | B-1 | E-1 | C-1 | C-4 | Additive 1 |
| | 0.77 g | 0.20 g | 0.02 g | 30 g | 20 g | 0.03g |
| Resist composition 7 | A-1 | B-2 | E-1 | C-1 | C-3 | |
| | 0.77 g | 0.20 g | 0.03 g | 67.5 g | 7.5 g | |

[Tests]

[Simple resolution performance evaluation: EB exposure evaluation: Examples 1 to 10 and Comparative Examples 1 to 3]

Each resist pattern was formed by performing the following operations using the resist compositions 1 to 6 listed in Table 2. The details of the conditions for forming a resist pattern are listed in Table 3.

In both EB exposure and EUV exposure, the resist film is ionized by exposure to generate secondary electrons, and the generated secondary electrons decompose the photoacid generator to generate an acid. Therefore, even in a case where the EB exposure is used for evaluation as the evaluation of simple exposure instead of the EUV exposure, the same results as those of the EUV exposure can be reproduced.

<Preparation of pattern>

(Application of resist composition and bake after application)

A 6-inch silicon wafer was coated with a composition for forming an organic film (product name: AL412, manufactured by Brewer Science, inc.) and baked at 205°C for 60 seconds to form an organic film having a film thickness of 20 nm. The film was coated with the resist composition listed in Table 2 and baked (bake after application) under the conditions listed in Table 4 to form a resist film having a film thickness of 60 nm.

(Exposure)

In the resist film in the wafer (wafer with a resist film) forming the resist film described above, a line-and-space pattern (0.2 mm in the length direction, 45 drawn lines) with a half pitch of 22nm was exposed at each exposure amount listed in Table 3 using an electron beam irradiation device (G100, manufactured by Elionix Inc.; acceleration voltage of 100 keV, beam current of 100 pA). Specifically, the exposure was performed with the exposure amount corresponding to each shot number in Table 3 shown below.

The resist film was exposed (shot) at each exposure amount, and the resist film exposed at each exposure amount was subjected to the subsequent steps.

Further, the exposure amounts listed in Table 3 were set to be logarithmically evenly spaced in order of shot numbers.

Even in a case where the sensitivity of the resist film used for evaluation varies, the resolution performance can be compared by comparing the number of shots that finally enabled resolution without problems (the number of exposure amounts that enabled resolutions without problems).

[Table 3]

| Shot No. | Exposure amount ($\mu C/m^2$) |
|---|---|
| 1 | 250 |

(continued)

| Shot No. | Exposure amount ($\mu C/m^2$) |
|---|---|
| 2 | 222 |
| 3 | 198 |
| 4 | 177 |
| 5 | 157 |
| 6 | 140 |
| 7 | 125 |
| 8 | 112 |
| 9 | 99 |
| 10 | 89 |
| 11 | 79 |
| 12 | 70 |
| 13 | 63 |
| 14 | 56 |
| 15 | 50 |

(Bake after exposure)

After the exposure, the wafer was taken out from the electron beam irradiation device and immediately heated (bake after exposure) on a hot plate under the conditions listed in Table 4.

(Developing step)

Development was performed by jetting the developer (23°C) listed in Table 4 onto the wafer at a flow rate of 200 mL/min for 10 seconds while the wafer was allowed to rotate at 50 rpm using a shower-type developing device (ADE3000S, manufactured by ACTES Co., Ltd.).

(Rinsing step)

Thereafter, the rinsing treatment was performed by jetting the rinsing liquid (23°C) listed in Table 4 onto the wafer at a flow rate of 200 mL/min for 5 seconds while the wafer was allowed to rotate at 50 rpm. However, the rinsing treatment was not performed in Comparative Example 1.

Finally, the wafer was dried by rotating at a high speed of 2000 rpm for 60 seconds.

Hereinafter, the conditions for pattern formation in each example and each comparative example are listed in Table 4.

In Table 4, the columns of "resist composition" denote the numbers of the resist compositions used for forming the resist films.

Further, the formulations of the developer and the rinsing liquid listed in Table 4 are listed in Table 5.

[Table 4]

| | Resist composition | Bake after application | Bake after exposure | Developer | Rinsing liquid |
|---|---|---|---|---|---|
| Example 1 | 1 | 120°C × 60 sec | 110°C × 60 sec | S-18 | S-1 |
| Example 2 | 2 | 120°C × 60 sec | 110°C × 60 sec | S-18 | S-2 |
| Example 3 | 3 | 120°C × 60 sec | 110°C × 60 sec | S-18 | S-3 |
| Example 4 | 4 | 120°C × 60 sec | 110°C × 60 sec | S-18 | S-4 |

(continued)

| | Resist composition | Bake after application | Bake after exposure | Developer | Rinsing liquid |
|---|---|---|---|---|---|
| Example 5 | 5 | 120°C × 60 sec | 110°C × 60 sec | S-18 | S-5 |
| Example 6 | 6 | 120°C × 60 sec | 110°C × 60 sec | S-18 | S-6 |
| Example 7 | 1 | 120°C × 60 sec | 110°C × 60 sec | S-18 | S-7 |
| Example 8 | 1 | 120°C × 60 sec | 110°C × 60 sec | S-18 | S-8 |
| Example 9 | 1 | 120°C × 60 sec | 110°C × 60 sec | S-18 | S-9 |
| Example 10 | 3 | 120°C × 60 sec | 110°C × 60 sec | S-18 | S-10 |
| Example 11 | 4 | 120°C × 60 sec | 110°C × 60 sec | S-18 | S-11 |
| Example 12 | 3 | 120°C × 60 sec | 110°C × 60 sec | S-18 | S-12 |
| Example 13 | 3 | 120°C × 60 sec | 110°C × 60 sec | S-18 | S-13 |
| Example 14 | 3 | 120°C × 60 sec | 110°C × 60 sec | S-18 | S-14 |
| Example 15 | 1 | 120°C × 60 sec | 110°C × 60 sec | S-18 | S-15 |
| Example 16 | 1 | 120°C × 60 sec | 110°C × 60 sec | S-18 | S-16 |
| Comparative Example 1 | 1 | 120°C × 60 sec | 110°C × 60 sec | S-18 | - |
| Comparative Example 2 | 3 | 120°C × 60 sec | 110°C × 60 sec | S-18 | S-18 |
| Comparative Example 3 | 1 | 120°C × 60 sec | 110°C × 60 sec | S-18 | S-19 |
| Comparative Example 4 | 1 | 120°C × 60 sec | 110°C × 60 sec | S-18 | S-20 |
| Comparative Example 5 | 1 | 120°C × 60 sec | 110°C × 60 sec | S-18 | S-17 |

The formulation of the treatment liquid (the developer or rinsing liquid) listed in Table 4 is listed in Table 5.

In the table, the columns of "bp1 - bp2" denote the value (°C) obtained by subtracting the boiling point of the first organic solvent from the boiling point of the first organic solvent.

[Table 5]

| | Formulation of treatment liquid | | | bp1 - bp2 |
|---|---|---|---|---|
| | First organic solvent (% by mass) | Second organic solvent (% by mass) | Other organic solvent (% by mass) (% by mass) | (°C) |
| S-1 | Diisoamyl ether (10% by mass) | Isoamyl formate (90% by mass) | - | 49.5 |
| S-2 | Diamyl ether (10% by mass) | Isoamyl formate (90% by mass) | - | 62.5 |
| S-3 | Diisoamyl ether (50% by mass) | Diether carbonate (50% by mass) | - | 47.0 |
| S-4 | Diisoamyl ether (30% by mass) | Isopropyl propionate (70% by mass) | - | 65.0 |

(continued)

| | Formulation of treatment liquid | | | bp1 - bp2 |
|---|---|---|---|---|
| | First organic solvent (% by mass) | Second organic solvent (% by mass) | Other organic solvent (% by mass) (% by mass) | (°C) |
| S-5 | Diamyl ether (10% by mass) | 3-Methylbutyl propionate (90% by mass) | - | 25.0 |
| S-6 | Diisoamyl ether (30% by mass) | Ethyl isobutanoate (70% by mass) | - | 63.0 |
| S-7 | Dibutyl ether (50% by mass) | t-Butyl formate (50% by mass) | - | 58.5 |
| S-8 | Dibutyl ether (50% by mass) | Diethyl carbonate (50% by mass) | - | 15.0 |
| S-9 | Dibutyl ether (50% by mass) | Dipropyl carbonate (50% by mass) | - | -26.0 |
| S-10 | Dibutyl ether (50% by mass) | Diisopropyl carbonate (50% by mass) | - | -6.0 |
| S-11 | Diisobutyl ether (30% by mass) | Isoamyl formate (70% by mass) | - | -1.5 |
| S-12 | Diisobutyl ether (50% by mass) | Diethyl carbonate (50% by mass) | - | -4.0 |
| S-13 | Diisobutyl ether (50% by mass) | 3-Methylbutyl propionate (50% by mass) | - | -39.0 |
| S-14 | Diisobutyl ether (30% by mass) | Ethyl isobutanoate (70% by mass) | - | 12.0 |
| S-15 | Isobutyl isobutanoate (20% by mass) | Isoamyl formate (80% by mass) | - | 23.5 |
| S-16 | Decane (20% by mass) | Propyl propionate (80% by mass) | - | 19.0 |
| S-17 | - | Isoamyl formate (100% by mass) | - | - |
| S-18 | - | - | Butyl acetate (100% by mass) | - |
| S-19 | - | - | 2-Heptanone (100% by mass) | - |
| S-20 | Decane (100% by mass) | - | - | - |

The characteristics of the organic solvents used in the treatment liquid (the developer or the rinsing liquid) listed in Table 5 are listed in Tables 6 to 8. Table 6 shows the characteristics of the first organic solvent, Table 7 shows the characteristics of the second organic solvent, and Table 8 shows the characteristics of other organic solvents.

In Tables 6 to 8, the columns of "structure" denote whether the organic solvent contains a branched chain alkyl

group. The description of "branched" denotes that the organic solvent contains a branched chain alkyl group. The description of "linear" denotes that the organic solvent does not contain a branched chain alkyl group but contains a linear alkyl group.

The columns of "SP value" denote the Hansen solubility parameter ($MPa^{1/2}$) of the organic solvent.

The columns of "δd" denote the dispersion element ($MPa^{1/2}$) of the organic solvent.

The columns of "δp" denote the polarity element ($MPa^{1/2}$) of the organic solvent.

The columns of "δh" denote the hydrogen bond element ($MPa^{1/2}$) of the organic solvent.

The columns of "X" denote a value calculated by Equation (2).

$$\text{Equation (2): } X = (\delta p)^2/((\delta d)^2 + (\delta p)^2 + (\delta h)^2) \times 100.$$

[Table 6]

| | Structure | δd | δp | δh | SP value | X | Boiling point (°C) |
|---|---|---|---|---|---|---|---|
| Dibutyl ether | Linear | 15.2 | 3.4 | 3.2 | 15.9 | 4.6 | 141.0 |
| Diisobutyl ether | Branched | 15.0 | 2.7 | 2.5 | 15.4 | 3.1 | 122.0 |
| Diamyl ether | Linear | 15.6 | 3.1 | 3.0 | 16.2 | 3.7 | 186.0 |
| Diisoamyl ether | Branched | 15.2 | 2.5 | 2.5 | 15.6 | 2.6 | 173.0 |
| Isobutyl isobutanoate | Branched | 15.1 | 2.8 | 5.8 | 16.4 | 2.9 | 147.0 |
| Decane | Linear | 15.7 | 0.0 | 0.0 | 15.7 | 0.0 | 141.0 |

[Table 7]

| | Structure | δd | δp | δh | SP value | X | Boiling point (°C) |
|---|---|---|---|---|---|---|---|
| t-Butyl formate | Branched | 14.9 | 5.4 | 5.8 | 16.9 | 10.2 | 82.5 |
| Isoamyl formate | Branched | 15.6 | 5.4 | 5.9 | 17.5 | 9.5 | 123.5 |
| Propyl propionate | Linear | 15.5 | 5.6 | 5.7 | 17.4 | 10.3 | 122.0 |
| Isopropyl propionate | Branched | 15.5 | 4.6 | 5.3 | 17.0 | 7.3 | 108.0 |
| 3-Methylbutyl propionate | Branched | 15.7 | 5.2 | 5.6 | 17.5 | 8.9 | 161.0 |
| Ethyl isobutanoate | Branched | 15.5 | 4.6 | 5.3 | 17.0 | 7.3 | 110.0 |
| Diethyl carbonate | Linear | 15.1 | 6.3 | 3.5 | 16.7 | 14.2 | 126.0 |
| Dipropyl carbonate | Linear | 15.6 | 6.0 | 4.8 | 17.4 | 11.9 | 167.0 |
| Diisopropyl carbonate | Branched | 15.2 | 5.8 | 4.1 | 16.8 | 12.0 | 147.0 |

[Table 8]

| | Structure | δd | δp | δh | SP value | X | Boiling point (°C) |
|---|---|---|---|---|---|---|---|
| 2-Heptanone | Linear | 16.2 | 5.7 | 4.1 | 17.7 | 10.4 | 151.0 |
| Butyl acetate | Linear | 15.8 | 3.7 | 6.3 | 17.4 | 4.5 | 126.0 |

<Evaluation>

The obtained patterns were evaluated based on the following items. The details of the results are listed in Table 9.

(Sensitivity)

The obtained pattern was observed with a scanning electron microscope (S-9260, manufactured by Hitachi, Ltd.). The irradiation energy for separation resolution with a line to space ratio of 1:1 in a line width of 22 nm is defined as the sensitivity of the resist film ($\mu C/cm^2$).

(Number of resolution frames (resolution))

The state of resolution of the 22 nm line-and-space pattern at each exposure amount was observed using a scanning electron microscope (S-9260, manufactured by Hitachi, Ltd.). The resolution was evaluated by counting the number of shots that were resolved without any problem at each exposure amount.

Fig. 1 shows micrographs of patterns formed by exposure at exposure amounts of the shot numbers 3 to 10 in Example 1 and Comparative Example 1.

In Comparative Example 1, it was determined that the resolution was carried out without any problem only in a case where the exposure was performed at the exposure amount of the shot number 4. That is, in Comparative Example 1, the number of shots (number of resolution frames) that enabled resolution without any problem was 1.

On the contrary, in Example 1, it was determined that the resolution was carried out without any problem in a case where the exposure was performed at the exposure amounts of the shot numbers of 4 to 8. That is, in Comparative Example 1, the number of shots (number of resolution frames) that enabled resolution without any problem was 5.

Based on the same determination standard as described above, the number of resolution frames was acquired for other examples and comparative examples.

(Residues (property of suppressing residues))

The unexposed portion of the wafer was observed using a scanning electron microscope (S-9260, manufactured by Hitachi, Ltd.), and the presence or absence of residues was confirmed.

(Shape (property of suppressing reduction in film thickness))

The shape of the pattern with a line width of 22 nm at the irradiation dose showing the above-described sensitivity was observed using a scanning electron microscope (S-4800, manufactured by Hitachi, Ltd.), and the results obtained by evaluating the shape of the obtained pattern according to the following indices are listed in Table 10.

It can be determined that the reduction in film thickness is suppressed as the shape of the pattern is closer to a rectangle and that the reduction in film thickness is significant as deterioration of the shape of the pattern is more significant.

A: The shape was rectangular.
B: The shape was slightly deteriorated.
C: The shape was significantly deteriorated or unresolved.

[Table 9]

| | Resist composition | Characteristics of rinsing liquid | | | | | | Results | | | |
|---|---|---|---|---|---|---|---|---|---|---|---|
| | | Type | First organic solvent | | Second organic solvent | | bp1 - bp2 | Sensitivity | Number of resolution frames | Residues | Shape |
| | | | Type | Structure | Type | Structure | | | | | |
| Example 1 | 1 | S-1 | Diisoamyl ether | Branched | Isoamyl formate | Branched | 49.5 | 157 | 5 | Not found | A |
| Example 2 | 2 | S-2 | Diamyl ether | Linear | Isoamyl formate | Branched | 62.5 | 177 | 4 | Not found | A |
| Example 3 | 3 | S-3 | Diisoamyl ether | Branched | Diethyl carbonate | Linear | 47.0 | 177 | 5 | Not found | A |
| Example 4 | 4 | S-4 | Diisoamyl ether | Branched | Isopropyl propionate | Branched | 65.0 | 157 | 5 | Not found | A |
| Example 5 | 5 | S-5 | Diamyl ether | Linear | 3-Methylbutyl propionate | Branched | 25.0 | 177 | 5 | Not found | A |
| Example 6 | 6 | S-6 | Diisoamyl ether | Branched | Ethyl isobutanoate | Branched | 63.0 | 157 | 5 | Not found | A |
| Example 7 | 1 | S-7 | Dibutyl ether | Linear | t-Butyl formate | Branched | 58.5 | 157 | 4 | Not found | A |
| Example 8 | 1 | S-8 | Dibutyl ether | Linear | Diethyl carbonate | Linear | 15.0 | 157 | 3 | Not found | A |
| Example 9 | 1 | S-9 | Dibutyl ether | Linear | Dipropyl carbonate | Linear | -26.0 | 157 | 3 | Not found | A |
| Example 10 | 3 | S-10 | Dibutyl ether | Linear | Diisopropyl carbonate | Branched | -6.0 | 177 | 4 | Not found | A |
| Example 11 | 4 | S-11 | Diisobutyl ether | Branched | Isoamyl formate | Branched | -1.5 | 157 | 4 | Not found | A |
| Example 12 | 3 | S-12 | Diisobutyl ether | Branched | Diethyl carbonate | Linear | -4.0 | 177 | 4 | Not found | A |
| Example 13 | 3 | S-13 | Diisobutyl ether | Branched | 3-Methylbutyl propionate | Branched | -39.0 | 177 | 4 | Not found | A |
| Example 14 | 3 | S-14 | Diisobutyl ether | Branched | Ethyl isobutanoate | Branched | 12.0 | 177 | 4 | Not found | A |

(continued)

| | Resist composition | Characteristics of rinsing liquid | | | | | | Results | | | |
|---|---|---|---|---|---|---|---|---|---|---|---|
| | | Type | First organic solvent | | Second organic solvent | | bp1 - bp2 | Sensitivity | Number of resolution frames | Residues | Shape |
| | | | Type | Structure | Type | Structure | | | | | |
| Example 1S | 1 | S-15 | Isobutyl isobutanoate | Branched | Isoamyl formate | Branched | 23.5 | 157 | 4 | Not found | A |
| Example 16 | 1 | S-16 | Decane | Linear | Propyl propionate | Linear | 19.0 | 157 | 3 | Not found | B |
| Comparative Example 1 | 1 | - | - | - | - | - | - | 157 | 1 | Not found | B |
| Comparative Example 2 | 3 | S-18 | - | - | - | - | - | 177 | 0 | Not found | C |
| Comparative Example 3 | 1 | S-19 | - | - | - | - | - | 157 | 0 | Not found | C |
| Comparative Example 4 | 1 | S-20 | Decane | Linear | - | - | - | 157 | 3 | Found | A |
| Comparative Example 5 | 1 | S-17 | - | - | Isoamyl formate | Branched | - | 157 | 2 | Not found | B |

As shown in the results listed in the table, it was confirmed that in a case where the treatment liquid of the present invention was used as a rinsing liquid, the resolution, the property of suppressing reduction in film thickness, and the property of suppressing residues were excellent.

In a case where at least one of a requirement that the first organic solvent is an organic solvent containing a branched chain alkyl group (an ether-based solvent having 6 to 12 carbon atoms which contains a branched chain alkyl group or an ester-based solvent having 5 to 8 carbon atoms which contains a branched chain alkyl group) or a requirement that the second organic solvent is an organic solvent containing a branched chain alkyl group (an ester-based solvent having 5 to 8 carbon atoms which contains a branched chain alkyl group or a carbonic acid ester-based solvent having 5 to 9 carbon atoms which contains a branched chain alkyl group) is satisfied, it was confirmed that the resolution was more excellent (see Examples 8, 9, and 16 and other examples and comparative examples).

[EUV exposure evaluation (process window evaluation): Examples 18 and 19 and Comparative Example 6]

A resist pattern was formed by performing the following operations using the composition 7 listed in Table 2. The details of the conditions for forming a resist pattern are listed in Table 10.

<Pattern formation>

(Application of resist composition and bake after application)

A 12-inch silicon wafer was coated with a composition for forming an organic film, AL412 (manufactured by Brewer Science, Inc.) and baked at 205°C for 60 seconds, thereby forming an organic film having a film thickness of 20 nm. The organic film was coated with a resist composition 7 listed in Table 2 and baked (bake after application) under the conditions listed in Table 10, thereby forming a resist film having a film thickness of 40 nm.

(Exposure)

In the wafer on which the resist film was formed as described above (wafer with a resist film), a dot pattern having a half pitch (HP) of 28 nm was exposed using an EUV exposure device by changing the focal point and the exposure amount.

Specifically, the focal point was changed by 0.02 μm for each time in a range of -0.06 to 0.1 μm for exposure. The exposure amount was changed by 1 mJ/cm$^2$ for each time in a range of 41 to 69 mJ/cm$^2$ for exposure.

That is, the exposure was performed at 29 different exposure amounts under one focal point condition. In other words, the exposure was performed at nine different focal points in one setting of the exposure amount.

In total, each exposure was performed under $9 \times 29 = 261$ types of conditions.

(Bake after exposure)

After the exposure, the wafer was taken out from the exposure device and immediately baked (bake after exposure) at 110°C for 60 seconds using a hot plate provided in a developing device (ACT12, manufactured by Tokyo Electron Limited).

(Developing step)

The development was performed by jetting the developer (23°C) listed in Table 10 onto the wafer at a flow rate of 200 mL/min for 10 seconds while the wafer rotated at 50 rpm, using a developing device (ACT12, manufactured by Tokyo Electron Limited).

(Rinsing step)

Thereafter, the rinsing treatment was performed by jetting the rinsing liquid (23°C) listed in Table 10 onto the wafer at a flow rate of 200 mL/min for 5 seconds while the wafer rotated at 50 rpm. Here, in Comparative Example 6, the rinsing treatment was not performed.

Finally, the wafer was dried by rotating at a high speed of 2000 rpm for 60 seconds.

[Table 10]

| | Resist composition | Bake after application | Bake after exposure | Developer | Rinsing liquid |
|---|---|---|---|---|---|
| Example 17 | 7 | 120°C × 60 sec | 110°C × 60 sec | S-18 | S-1 |
| Example 18 | 7 | 120°C × 60 sec | 100°C × 60 sec | S-18 | S-2 |
| Comparative Example 6 | 7 | 120°C × 60 sec | 110°C × 60 sec | S-18 | - |

<Evaluation>

The obtained patterns were evaluated based on the following items. The details of the results are listed in Table 11.

The columns of "sensitivity" in the table show the irradiation energy (exposure amount, unit: $mJ/cm^2$) in a case of resolution of a dot pattern of with a half pitch (HP) of 28 nm.

(Process margin evaluation (resolution and number of resolution frames))

The obtained pattern was observed with a scanning electron microscope (S-9380, manufactured by Hitachi, Ltd.). The number of frames in which the dot pattern was resolved without any problem (the number of resolution frames; the number of exposure amounts and the number of focal depths that enabled resolution without any problem) was counted.

In the exposure, as described above, the exposure was performed at 29 different exposure amounts under one focal point condition. The exposure was performed at each focal point with 29 different exposure amounts, and the number of resolution frames at the focal point where the number of resolution frames was the largest was evaluated as the number of resolution frames in the exposure amount direction.

Further, in the exposure, as described above, it can be said that the exposure was performed at nine different focal points under the condition of one exposure amount. The exposure was performed at nine different focal points with each exposure amount, and the number of resolution frames at the exposure amount where the number of resolution frames was the largest was evaluated as the number of resolution frames in the focal depth direction.

(Residues (property of suppressing residues))

The unexposed portion of the wafer was observed using a scanning electron microscope (S-9260, manufactured by Hitachi, Ltd.), and the presence or absence of residues was confirmed.

[Table 11]

| | Sensitivity | Number of resolution frames | Property of suppressing residues |
|---|---|---|---|
| | $mJ/cm^2$ | Exposure amount direction/focal depth direction | |
| Example 17 | 55 | 6/5 | Residues were not found |
| Example 18 | 55 | 6/5 | Residues were not found |
| Comparative Example 6 | 55 | 1/2 | Residues were not found |

As shown in the above-described evaluation results, it was confirmed that the pattern forming method using the treatment liquid according to the embodiment of the present invention enables formation of an ultrafine size pattern and thus can be suitably used.

## Claims

1. A treatment liquid for patterning a resist film, which is used for performing at least one of development or washing after exposure on a resist film obtained from an actinic ray-sensitive or radiation-sensitive composition, the treatment liquid comprising:

a first organic solvent that satisfies Condition A; and a second organic solvent that satisfies Condition B, Condition A: the solvent has a SP value of 15.0 $MPa^{1/2}$ or greater and less than 16.5 $MPa^{1/2}$ which is acquired by Equation (1) and is a hydrocarbon-based solvent, an ester-based solvent, an ether-based solvent, or a carbonic acid ester-based solvent,

$$\text{Equation (1): SP value} = ((\delta d)^2 + (\delta p)^2 + (\delta h)^2)^{0.5}$$

SP value: Hansen solubility parameter of organic solvent
δd: dispersion element of organic solvent
δp: polarity element of organic solvent
δh: hydrogen bond element of organic solvent

Condition B:
the solvent has a SP value of 16.5 $MPa^{1/2}$ or greater and less than 17.6 $MPa^{1/2}$ which is acquired by Equation (1) and has an X value of 7.0 or greater and less than 20.0 which is acquired by Equation (2), and is a hydrocarbon-based solvent, an ester-based solvent, an ether-based solvent, or a carbonic acid ester-based solvent,

$$\text{Equation (2): } X = (\delta p)^2/((\delta d)^2 + (\delta p)^2 + (\delta h)^2) \times 100.$$

**2.** The treatment liquid according to claim 1,
wherein the first organic solvent is an ether-based solvent having 6 to 12 carbon atoms.

**3.** The treatment liquid according to claim 1 or 2,
wherein the second organic solvent is an ester-based solvent having 5 to 8 carbon atoms or a carbonic acid ester-based solvent having 5 to 9 carbon atoms.

**4.** The treatment liquid according to any one of claims 1 to 3,
wherein the first organic solvent is an ether-based solvent having 6 to 12 carbon atoms, which contains a branched chain alkyl group.

**5.** The treatment liquid according to any one of claims 1 to 4,
wherein the second organic solvent is an ester-based solvent having 5 to 8 carbon atoms, which contains a branched chain alkyl group.

**6.** The treatment liquid according to any one of claims 1 to 5,
wherein the first organic solvent is selected from the group consisting of diisopropyl ether, diisobutyl ether, diisoamyl ether, isopropyl propyl ether, isopropyl n-butyl ether, n-propyl isobutyl ether, isopropyl isobutyl ether, isopropyl isoamyl ether, isobutyl isoamyl ether, n-butyl isoamyl ether, and n-amyl isoamyl ether.

**7.** The treatment liquid according to any one of claims 1 to 6,
wherein the second organic solvent is selected from the group consisting of t-butyl formate, isopentyl formate, 1,1-dimethylpropyl formate, 2,2-dimethylpropyl formate, 2-methylbutyl formate, isopropyl propanoate, isopentyl propanoate, diethyl carbonate, dipropyl carbonate, diisopropyl carbonate, dibutyl carbonate, diisobutyl carbonate, ditert-butyl carbonate, and ethyl isopentyl carbonate.

**8.** The treatment liquid according to any one of claims 1 to 7,
wherein the first organic solvent and the second organic solvent satisfy a relationship of Expression (3),

$$\text{Expression (3): } 5.0°C < bp1 - bp2 < 100.0°C$$

bp1: boiling point of first organic solvent
bp2: boiling point of second organic solvent.

**9.** The treatment liquid according to any one of claims 1 to 8,
wherein the actinic ray-sensitive or radiation-sensitive composition contains a resin having a hydroxystyrene-based

repeating unit.

**10.** A pattern forming method comprising:

a resist film forming step of forming a resist film by using an actinic ray-sensitive or radiation-sensitive composition;
an exposing step of exposing the resist film; and
a treatment step of treating the exposed resist film with the treatment liquid according to any one of claims 1 to 8.

**11.** A pattern forming method comprising:

a resist film forming step of forming a resist film by using an actinic ray-sensitive or radiation-sensitive composition;
an exposing step of exposing the resist film; and
a treatment step of treating the exposed resist film,
wherein the treatment step includes

a developing step of developing the film with a developer, and
a rinsing step of washing the film with a rinsing liquid, and

the rinsing liquid is the treatment liquid according to any one of claims 1 to 8.

# FIG. 1

| Shot NO. | EXPOSURE AMOUNT ($\mu C/m^2$) | COMPARATIVE EXAMPLE 1 | EXAMPLE 1 |
|---|---|---|---|
| | | NUMBER OF RESOLUTION FRAMES | |
| | | 1 | 5 |
| 3 | 198 | 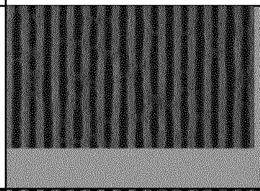 | 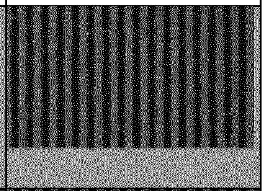 |
| 4 | 177 | 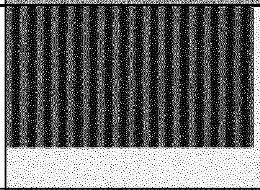 | 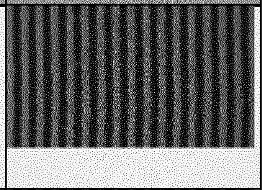 |
| 5 | 157 | 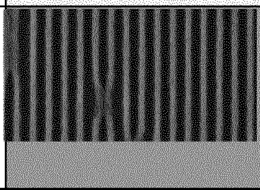 | 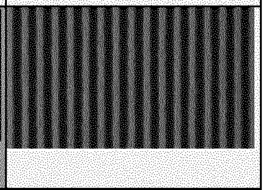 |
| 6 | 140 | 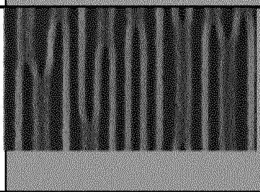 | 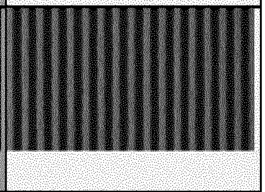 |
| 7 | 125 | 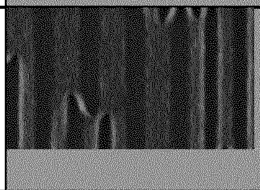 | 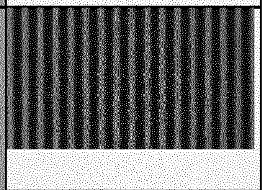 |
| 8 | 112 | 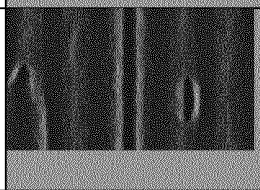 | 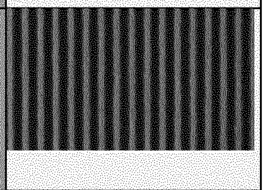 |
| 9 | 99 | 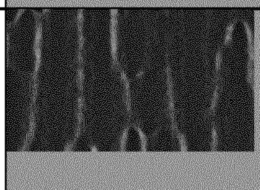 | 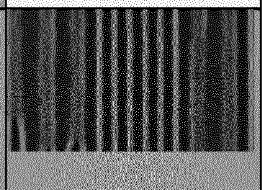 |
| 10 | 89 | 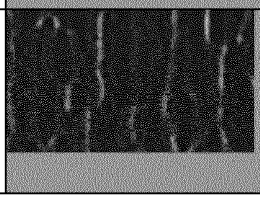 | 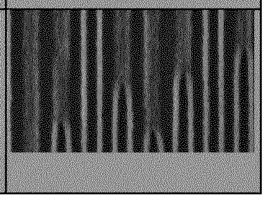 |

## INTERNATIONAL SEARCH REPORT

International application No.
PCT/JP2020/043187

A. CLASSIFICATION OF SUBJECT MATTER
C08F 220/28(2006.01)i; G03F 7/038(2006.01)i; G03F 7/039(2006.01)i; G03F 7/20(2006.01)i; G03F 7/32(2006.01)i; H01L 21/027(2006.01)i
FI: G03F7/32; G03F7/32 501; G03F7/038 601; G03F7/039 601; C08F220/28; H01L21/30 569E; G03F7/20 501; G03F7/20 521
According to International Patent Classification (IPC) or to both national classification and IPC

B. FIELDS SEARCHED
Minimum documentation searched (classification system followed by classification symbols)
C08F220/28; G03F7/038; G03F7/039; G03F7/20; G03F7/32; H01L21/027

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| A | WO 2016/208313 A1 (FUJIFILM CORPORATION) 29 December 2016 (2016-12-29) claims | 1-11 |
| A | JP 2012-32807 A (SHIN-ETSU CHEMICAL CO., LTD.) 16 February 2012 (2012-02-16) claims | 1-11 |
| A | JP 2012-32780 A (SHIN-ETSU CHEMICAL CO., LTD.) 16 February 2012 (2012-02-16) claims | 1-11 |

☐ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 18 January 2021 (18.01.2021) | 26 January 2021 (26.01.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application no.
PCT/JP2020/043187

| Patent Documents referred in the Report | Publication Date | Patent Family | Publication Date |
|---|---|---|---|
| WO 2016/208313 A1 | 29 Dec. 2016 | US 2018/0186907 A1 claims<br>KR 10-2018-0011225 A<br>CN 107735730 A<br>TW 201708980 A | |
| JP 2012-32807 A | 16 Feb. 2012 | US 2012/0009529 A1 claims<br>KR 10-2012-0005387 A<br>TW 201217406 A | |
| JP 2012-32780 A | 16 Feb. 2012 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013045086 A
- US 20070178407 A
- US 20080085466 A
- US 20070275326 A
- US 20160299432 A
- US 20130244438 A
- WO 2016157988 A
- JP 2014059543 A
- JP 2014041327 A
- JP 2014041328 A
- JP 2013228681 A
- US 2015004533 A
- JP 2014219664 A
- JP 2014134686 A
- JP 2013011833 A
- US 20120251948 A1
- JP 2014010245 A
- JP 2011248019 A
- JP 2010175859 A
- JP 2012032544 A
- US 20080248425 A
- JP 2002090991 A
- WO 2012043496 A
- JP 2002273123 A
- JP 2013150979 A
- JP 3502677 A
- JP H03502677 A
- WO 2004016526 A
- WO 9946309 A
- JP 2015227501 A
- JP 2008264929 A


### Non-patent literature cited in the description


- *Materials Letters,* 2008, vol. 62, 3152